# EUROPEAN PATENT APPLICATION

(11) **EP 4 838 268 A1**
(43) Date of publication of application: **11.11.2026**
(21) Application number: 26175295.0
(22) Date of filing: 29.04.2026
(51) Int. Cl.: G02B 1/00, G02B 3/00, G02B 5/18

(54) **OPTICAL ELEMENT, IMAGE SENSOR, AND IMAGE PICKUP APPARATUS**

(30) Priority: 08.05.2025 JP 2025077751
(71) Applicant: Canon Kabushiki Kaisha, Tokyo 146-8501 (JP)
(72) Inventor: ISHIBASHI, Tomohiko, Tokyo (JP)
(74) Representative: WESER & Kollegen Patentanwälte PartmbB

(57) **Abstract**

An optical element (100) includes a plurality of structures each including at least one of a concave element or a convex element (121). A predetermined inequality is satisfied.

## Description

### BACKGROUND

### Field of the Technology

The present disclosure relates to an optical element, an image sensor, and an image pickup apparatus.

### Description of the Related Art

An optical element (metalens) having a light-condensing function or a light-diverging function utilizing a phase change by forming a fine (or minute) concavo-convex structure on a surface of a substrate is known. Japanese Patent Laid-Open No. 2019-184986 discloses an optical element that separates focal positions according to the wavelength of incident light by utilizing the wavelength dispersion of the fine concavo-convex structure.

### SUMMARY

The present disclosure in its first aspect provides an optical element as specified in claims 1 to 11.

The present disclosure in its second aspect provides an image sensor as specified in claim 12.

The present disclosure in its third aspect provide an image pickup apparatus as specified in claim 13.

Features of the present disclosure will become apparent from the following description of embodiments with reference to the attached drawings. The following description of embodiments will be described by way of example.

### BRIEF DESCRIPTION OF THE DRAWINGS

Figs. 1A to 1E are diagrams illustrating the configurations of optical elements according to each example and a comparative example.
Figs. 2A to 2I are diagrams for explaining concavo-convex elements according to each example.
Fig. 3 is a diagram for explaining an annulus according to each example.
Figs. 4A and 4B are diagrams illustrating the configuration of the optical element according to Example 1 and a phase change amount distribution.
Figs. 5A and 5B are diagrams illustrating the configuration and phase change amount distribution of an optical element of comparative example 1.
Figs. 6A and 6B are diagrams illustrating the configuration and phase change amount distribution of an optical element according to Example 2.
Figs. 7A and 7B are diagrams illustrating the configuration and phase change amount distribution of an optical element according to Example 3.
Figs. 8A and 8B are diagrams illustrating the configuration and phase change amount distribution of an optical element according to Example 4.
Figs. 9A and 9B are diagrams illustrating the configuration and phase change amount distribution of an optical element according to Example 5.
Figs. 10A and 10B are diagrams illustrating the configuration and phase change amount distribution of an optical element according to Example 6.
Figs. 11A and 11B are diagrams illustrating the configuration of an optical element according to Example 7.
Figs. 12A and 12B are diagrams illustrating the configuration and phase change amount distribution of the optical element according to Example 7.
Fig. 13 is a diagram illustrating an image pickup apparatus including an image sensor that includes the optical element according to each example.

### DETAILED DESCRIPTION

Referring now to the accompanying drawings, a detailed description will be given of embodiments according to the present disclosure. Corresponding elements in respective figures will be designated by the same reference numerals, and a duplicate description thereof will be omitted. Each of the embodiments of the present invention described below can be implemented solely or as a combination of a plurality of the embodiments or features thereof where necessary or where the combination of elements or features from individual embodiments in a single embodiment is beneficial.

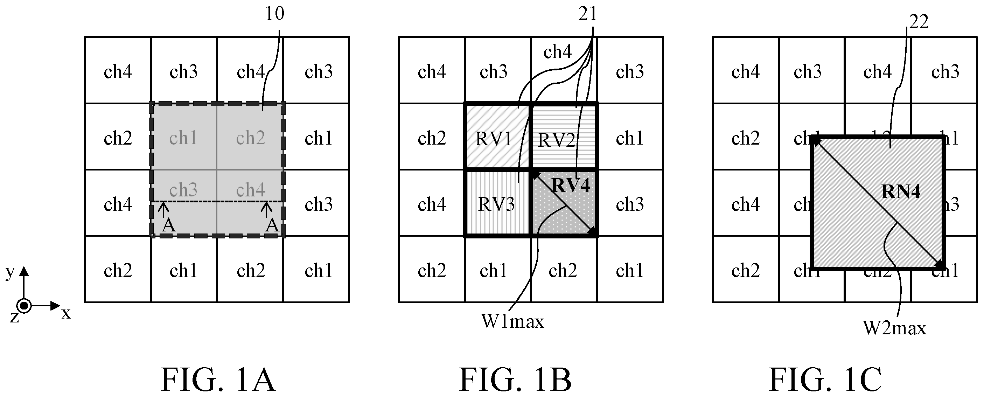

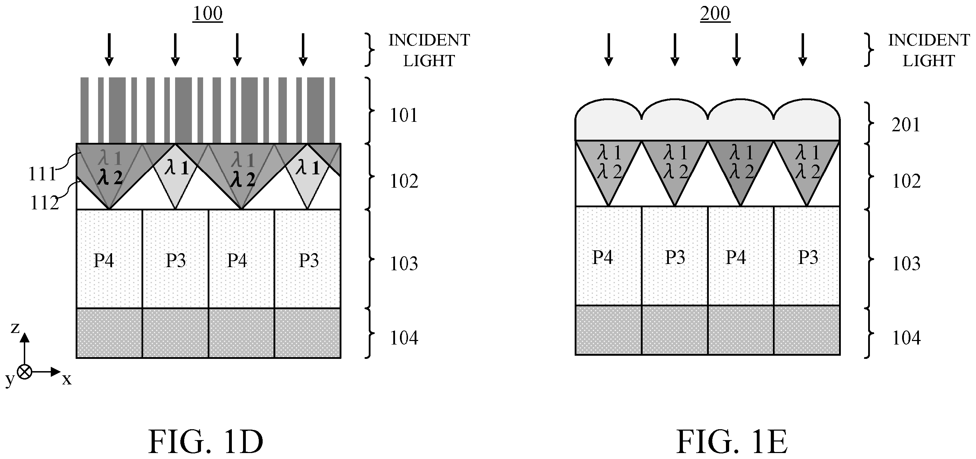

First, an outline of the optical element 100 according to each example will be described with reference to Figs. 1A to 1D. Figs. 1A to 1C illustrate the optical element 100 in an xy plane when viewed from a z-axis direction, and Fig. 1D illustrates an enlarged cross-section (xz plane) taken along line A-A of the optical element 100 illustrated in Fig. 1A when viewed from a y-axis direction. In each example, an optical axis direction of the optical element 100 coincides with the z-axis direction.

The optical element 100 according to each example has a function of condensing incident light onto specific pixels in an image sensor having a region in which periodic structure regions 10 are periodically arranged in the xy plane.

In Fig. 1A, ch1 to ch4 are pixels of the image sensor and constitute the periodic structure region 10. The pixels ch1 to ch4 are periodically arranged in the xy plane as a repeating unit. The pixels ch1 to ch4 may be pixels that function to receive light having mutually different wavelengths, for example. Such pixels can receive light incident via an unillustrated imaging optical system and record light intensity information on an object. For example, in a case where the pixels ch1 to ch4 are configured to receive incident light corresponding to red (R), green (G), and blue (B), a color image can be obtained. In a case where some of the pixels are configured to receive ultraviolet (UV) light or infrared (IR) light, an image outside a visible light region can be obtained.

In a case where UV light can be captured, noncontact inspection of corrosion, scratches, defects, and the like of a substance, medical diagnosis for detecting skin abnormalities, and authenticity inspection of banknotes and currency can be achieved. In a case where IR light can be captured, it becomes possible to monitor a health condition of crops, measure oxygen saturation of blood vessels and tissues, and perform surveillance imaging at night or in a dark place, thereby making it possible to obtain information that cannot be obtained only by imaging in a visible light region.

There is a demand for an optical element using a fine concavo-convex structure capable of receiving such light outside the visible light region with higher sensitivity than the conventional image sensor, and for an image sensor having the same. In the optical element according to each example, higher sensitivity is achieved by expanding a condensing region, which is a range of incident light condensed onto a specific pixel, by the fine concavo-convex structure.

Fig. 1B illustrates a region that condenses light toward each of the pixels ch1 to ch4 in a case where light of a first wavelength λ1 enters the optical element 100 as a first condensing region (RV1 to RV4) 21. Light incident on each first condensing region 21 is condensed toward each corresponding pixel by a condensing action of the first condensing region 21.

Fig. 1C illustrates a region that condenses light toward the pixel ch4 in a case where light of a second wavelength λ2 enters the optical element 100 as a second condensing region (RN4) 22. The second condensing region 22 condenses light incident on an area corresponding to four pixels including the pixel ch4 and its surroundings toward the single pixel ch4. Thereby, light of the second wavelength λ2 can be received by the pixel ch4 with high sensitivity.

A concavo-convex structure group 101 illustrated in Fig. 1D is formed of a dielectric material Si₃N₄ and includes a concavo-convex structure finer than a wavelength of incident light. A material constituting the concavo-convex structure group 101 may be any material that is transparent (for example, having a transmittance of 80% or more) in a used wavelength region, and includes GaN, GaP, GaAs, Si, SiC, Al₂O₃, SiO₂, TiO₂, and the like. A transparent layer 102 is disposed between the concavo-convex structure group 101 and photoelectric conversion layers 103 of the pixels ch1 to ch4, and is formed of silicon oxide (SiOx), silicon nitride (SiN), air, or the like. The photoelectric conversion layers 103 corresponding to the pixels ch1 to ch4 are denoted as P1 to P4. The photoelectric conversion layer 103 converts incident light into an electric signal and transmits the electric signal to an unillustrated signal processing circuit through a wiring layer 104. Wiring in the wiring layer 104 is formed using a metal material such as aluminum, copper, tungsten, or titanium. The signal processing circuit performs predetermined processing on the electric signal input through the wiring layer 104 and outputs a processed signal to the outside.

The image sensor may include, for example, an unillustrated antireflection layer, light-shielding layer, base layer, low-pass filter, color filter, and the like.

Fig. 1D schematically illustrates light that passes through the concavo-convex structure group 101, transmits through the transparent layer 102, and reaches the photoelectric conversion layer 103. A first light beam 111 as light of the first wavelength λ1 is condensed toward the photoelectric conversion layers (P1 to P4) 103 by the first condensing regions (RV1 to RV4) 21 corresponding to the pixels ch1 to ch4. A second light beam 112 as light of the second wavelength λ2 is condensed toward the photoelectric conversion layer 103 by the second condensing region (RN4) 22, which is wider than the first condensing region (RV4) 21 corresponding to the pixel ch4. Thus, the concavo-convex structure group 101 has different condensing actions according to a wavelength of incident light.

Fig. 1E illustrates an optical element 200 according to a comparative example. Light of the first wavelength λ1 and light of the second wavelength λ2 are condensed toward the photoelectric conversion layers (P1 to P4) 103 of the pixels ch1 to ch4 by passing through microlenses 201 provided for the respective pixels. At this time, a condensing region for condensing light reaching each pixel is determined by a shape of the microlens 201, and therefore the condensing region cannot be significantly changed according to the wavelength.

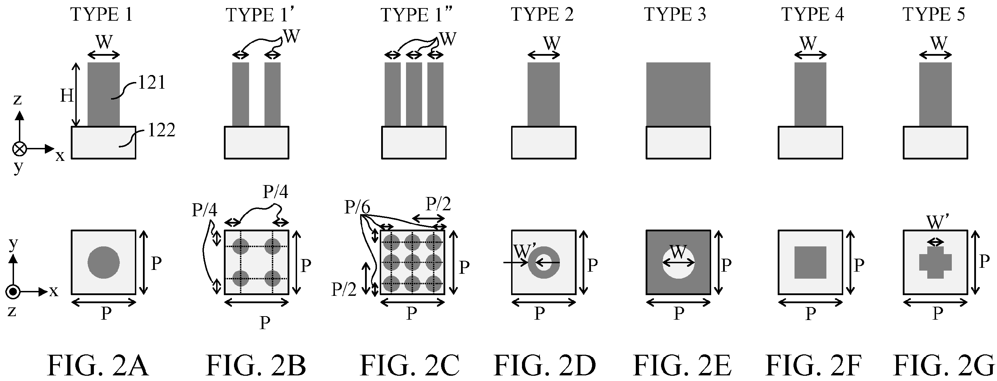

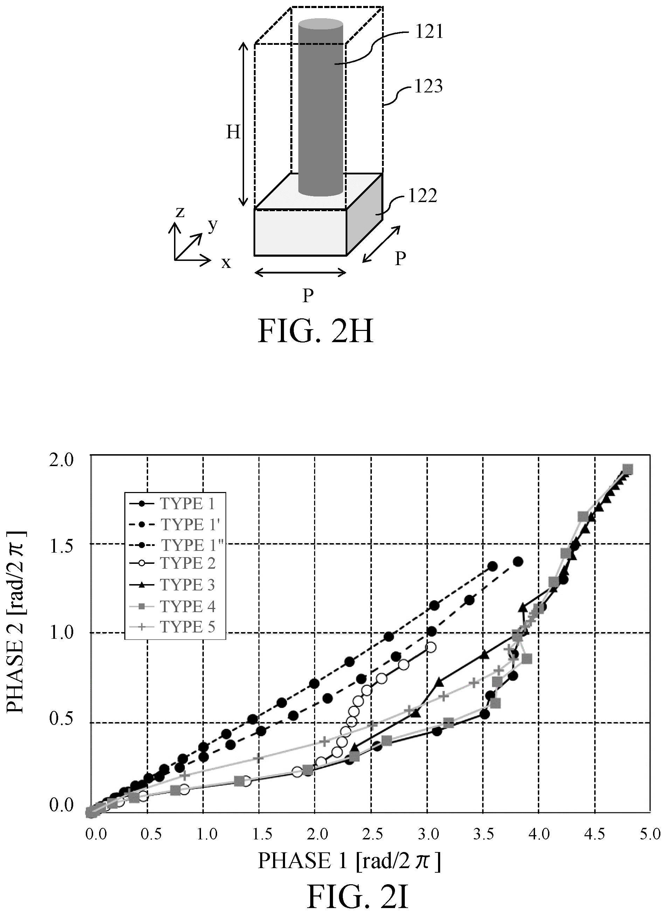

Figs. 2A to 2H illustrate a more detailed configuration of the concavo-convex structure group 101. As illustrated in Fig. 2H as a representative example, one structure is configured for each segment (unit section) divided into a square shape in the xy plane, and includes a convex element 121 having a convex cylindrical shape that contacts a base layer 122. The structure has a constant width (pitch) P and is periodically arranged in the xy plane. That is, the concavo-convex structure group 101 includes a plurality of structures arranged repeatedly. In the concavo-convex structure group 101, a plurality of structures including the convex element 121 are arranged at a repetition period (pitch) P shorter than a wavelength of incident light. The repetition period (pitch) P of the concavo-convex structure group 101 may be the same throughout the xy plane, or may vary depending on position. Although square segments are illustrated in Figs. 2A to 2H, other polygons may be used, or the structures may be arranged at constant intervals in a circumferential direction concentrically with respect to a specific symmetry axis such as an optical axis.

Light incident on this concavo-convex structure group 101 is phase-modulated in accordance with an effective refractive index calculated from a ratio (filling factor) of a volume of the convex element 121 occupying a space 123 in a structure having a height H of the convex element 121, and the structure.

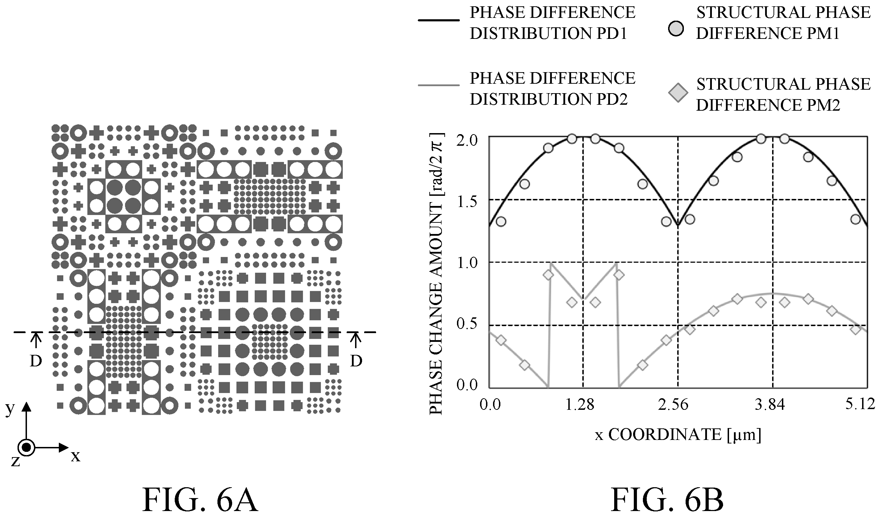

Figs. 2A to 2G illustrate examples of structures having mutually different configurations. Fig. 2A illustrates a structure (type 1) in which one convex element 121 having a convex cylindrical shape is formed at a center portion of a segment. The convex element 121 has a height H and a diameter (width) W. Figs. 2B and 2C illustrate structures (type 1' and type 1") in which four and nine convex cylindrical convex elements 121 are formed in the segment, respectively. Each convex element 121 has a height H and a diameter W. A distance from an edge (side) of the segment to the center of each convex element 121 is P/4 in Fig. 2B, and P/6 and P/2 in Fig. 2C.

Fig. 2D illustrates a structure (type 2) in which a cylindrical concave element (hollow portion) is formed at a central portion of the convex element 121 illustrated in Fig. 2A. The convex element 121 has a height H and a diameter W. A radial thickness of the convex element 121 obtained by subtracting a diameter of the concave element from the diameter of the convex element 121 is W'. Fig. 2E illustrates a structure (type 3) in which a cylindrical space as a concave element is formed at a central portion of a segment and its surrounding is filled with the above material such as GaN. The concave element has a height H and a diameter W.

Fig. 2F illustrates a structure (type 4) in which one convex element 121 having a convex quadrangular prism shape is formed at a central portion of a segment. The convex element 121 has a height H and a width (length of each side) W. Fig. 2G illustrates a structure (type 5) in which the convex element 121 having a columnar shape with a cross-shaped xy cross-section including four protrusions is formed at a central portion of a segment. The convex element 121 has a height H, a maximum width W in the xz plane, and a width W' of each of the four protrusions.

By changing W and W', which are dimensions parallel to the xy plane of the structures of types 1 to 5, not only can a phase change amount at a specific wavelength be changed, but also a ratio of effective refractive indices for different wavelengths, that is, wavelength dispersion, can be adjusted. Although the structures are arranged at the center of the segment in Figs. 2A to 2G, they may be translated in a direction parallel to the x-axis or y-axis. In order to suppress the influence of the polarization state of incident light on a phase change amount, the convex element or concave element may have a shape that is line-symmetric with respect to straight lines passing through the center of the segment and parallel to the x-axis and the y-axis in the xy plane.

Fig. 2I illustrates a relationship between phase change amounts of light having wavelengths of 450 nm and 1050 nm in a case where the structures of type 1 to type 5 are formed of Si₃N₄, the pitch P is 400 nm, the height H is 2000 nm, and ratios of W and W' to the pitch P are varied from 0 to 1. The phase change amount is calculated by rigorous coupled-wave analysis (RCWA), taking a phase change when light passes through air (refractive index of about 1.0) having the height H as zero. A horizontal axis indicates a phase change amount of light having a wavelength of 450 nm, and a vertical axis indicates a phase change amount of light having a wavelength of 1050 nm, each normalized by 2π. If a structure is sufficiently larger than a wavelength of incident light, wavelength dispersion is determined for each material regardless of shape. However, as illustrated in Fig. 2I, wavelength dispersion is not determined only by the filling factor and varies depending on the structure. From this, the phase change amounts for respective wavelengths can be adjusted, and different light-condensing actions can be realized for respective wavelengths.

In the concavo-convex structure group 101, a phase change amount distribution can be formed by changing the type of structure and dimensions such as W between adjacent segments, thereby exhibiting condensing characteristics. Letting m be an integer diffraction order, if a phase change amount distribution is formed concentrically so as to be folded back at 2mπ, a condensing action and a diverging action can be obtained by the m-th order diffracted light.

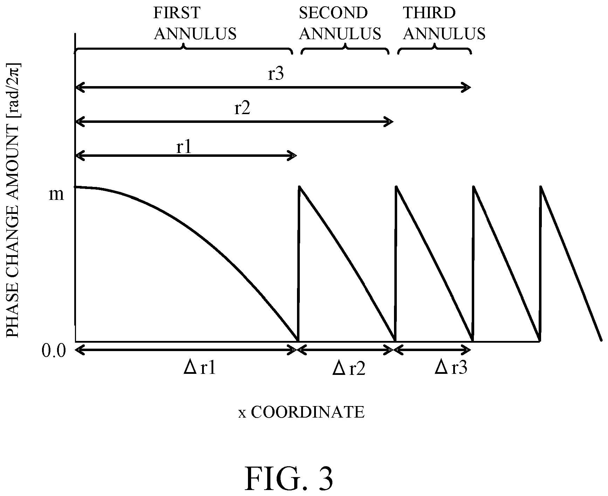

Fig. 3 illustrates a phase change amount distribution representing condensing characteristics. Here, a phase change amount distribution that monotonically decreases as a distance from a condensing position in the xy plane increases and is folded back at 2mπ is illustrated. A distance from the condensing position to an i-th folded position of the phase change amount is defined as an annulus radius ri (i = 1, 2, ...). A region surrounded by ri and r(i-1) is defined as an i-th annulus.

Let a radial length from the condensing position in the xy plane be r, let a focal length be f, and let a wavelength be λ. Then, a phase change amount distribution Ph(r) is expressed by the following equation (a): $Ph \left(r\right) = 2 π \left\{m\times i-\frac{1}{λ}\left(\sqrt{{r}^{2} + {f}^{2}}-f\right)\right\}$ (a)

Equation (a) indicates an equation for calculating a phase change amount distribution from a focal length. However, this equation is merely an example, and the phase change amount distribution may be calculated using a polynomial. As understood from equation (a), in a case where the phase change amount distribution is provided for light having a shorter wavelength, the number of folds at 2mπ increases as compared with light on a relatively longer wavelength side. That is, as the wavelength becomes shorter, the annulus radius ri becomes smaller, and an inter-annulus distance Δri, which is a difference between the radius ri of the i-th annulus and the radius r(i-1) of the (i-1)-th annulus, also becomes smaller as the wavelength becomes shorter. In a case where the inter-annulus distance Δri is sufficiently larger than the pitch P of the structures, a desired phase change amount distribution can be reproduced with high accuracy by the concavo-convex structure group, and condensing efficiency, which is a ratio of an amount of diffracted light propagating in a direction of a designed diffraction order to an amount of incident light, can be increased.

At boundaries between annuli, the phase change amount changes steeply, and thus a filling factor of adjacent structures also changes steeply. Reproducing a steep phase change between adjacent structures is difficult, and the reproduction accuracy of the phase change amount distribution may decrease, resulting in a decrease in condensing efficiency. In a case where obliquely incident light that is incident not from the height direction of the structure but from a direction oblique to the height direction enters both sides of a folding position of the phase change amount, an obtained phase change amount tends to largely deviate from a desired phase change amount, which may cause a decrease in condensing efficiency.

When the condensing efficiency decreases due to these causes, unnecessary light (flare) propagating in directions of diffraction orders other than a designed diffraction order is generated. If this unnecessary light reaches pixels other than a designed pixel, noise is generated, a signal-to-noise ratio (SNR) indicating a strength of noise to an original signal value decreases, and the high-sensitivity imaging becomes difficult.

Accordingly, each example relatively reduces the number of annuli in the concavo-convex structure group and increases the inter-annulus distance by increasing a diffraction order or a phase change amount at a designed wavelength on a shorter wavelength side among a plurality of designed wavelengths. Thereby, the generation of unnecessary light can be suppressed, and the SNR can be increased.

The plurality of structures in the concavo-convex structure group may have shapes satisfying the following inequality (1): $1 < m 1 / m 2 \leq 20$ (1) where m1 is a value obtained by normalizing, by 2π, a maximum phase change amount provided by the plurality of structures to light of the first wavelength, and m2 is a value obtained by normalizing, by 2π, a maximum phase change amount provided by the plurality of structures to light of the second wavelength.

Inequality (1) defines a proper ratio of phase change amounts provided by the plurality of structures to light having mutually different wavelengths. Satisfying inequality (1) can suppress unnecessary light. In general, m1 and m2 are integers and coincide with diffraction orders; however, an actual phase change amount may take a non-integer value in some cases.

In a case where m1/m2 becomes 1 or becomes lower than the lower limit of inequality (1), the inter-annulus distances at the first wavelength and the second wavelength become relatively small. As a result, the accuracy of the phase change amount distribution reproduced by the concavo-convex structure group may decrease, or the influence of unnecessary light due to folding of the phase change amount may increase to decrease the condensing efficiency. In a case where m1/m2 becomes higher than the upper limit of inequality (1), an absolute value of the phase change amount provided to light of the first wavelength λ1 becomes relatively large, so that it becomes necessary to form the concavo-convex structures with a larger height, and an aspect ratio (a ratio of a height to a width of the concavo-convex structures) becomes excessively large, making manufacture difficult.

The lower limit of inequality (1) may be set to 1.1, 1.2, 1.25, 1.5, 1.6, 1.7, 1.8, 1.85, 1.9, 1.95, 2.0, 2.2, 2.4, 2.6, or 2.8. The upper limit of inequality (1) may be set to 16, 14, 12, 10, 8, 6, 4.2, 4, 3.2, 3, 2.4, 2.2, or 2.

The plurality of structures may have shapes satisfying the following inequality (2): $0.1 \leq m 1 - m 2 \leq 10.0$ (2)

Inequality (2) defines a proper difference between phase change amounts provided by the plurality of structures to light having mutually different wavelengths. Satisfying inequality (2) can suppress unnecessary light. In a case where m1-m2 becomes lower than the lower limit of inequality (2), the inter-annulus distances at the first wavelength and the second wavelength become relatively small. As a result, the accuracy of the phase change amount distribution reproduced by the concavo-convex structure group may decrease, or the influence of unnecessary light due to folding of the phase change amount may increase to decrease the condensing efficiency. In a case where m1-m2 becomes higher than the upper limit of inequality (2), an absolute value of the phase change amount provided to light of the first wavelength becomes relatively large, so that it becomes necessary to increase a height of each structure, and an aspect ratio (a ratio of a height to a width of each structure) becomes excessively large, making manufacture difficult.

The lower limit of inequality (2) may be set to 0.15, 0.2, 0.25, 0.3, 0.4, 0.5, 0.6, 0.7, 0.8, 0.9, 0.95, 1, 1.1, 1.8, 1.9, or 1.95. The upper limit of inequality (2) may be set to 8, 6, 4.2, 3.8, 3.2, 2.8, 2.6, 2.4, 2.2, 2.1, 2, 1.9, 1.8, 1.6, 1.4, or 1.2.

In a case where at least one of the first wavelength λ1 or the second wavelength λ2 is a wavelength in a visible light region, and the following inequality (3) may be satisfied. $λ 1 < λ 2$ (3)

Inequality (3) defines a proper relationship between wavelengths that are different from each other. Visible light is an electromagnetic-wave wavelength range visible to human eyes, and is light having a wavelength approximately in a range from 380 nm to 750 nm. Satisfying inequality (3) can suppress unnecessary light. In a case where inequality (3) is not satisfied, it becomes necessary to relatively increase an absolute value of a phase change amount provided to light of the second wavelength λ2, so that it becomes necessary to increase a height of each structure, and an aspect ratio increases, making manufacture difficult.

The plurality of structures may have shapes satisfying the following inequality (4). $0.2 \leq \left(λ1\times m1\right) / \left(λ2\times m2\right) \leq 10.0$ (4)

Inequality (4) defines a proper relationship between mutually different wavelengths and phase change amounts. Satisfying inequality (4) can suppress unnecessary light. In a case where (λ1×m1)/(λ2×m2) becomes lower than the lower limit of inequality (4), the inter-annulus distance at the first wavelength λ1 becomes relatively small. As a result, the accuracy of the phase change amount distribution reproduced by the concavo-convex structure group may decrease, or the influence of unnecessary light due to folding of the phase change amount may increase to decrease the condensing efficiency. In a case where (λ1×m1)/(λ2×m2) becomes higher than upper limit of inequality (4), the inter-annulus distance at the second wavelength becomes relatively small. As a result, the accuracy of the phase change amount distribution reproduced by the concavo-convex structure group may decrease, or the influence of unnecessary light due to folding of the phase change amount may increase to decrease the condensing efficiency.

The lower limit of inequality (4) may be set to 0.3, 0.4, 0.5, 0.6, 0.65, 0.7, 0.75, or 0.8. The upper limit of inequality (4) may be set to 9.0, 8.0, 7.0, 6.0, 5.0, 4.0, 3.0, 2.8, 2.6, 2.4, 2.2, 2.0, 1.8, 1.6, 1.5, 1.4, 1.3, 1.2, or 1.1.

The plurality of structures may satisfy the following inequality (5): $0.8 \leq Hmin / Hmax \leq 1.0$ (5) where Hmax is a maximum value and Hmin is a minimum value of heights of the plurality of structures.

Inequality (5) defines proper heights of the plurality of structures. In a case where Hmin/Hmax becomes lower than the lower limit of inequality (5) or becomes higher than the upper limit, it becomes necessary to form the plurality of structures in a plurality of steps, which complicates manufacture.

The lower limit of inequality (5) may be set to 0.84, 0.88, 0.90, 0.92, 0.94, 0.96, or 0.98. The upper limit of inequality (5) may be set to 1.16, 1.12, 1.10, 1.08, 1.06, or 1.04.

The plurality of structures may have shapes satisfying the following inequality (6): $0.90 \leq Hmax \left(n2-1\right) / \left(m2\times λ2\right) \leq 5.00$ (6) where n2 is a refractive index of the plurality of structures at the second wavelength λ2.

Inequality (6) defines proper shapes of the plurality of structures. In a case where the value of inequality (6) becomes lower than the lower limit, a sufficient phase change amount cannot be provided for the second wavelength λ2, making it difficult to form a desired phase change amount distribution, and unnecessary light may be generated. In a case where the value of inequality (6) becomes higher than the upper limit, an aspect ratio of each structure increases, making manufacture difficult.

The lower limit of inequality (6) may be set to 1.0, 1.1, 1.2, 1.3, 1.4, 1.5, 1.6, 1.7, 1.8, or 1.9. The upper limit of inequality (6) may be set to 4.6, 4.4, 3.8, 3.4, 3.0, 2.8, 2.6, 2.4, 2.2, or 2.0.

A repetition period (pitch) P of each structure may satisfy the following inequality (7): $0.1 \leq P / λ 1 \leq 1.5$ (7)

Inequality (7) defines a proper pitch of each structure for light of the first wavelength λ1. In a case where P/λ1 becomes lower than the lower limit of inequality (7), the pitch becomes relatively small or an aspect ratio becomes excessively large, making manufacture of the plurality of structures difficult. In a case where P/λ1 becomes higher than the upper limit of inequality (7), the pitch cannot be made sufficiently small relative to the wavelength of incident light, and reflective diffraction caused by the plurality of structures occurs, making it difficult to increase the condensing efficiency.

The lower limit of inequality (7) may be set to 0.2, 0.3, 0.4, 0.5, 0.55, 0.6, 0.65, 0.7, 0.75, 0.80, or 0.85. The upper limit of inequality (7) may be set to 1.4, 1.3, 1.2, 1.15, 1.10, 1.05, 1.0, 0.95, or 0.9.

Let a maximum width (maximum diagonal length or maximum dimension) of each first condensing region 21 having a condensing function among the plurality of structures be W1max and let a focal length of each first condensing region 21 at the first wavelength λ1 be f1. Then, the following inequality (8) may be satisfied. $0.1 \leq f 1 / W 1 max \leq 4.0$ (8)

Inequality (8) defines proper condensing characteristics of the plurality of structures. In a case where f1/W1max becomes lower than the lower limit of inequality (8), the inter-annulus distance at the first wavelength becomes relatively small. As a result, the accuracy of the phase change amount distribution reproduced by the concavo-convex structure group may decrease, or the influence of unnecessary light due to folding of the phase change amount may increase to decrease the condensing efficiency. In a case where f1/W1max becomes higher than the upper limit of inequality (8), the phase change amount distribution becomes gentle, so that folding of the phase change amount can be avoided or the number of annuli can be reduced, and unnecessary light can be suppressed even without the configuration according to each example.

The lower limit of inequality (8) may be set to 0.2, 0.3, 0.4, 0.5, 0.55, 0.6, 0.65, or 0.7. The upper limit of inequality (8) may be set to 3.5, 2.8, 2.5, 2.2, 2.0, 1.8, 1.6, 1.4, 1.2, 1.0, 0.95, 0.9, 0.85, or 0.80.

The plurality of annuli may satisfy the following inequality (9): $1.2 \leq Δrmin 1 / P \leq 20.0$ (9) where Δrmin1 is a minimum inter-annulus distance at the first wavelength.

Inequality (9) defines a proper range of the minimum inter-annulus distance. In a case where Δrmin1/P becomes lower than a lower limit of inequality (9), the inter-annulus distance at the first wavelength becomes relatively small. As a result, the accuracy of the phase change amount distribution reproduced by the concavo-convex structure group may decrease, or the influence of unnecessary light due to folding of the phase change amount may increase to decrease the condensing efficiency. In a case where Δrmin1/P becomes higher than the upper limit of inequality (9), an aspect ratio of each structure increases, making manufacture difficult.

The lower limit of inequality (9) may be set to 1.6, 1.8, 2.0, 2.4, 2.8, 3.0, 3.2, 3.3, 3.4, 3.5, or 3.6. The upper limit of inequality (9) may be set to 18, 16, 14, 12, 10, 9, 8, 7, 6.5, 6, 5.8, or 5.6.

Let a maximum value of a filling factor of the structures be FFmax and let a minimum value thereof be FFmin. Then, the following inequality (10) may be satisfied: $0.1 \leq FFmax - FFmin < 1.0$ (10)

Inequality (10) defines a proper relationship among filling factors of the plurality of structures. In a case where FFmax-FFmin becomes lower than the lower limit of inequality (10), a variation range of the filling factor among the plurality of structures reduces, and a wavelength dependence of the phase change amount becomes less distinct. As a result, it becomes difficult to obtain a concavo-convex structure group having different functions for respective wavelengths. Since a maximum value of the filling factor is 1 and a minimum value thereof is 0 by definition, FFmax-FFmin does not become higher than the upper limit of inequality (10).

The lower limit of inequality (10) may be set to 0.2, 0.3, 0.34, 0.38, 0.40, 0.42, 0.43, 0.44, 0.45, 0.50, 0.60, 0.70, 0.80, or 0.90.

Satisfying at least one of the above conditions can provide an optical element having mutually different condensing actions (or diverging actions) relative to light having mutually different wavelengths.

Details of the optical element 100 according to each example will be described below.

### EXAMPLE 1

The optical element according to Example 1 is configured for visible light having a first wavelength λ1 of 450 nm and IR light having a second wavelength λ2 of 1050 nm. The concavo-convex structure group 101 is formed of Si₃N₄, and the transparent layer 102 is formed of SiO₂. The pitch P of the structures is 400 nm and the height H is 2000 nm. The concavo-convex structure group 101 condenses light of the first wavelength λ1 onto pixels ch1 to ch4 each having a square shape with a side length of 3200 nm. The concavo-convex structure group 101 condenses light of the second wavelength λ2 onto the pixel ch4.

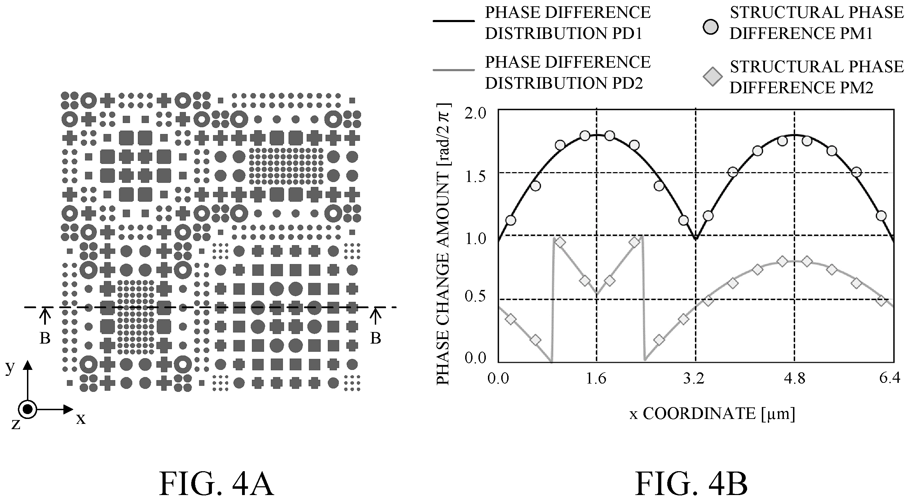

Fig. 4A illustrates an xy cross-section of the concavo-convex structure group according to Example 1. Fig. 4B illustrates, in a cross-section taken along line B-B in Fig. 4A, phase change amount distributions PD1 and PD2 provided for light of the first wavelength and light of the second wavelength, respectively, and structural phase differences PM1 and PM2 realized by the concavo-convex structure group. Fig. 4B illustrates the phase change amounts with an offset such that the smallest phase change amount becomes 0.

As illustrated in Fig. 4A, in Example 1, a region of four pixels ch1 to ch4 is divided into 16 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 3200 nm, and light incident parallel to a z-axis direction (optical axis direction) is condensed toward the center of each pixel.

Each of the first condensing region and the second condensing region is a square region as illustrated in Fig. 1B, and maximum widths W1max and W2max of the first condensing region and the second condensing region are 4525 nm and 9051 nm, respectively.

Phase change amounts m1 and m2 provided for the first wavelength and the second wavelength are 1.223 and 0.963, respectively.

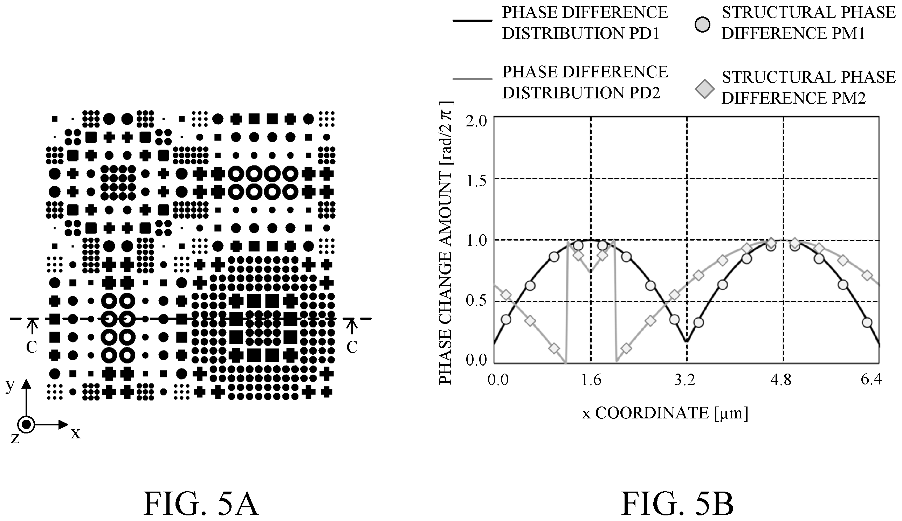

Fig. 5A illustrates an xy cross-section of a concavo-convex structure group according to a comparative example 1. Fig. 5B illustrates, in a cross-section taken along line C-C in Fig. 5A, phase change amount distributions PD1 and PD2 provided for light of the first wavelength and light of the second wavelength, respectively, and structural phase differences PM1 and PM2 realized by the concavo-convex structure group. In Fig. 5B, the phase change amounts are illustrated with an offset such that the smallest phase change amount becomes 0.

In comparative example 1, phase change amounts m1 and m2 are 0.94 and 0.98, respectively, and other specifications are the same as those in Example 1.

At the first wavelength λ1, comparative example 1 has an annulus number of 2 and a minimum annulus width of 803 nm, whereas Example 1 has an annulus number of 1 and a minimum annulus width of 1534 nm.

In Example 1, since the annulus number is reduced as compared with comparative example 1, folding of the phase change amount can be reduced. As a result, generation of unnecessary light can be suppressed. This is similarly applied to other examples described below.

### EXAMPLE 2

The optical element according to Example 2 is configured for visible light having a first wavelength λ1 of 450 nm and infrared light having a second wavelength λ2 of 1050 nm. The concavo-convex structure group 101 is formed of TiO₂, and the transparent layer 102 is formed of SiO₂. The pitch P of the structures is 320 nm and the height H is 1250 nm. The concavo-convex structure group 101 condenses light of the first wavelength λ1 onto pixels ch1 to ch4 each having a square shape with a side length of 2560 nm. The concavo-convex structure group 101 condenses light of the second wavelength λ2 onto the pixel ch4.

Fig. 6A illustrates an xy cross-section of the concavo-convex structure group according to Example 2. Fig. 6B illustrates, in a cross-section taken along line D-D in Fig. 6A, phase change amount distributions PD1 and PD2 provided for light of the first wavelength and light of the second wavelength, respectively, and structural phase differences PM1 and PM2 realized by the concavo-convex structure group. Fig. 6B illustrates the phase change amounts with an offset such that the smallest phase change amount becomes 0.

As illustrated in Fig. 6A, in Example 2, a region of four pixels ch1 to ch4 is divided into 16 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 2000 nm, and light incident parallel to a z-axis direction is condensed toward a center of each pixel.

Each of the first condensing region and the second condensing region is a square region as illustrated in Fig. 1B, and maximum widths W1max and W2max of the first condensing region and the second condensing region are 3620 nm and 7421 nm, respectively.

Phase change amounts m1 and m2 provided for the first wavelength and the second wavelength are 1.197 and 0.931, respectively.

### EXAMPLE 3

The optical element according to Example 3 is configured for visible light having a first wavelength λ1 of 450 nm and infrared light having a second wavelength λ2 of 850 nm. The concavo-convex structure group 101 is formed of TiO₂, and the transparent layer 102 is formed of SiO₂. The pitch P of the structures is 320 nm and the height H is 1250 nm. The concavo-convex structure group 101 condenses light of the first wavelength λ1 onto pixels ch1 to ch4 each having a square shape with a side length of 4800 nm. The concavo-convex structure group 101 condenses light of the second wavelength λ2 onto the pixel ch4.

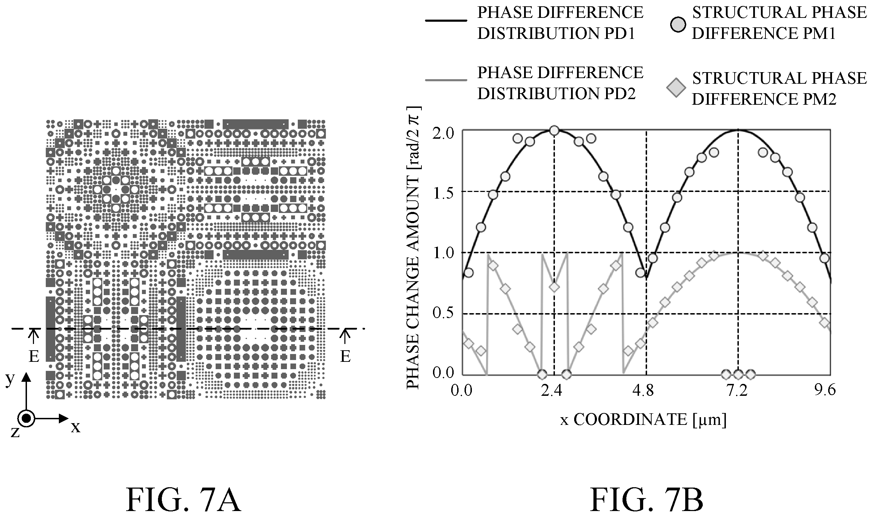

Fig. 7A illustrates an xy cross-section of the concavo-convex structure group according to Example 3. Fig. 7B illustrates, in a cross-section taken along line E-E in Fig. 7A, phase change amount distributions PD1 and PD2 provided for light of the first wavelength and light of the second wavelength, respectively, and structural phase differences PM1 and PM2 realized by the concavo-convex structure group. Fig. 7B illustrates the phase change amounts with an offset such that the smallest phase change amount becomes 0.

As illustrated in Fig. 7A, in Example 3, a region of four pixels ch1 to ch4 is divided into 16 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 5000 nm, and light incident parallel to a z-axis direction is condensed toward a center of each pixel.

Each of the first condensing region and the second condensing region is a square region as illustrated in Fig. 1B, and maximum widths W1max and W2max of the first condensing region and the second condensing region are 6788 nm and 13576 nm, respectively.

Phase change amounts m1 and m2 provided for the first wavelength and the second wavelength are 1.977 and 0.996, respectively.

### EXAMPLE 4

The optical element according to Example 4 is configured for visible light having a first wavelength λ1 of 500 nm and infrared light having a second wavelength λ2 of 950 nm. The concavo-convex structure group 101 is formed of Si₃N₄, and the transparent layer 102 is formed of SiO₂. The pitch P of the structures is 400 nm and the height H is 2000 nm. The concavo-convex structure group 101 condenses light of the first wavelength λ1 onto pixels ch1 to ch4 each having a square shape with a side length of 6000 nm. The concavo-convex structure group 101 condenses light of the second wavelength λ2 onto the pixel ch4.

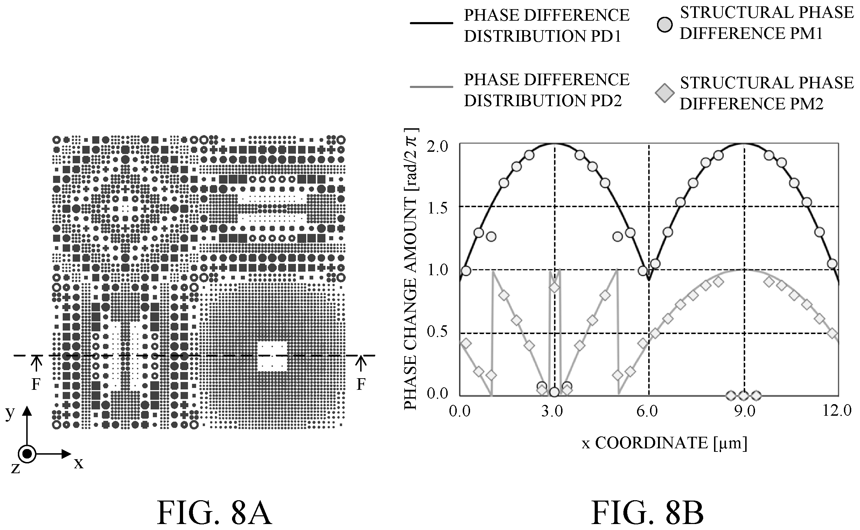

Fig. 8A illustrates an xy cross-section of the concavo-convex structure group according to Example 4. Fig. 8B illustrates, in a cross-section taken along line F-F in Fig. 8A, phase change amount distributions PD1 and PD2 provided for light of the first wavelength and light of the second wavelength, respectively, and structural phase differences PM1 and PM2 realized by the concavo-convex structure group. Fig. 8B illustrates the phase change amounts with an offset such that the smallest phase change amount becomes 0.

As illustrated in Fig. 8A, in Example 4, a region of four pixels ch1 to ch4 is divided into 30 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 8000 nm, and light incident parallel to a z-axis direction is condensed toward a center of each pixel.

Each of the first condensing region and the second condensing region is a square region as illustrated in Fig. 1B, and maximum widths W1max and W2max of the first condensing region and the second condensing region are 8485 nm and 16971 nm, respectively.

Phase change amounts m1 and m2 provided for the first wavelength and the second wavelength are 1.980 and 0.997, respectively.

### EXAMPLE 5

The optical element according to Example 5 is configured for visible light having a first wavelength λ1 of 500 nm and infrared light having a second wavelength λ2 of 950 nm. The concavo-convex structure group 101 is formed of Si₃N₄, and the transparent layer 102 is formed of SiO₂. The pitch P of the structures is 400 nm and the height H is 2000 nm. The concavo-convex structure group 101 condenses light of the first wavelength λ1 onto pixels ch1 to ch4 each having a square shape with a side length of 6000 nm. The concavo-convex structure group 101 condenses light of the second wavelength λ2 onto the pixel ch4.

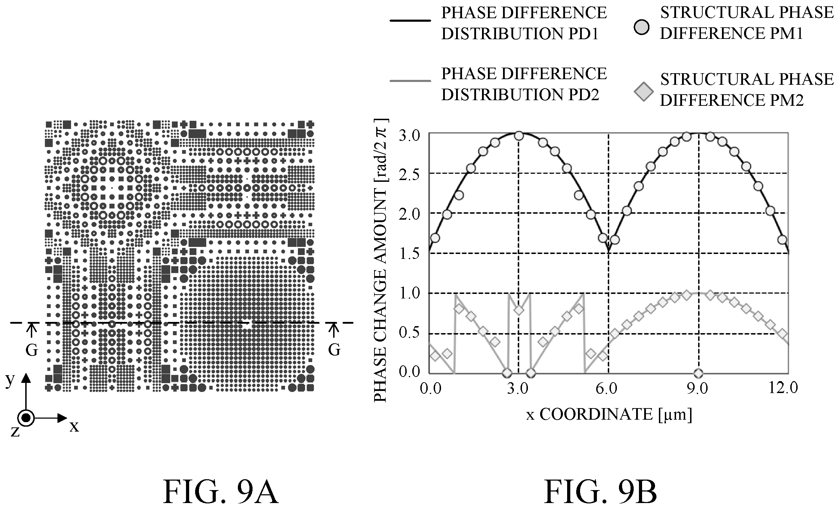

Fig. 9A illustrates an xy cross-section of the concavo-convex structure group according to Example 5. Fig. 9B illustrates, in a cross-section taken along line G-G in Fig. 9A, phase change amount distributions PD1 and PD2 provided for light of the first wavelength and light of the second wavelength, respectively, and structural phase differences PM1 and PM2 realized by the concavo-convex structure group. Fig. 9B illustrates the phase change amounts with an offset such that the smallest phase change amount becomes 0.

As illustrated in Fig. 9A, in Example 5, a region of four pixels ch1 to ch4 is divided into 30 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 6500 nm, and light incident parallel to a z-axis direction is condensed toward a center of each pixel.

Each of the first condensing region and the second condensing region is a square region as illustrated in Fig. 1B, and maximum widths W1max and W2max of the first condensing region and the second condensing region are 8485 nm and 16971 nm, respectively.

Phase change amounts m1 and m2 provided for the first wavelength and the second wavelength are 2.973 and 0.988, respectively.

### EXAMPLE 6

The optical element according to Example 6 is configured for visible light having a first wavelength λ1 of 450 nm and visible light having a second wavelength λ2 of 650 nm. The concavo-convex structure group 101 is formed of TiO₂, and the transparent layer 102 is formed of SiO₂. The pitch P of the structures is 320 nm and the height H is 1250 nm. The concavo-convex structure group 101 condenses light of the first wavelength λ1 onto pixels ch1 to ch4 each having a square shape with a side length of 2560 nm. The concavo-convex structure group 101 condenses light of the second wavelength λ2 onto the pixel ch4.

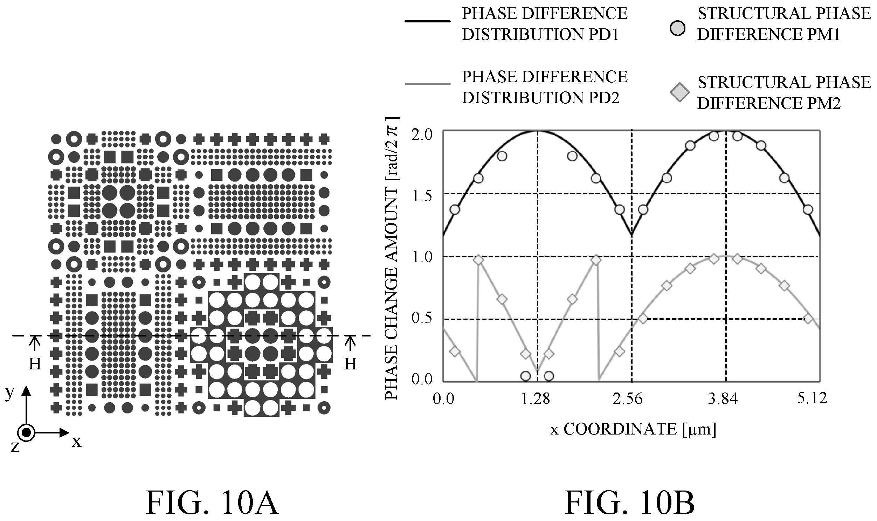

Fig. 10A illustrates an xy cross-section of the concavo-convex structure group according to Example 6. Fig. 10B illustrates, in a cross-section taken along line H-H in Fig. 10A, phase change amount distributions PD1 and PD2 provided for light of the first wavelength and light of the second wavelength, respectively, and structural phase differences PM1 and PM2 realized by the concavo-convex structure group. Fig. 10B illustrates the phase change amounts with an offset such that the smallest phase change amount becomes 0.

As illustrated in Fig. 10A, in Example 6, a region of four pixels ch1 to ch4 is divided into 16 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 2000 nm, and light incident parallel to a z-axis direction is condensed toward a center of each pixel.

Each of the first condensing region and the second condensing region is a square region as illustrated in Fig. 1B, and maximum widths W1max and W2max of the first condensing region and the second condensing region are 3620 nm and 7241 nm, respectively.

Phase change amounts m1 and m2 provided for the first wavelength and the second wavelength are 1.197 and 0.964, respectively.

### EXAMPLE 7

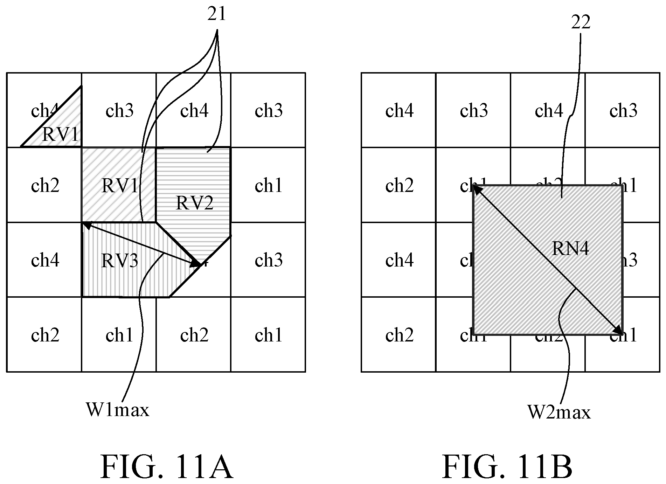

The optical element according to Example 7 is configured for visible light having a first wavelength λ1 of 450 nm and infrared light having a second wavelength λ2 of 1050 nm. The concavo-convex structure group 101 is formed of TiO₂, and the transparent layer 102 is formed of SiO₂. The pitch P of the structures is 320 nm and the height H is 1250 nm. As illustrated in Fig. 11A, in a region corresponding to pixels ch1 to ch3 among pixels ch1 to ch4 each having a square shape with a side length of 2560 nm, the concavo-convex structure group 101 condenses light of the first wavelength λ1 onto the pixels ch1 to ch3. In a region corresponding to the pixel ch4, the concavo-convex structure group 101 divides light of the first wavelength λ1 into approximately three equal portions and condenses the portions onto the pixels ch1 to ch3.

In this example, the maximum width W1max of the first condensing region 21 becomes larger than that in a setting of the first condensing region 21 illustrated in Fig. 1B. Thus, setting a phase change amount for the first wavelength λ1 to be greater than 1 to increase a minimum inter-annulus distance can effectively suppress unnecessary light. As illustrated in Fig. 11B, the concavo-convex structure group 101 condenses light of the second wavelength λ2 onto the pixel ch4.

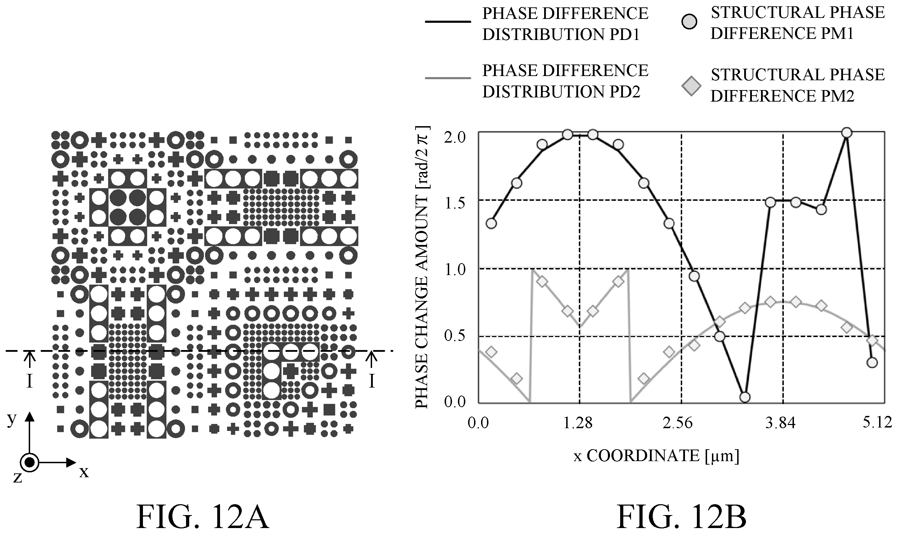

Fig. 12A illustrates an xy cross-section of the concavo-convex structure group according to Example 7. Fig. 12B illustrates, in a cross-section taken along line I-I in Fig. 12A, phase change amount distributions PD1 and PD2 provided for light of the first wavelength and light of the second wavelength, respectively, and structural phase differences PM1 and PM2 realized by the concavo-convex structure group. Fig. 12B illustrates the phase change amounts with an offset such that the smallest phase change amount becomes 0.

As illustrated in Fig. 12A, in Example 7, a region of four pixels ch1 to ch4 is divided into 16 segments in each of an x-axis direction and a y-axis direction, and a plurality of types of structures having mutually different configurations are periodically arranged in the x-axis direction and the y-axis direction in these square segments. Focal lengths at the first wavelength and the second wavelength by the concavo-convex structure group are both 2000 nm, and light incident parallel to a z-axis direction is condensed toward the center of each pixel.

Each of the first condensing region and the second condensing region is a square region as illustrated in Fig. 1B, and maximum widths W1max and W2max of the first condensing region and the second condensing region are 7210 nm and 7241 nm, respectively.

Phase change amounts m1 and m2 provided for the first wavelength and the second wavelength are 1.961 and 0.931, respectively.

The optical elements according to the examples described above can be manufactured by a lithography technique. For example, using a mold formed by electron-beam writing, laser writing, lithography, or the like, a resist material that becomes a desired concavo-convex structure group may be formed by nanoimprint lithography, and the concavo-convex structure group can be formed by lithography using the resist material. However, a manufacturing method of the optical element according to each example is not limited to nanoimprint lithography, and other methods may be used, such as directly forming the concavo-convex structure group using an electron beam or a laser.

Numerical examples 1 to 7 corresponding to Examples 1 to 7 and a comparative numerical example 1 corresponding to comparative example 1 will be described below. In each numerical example, center coordinates of each segment are represented by Cx and Cy, and types of structures illustrated in Figs. 2A to 2G are represented as type 1 to type 5. The widths of the convex element or the concave element are represented by W and W', and a filling factor of the structure is represented by FF. In a case where the concavo-convex structure group is line-symmetric or rotationally symmetric with respect to centers of the four pixels ch1 to ch4, numerical values of only a part of a region are illustrated.

Let a refractive index at a wavelength λ be nλ. Then, Table 1 summarizes the refractive indices of the materials. Table 2 summarizes values related to inequalities (1) to (10) in numerical examples 1 to 7 and comparative numerical example 1. The optical elements according to numerical examples 1 to 7 satisfy inequalities (1) to (10).

### NUMERICAL EXAMPLE 1

| Cx | Cy | PM1 | PM2 | PD1 | PD2 | type | W | W' | FF |
|---|---|---|---|---|---|---|---|---|---|
| 1.80 | 1.80 | 1.794 | 0.646 | 1.772 | 0.666 | type1" | 102.7 | | 0.466 |
| 2.20 | 1.80 | 1.718 | 0.950 | 1.662 | 0.916 | type5 | 300.0 | 243.0 | 0.542 |
| 2.60 | 1.80 | 1.397 | 0.177 | 1.448 | 0.144 | type1 | 164.0 | | 0.132 |
| 3.00 | 1.80 | 1.124 | 0.342 | 1.137 | 0.346 | type1' | 116.0 | | 0.264 |
| 3.40 | 1.80 | 1.159 | 0.488 | 1.137 | 0.516 | type5 | 240.0 | 141.6 | 0.299 |
| 3.80 | 1.80 | 1.505 | 0.625 | 1.448 | 0.649 | type4 | 244.0 | | 0.372 |
| 4.20 | 1.80 | 1.674 | 0.734 | 1.662 | 0.741 | type1 | 296.0 | | 0.430 |
| 4.60 | 1.80 | 1.753 | 0.800 | 1.772 | 0.788 | type5 | 300.0 | 171.0 | 0.458 |
| 1.80 | 2.20 | 1.682 | 0.606 | 1.662 | 0.631 | type1" | 100.0 | | 0.442 |
| 2.20 | 2.20 | 1.632 | 0.810 | 1.554 | 0.879 | type5 | 320.0 | 150.4 | 0.460 |
| 2.60 | 2.20 | 1.303 | 0.167 | 1.343 | 0.105 | type1 | 160.0 | | 0.126 |
| 3.00 | 2.20 | 1.028 | 0.316 | 1.036 | 0.305 | type1' | 112.0 | | 0.246 |
| 3.40 | 2.20 | 1.050 | 0.471 | 1.036 | 0.472 | type5 | 240.0 | 134.4 | 0.290 |
| 3.80 | 2.20 | 1.357 | 0.557 | 1.343 | 0.604 | type4 | 232.0 | | 0.336 |
| 4.20 | 2.20 | 1.586 | 0.673 | 1.554 | 0.695 | type4 | 252.0 | | 0.397 |
| 4.60 | 2.20 | 1.674 | 0.734 | 1.662 | 0.741 | type1 | 296.0 | | 0.430 |
| 1.80 | 2.60 | 1.424 | 0.561 | 1.448 | 0.563 | type1 | 264.0 | | 0.342 |
| 2.20 | 2.60 | 1.400 | 0.716 | 1.343 | 0.807 | type5 | 320.0 1 | 128.0 | 0.410 |
| 2.60 | 2.60 | 1.149 | 0.962 | 1.137 | 0.029 | type2 | 376.0 1 | 104.0 | 0.555 |
| 3.00 | 2.60 | 0.809 | 0.254 | 0.837 | 0.224 | type1' | 102.0 | | 0.204 |
| 3.40 | 2.60 | 0.876 | 0.395 | 0.837 | 0.387 | type1 | 228.0 | | 0.255 |
| 3.80 | 2.60 | 1.159 | 0.488 | 1.137 | 0.516 | type5 | 240.0 | 141.6 | 0.299 |
| 4.20 | 2.60 | 1.357 | 0.557 | 1.343 | 0.604 | type4 | 232.0 | | 0.336 |
| 4.60 | 2.60 | 1.505 | 0.625 | 1.448 | 0.649 | type4 | 244.0 | | 0.372 |
| 1.80 | 3.00 | 1.157 | 0.465 | 1.137 | 0.463 | type1 | 244.0 | | 0.292 |
| 2.20 | 3.00 | 1.105 | 0.626 | 1.036 | 0.701 | type5 | 320.0 | 108.8 | 0.361 |
| 2.60 | 3.00 | 0.825 | 0.917 | 0.837 | 0.916 | type1' | 174.0 | | 0.594 |
| 3.00 | 3.00 | 0.542 | 0.089 | 0.549 | 0.105 | type4 | 108.0 | | 0.073 |
| 3.40 | 3.00 | 0.603 | 0.224 | 0.549 | 0.264 | type1" | 65.3 | | 0.189 |
| 3.80 | 3.00 | 0.876 | 0.395 | 0.837 | 0.387 | type1 | 228.0 | | 0.255 |
| 4.20 | 3.00 | 1.050 | 0.471 | 1.036 | 0.472 | type5 | 240.0 | 134.4 | 0.290 |
| 4.60 | 3.00 | 1.159 | 0.488 | 1.137 | 0.516 | type5 | 240.0 | 141.6 | 0.299 |
| 1.80 | 3.40 | 1.124 | 0.342 | 1.137 | 0.332 | type1' | 116.0 | | 0.264 |
| 2.20 | 3.40 | 1.032 | 0.594 | 1.036 | 0.563 | type5 | 300.0 | 114.0 | 0.346 |
| 2.60 | 3.40 | 0.829 | 0.765 | 0.837 | 0.771 | type2 | 340.0 | 96.0 | 0.460 |
| 3.00 | 3.40 | 0.640 | 0.835 | 0.549 | 0.953 | type1' | 168.0 | | 0.554 |
| 3.40 | 3.40 | 0.542 | 0.089 | 0.549 | 0.105 | type4 | 108.0 | | 0.073 |
| 3.80 | 3.40 | 0.809 | 0.254 | 0.837 | 0.224 | type1' | 102.0 | | 0.204 |
| 4.20 | 3.40 | 1.028 | 0.316 | 1.036 | 0.305 | type1' | 112.0 | | 0.246 |
| 4.60 | 3.40 | 1.124 | 0.342 | 1.137 | 0.346 | type1' | 116.0 | | 0.264 |
| 1.80 | 3.80 | 1.476 | 0.191 | 1.448 | 0.174 | type4 | 148.0 | | 0.137 |
| 2.20 | 3.80 | 1.329 | 0.400 | 1.343 | 0.397 | type1' | 124.0 | | 0.302 |
| 2.60 | 3.80 | 1.130 | 0.619 | 1.137 | 0.597 | type5 | 300.0 | 120.0 | 0.360 |
| 3.00 | 3.80 | 0.829 | 0.765 | 0.837 | 0.771 | type2 | 340.0 | 96.0 | 0.460 |
| 3.40 | 3.80 | 0.825 | 0.917 | 0.837 | 0.916 | type1' | 174.0 | | 0.594 |
| 3.80 | 3.80 | 1.149 | 0.962 | 1.137 | 0.029 | type2 | 376.0 | 104.0 | 0.555 |
| 4.20 | 3.80 | 1.303 | 0.167 | 1.343 | 0.105 | type1 | 160.0 | | 0.126 |
| 4.60 | 3.80 | 1.397 | 0.177 | 1.448 | 0.144 | type1 | 164.0 | | 0.132 |
| 1.80 | 4.20 | 1.717 | 0.963 | 1.662 | 0.991 | type5 | 300.0 | 255.0 | 0.550 |
| 2.20 | 4.20 | 1.582 | 0.204 | 1.554 | 0.205 | type4 | 152.0 | | 0.144 |
| 2.60 | 4.20 | 1.329 | 0.400 | 1.343 | 0.397 | type1' | 124.0 | | 0.302 |
| 3.00 | 4.20 | 1.032 | 0.594 | 1.036 | 0.563 | type5 | 300.0 | 114.0 | 0.346 |
| 3.40 | 4.20 | 1.105 | 0.626 | 1.036 | 0.701 | type5 | 320.0 | 108.8 | 0.361 |
| 3.80 | 4.20 | 1.400 | 0.716 | 1.343 | 0.807 | type5 | 320.0 | 128.0 | 0.410 |
| 4.20 | 4.20 | 1.632 | 0.810 | 1.554 | 0.879 | type5 | 320.0 | 150.4 | 0.460 |
| 4.60 | 4.20 | 1.718 | 0.950 | 1.662 | 0.916 | type5 | 300.0 | 243.0 | 0.542 |
| 1.80 | 4.60 | 1.753 | 0.800 | 1.772 | 0.787 | type5 | 300.0 | 171.0 | 0.458 |
| 2.20 | 4.60 | 1.717 | 0.963 | 1.662 | 0.991 | type5 | 300.0 | 255.0 | 0.550 |
| 2.60 | 4.60 | 1.476 | 0.191 | 1.448 | 0.174 | type4 | 148.0 | | 0.137 |
| 3.00 | 4.60 | 1.124 | 0.342 | 1.137 | 0.332 | type1' | 116.0 | | 0.264 |
| 3.40 | 4.60 | 1.157 | 0.465 | 1.137 | 0.463 | type1 | 244.0 | | 0.292 |
| 3.80 | 4.60 | 1.424 | 0.561 | 1.448 | 0.563 | type1 | 264.0 | | 0.342 |
| 4.20 | 4.60 | 1.682 | 0.606 | 1.662 | 0.631 | type1" | 100.0 | | 0.442 |
| 4.60 | 4.60 | 1.794 | 0.646 | 1.772 | 0.666 | type1" | 102.7 | | 0.466 |

### NUMERICAL EXAMPLE 2

| Cx | Cy | PM1 | PM2 | PD1 | PD2 | type | W | W' | FF |
|---|---|---|---|---|---|---|---|---|---|
| 1.44 | 1.44 | 1.980 | 0.680 | 1.972 | 0.676 | type1" | 88.5 | | 0.541 |
| 1.76 | 1.44 | 1.907 | 0.898 | 1.860 | 0.902 | type5 | 256.0 | 179.2 | 0.582 |
| 2.08 | 1.44 | 1.622 | 0.182 | 1.644 | 0.113 | type1 | 144.0 | | 0.159 |
| 2.40 | 1.44 | 1.324 | 0.379 | 1.338 | 0.303 | type1' | 104.0 | | 0.332 |
| 2.72 | 1.44 | 1.342 | 0.466 | 1.338 | 0.466 | type4 | 185.6 | | 0.336 |
| 3.04 | 1.44 | 1.647 | 0.612 | 1.644 | 0.598 | type4 | 208.0 | | 0.423 |
| 3.36 | 1.44 | 1.836 | 0.707 | 1.860 | 0.690 | type1 | 249.6 | | 0.478 |
| 3.68 | 1.44 | 1.980 | 0.680 | 1.972 | 0.738 | type1" | 88.5 | | 0.541 |
| 1.44 | 1.76 | 1.855 | 0.637 | 1.860 | 0.645 | type1" | 86.4 | | 0.515 |
| 1.76 | 1.76 | 1.707 | 0.885 | 1.751 | 0.869 | type3 | 262.4 | | 0.472 |
| 2.08 | 1.76 | 1.516 | 0.172 | 1.540 | 0.077 | type1 | 140.8 | | 0.152 |
| 2.40 | 1.76 | 1.216 | 0.351 | 1.240 | 0.264 | type1' | 100.8 | | 0.312 |
| 2.72 | 1.76 | 1.238 | 0.423 | 1.240 | 0.424 | type5 | 192.0 | 121.0 | 0.311 |
| 3.04 | 1.76 | 1.539 | 0.546 | 1.540 | 0.553 | type4 | 198.4 | | 0.384 |
| 3.36 | 1.76 | 1.774 | 0.642 | 1.751 | 0.643 | type1 | 240.0 | | 0.442 |
| 3.68 | 1.76 | 1.836 | 0.707 | 1.860 | 0.690 | type1 | 249.6 | | 0.478 |
| 1.44 | 2.08 | 1.656 | 0.572 | 1.644 | 0.583 | type5 | 224.0 | 125.4 | 0.395 |
| 1.76 | 2.08 | 1.577 | 0.804 | 1.540 | 0.803 | type3 | 272.0 | | 0.433 |
| 2.08 | 2.08 | 1.307 | 0.154 | 1.338 | 0.006 | type1 | 134.4 | | 0.139 |
| 2.40 | 2.08 | 1.054 | 0.138 | 1.049 | 0.187 | type4 | 112.0 | | 0.123 |
| 2.72 | 2.08 | 1.033 | 0.365 | 1.049 | 0.343 | type1" | 69.3 | | 0.332 |
| 3.04 | 2.08 | 1.342 | 0.466 | 1.338 | 0.466 | type4 | 185.6 | | 0.336 |
| 3.36 | 2.08 | 1.539 | 0.546 | 1.540 | 0.553 | type4 | 198.4 | | 0.384 |
| 3.68 | 2.08 | 1.647 | 0.612 | 1.644 | 0.598 | type4 | 208.0 | | 0.423 |
| 1.44 | 2.40 | 1.326 | 0.488 | 1.338 | 0.494 | type5 | 224.0 | 100.8 | 0.342 |
| 1.76 | 2.40 | 1.371 | 0.690 | 1.240 | 0.707 | type3 | 284.8 | | 0.378 |
| 2.08 | 2.40 | 1.048 | 0.844 | 1.049 | 0.902 | type2 | 304.0 | 76.8 | 0.535 |
| 2.40 | 2.40 | 0.757 | 0.110 | 0.775 | 0.077 | type4 | 102.4 | | 0.102 |
| 2.72 | 2.40 | 0.754 | 0.233 | 0.775 | 0.225 | type1' | 84.8 | | 0.221 |
| 3.04 | 2.40 | 1.033 | 0.365 | 1.049 | 0.343 | type1" | 69.3 | | 0.332 |
| 3.36 | 2.40 | 1.238 | 0.423 | 1.240 | 0.424 | type5 | 192.0 | 121.0 | 0.311 |
| 3.68 | 2.40 | 1.342 | 0.466 | 1.338 | 0.466 | type4 | 185.6 | | 0.336 |
| 1.44 | 2.72 | 1.324 | 0.379 | 1.338 | 0.379 | type1' | 104.0 | | 0.332 |
| 1.76 | 2.72 | 1.233 | 0.581 | 1.240 | 0.583 | type5 | 256.0 | 94.7 | 0.386 |
| 2.08 | 2.72 | 0.987 | 0.788 | 1.049 | 0.771 | type2 | 294.4 | 76.8 | 0.513 |
| 2.40 | 2.72 | 0.849 | 0.856 | 0.775 | 0.936 | type1' | 142.4 | | 0.622 |
| 2.72 | 2.72 | 0.757 | 0.110 | 0.775 | 0.077 | type4 | 102.4 | | 0.102 |
| 3.04 | 2.72 | 1.054 | 0.138 | 1.049 | 0.187 | type4 | 112.0 | | 0.123 |
| 3.36 | 2.72 | 1.216 | 0.351 | 1.240 | 0.264 | type1' | 100.8 | | 0.312 |
| 3.68 | 2.72 | 1.324 | 0.379 | 1.338 | 0.303 | type1' | 104.0 | | 0.332 |
| 1.44 | 3.04 | 1.652 | 0.199 | 1.644 | 0.240 | type5 | 160.0 | 65.6 | 0.163 |
| 1.76 | 3.04 | 1.555 | 0.439 | 1.540 | 0.436 | type1' | 110.4 | | 0.374 |
| 2.08 | 3.04 | 1.334 | 0.606 | 1.338 | 0.614 | type5 | 256.0 | 99.8 | 0.402 |
| 2.40 | 3.04 | 0.987 | 0.788 | 1.049 | 0.771 | type2 | 294.4 | 76.8 | 0.513 |
| 2.72 | 3.04 | 1.048 | 0.844 | 1.049 | 0.902 | type2 | 304.0 | 76.8 | 0.535 |
| 3.04 | 3.04 | 1.307 | 0.154 | 1.338 | 0.006 | type1 | 134.4 | | 0.139 |
| 3.36 | 3.04 | 1.516 | 0.172 | 1.540 | 0.077 | type1 | 140.8 | | 0.152 |
| 3.68 | 3.04 | 1.622 | 0.182 | 1.644 | 0.113 | type1 | 144.0 | | 0.159 |
| 1.44 | 3.36 | 1.930 | 0.032 | 1.860 | 0.080 | type3 | 243.2 | | 0.546 |
| 1.76 | 3.36 | 1.749 | 0.207 | 1.751 | 0.267 | type5 | 160.0 | 68.8 | 0.169 |
| 2.08 | 3.36 | 1.555 | 0.439 | 1.540 | 0.436 | type1' | 110.4 | | 0.374 |
| 2.40 | 3.36 | 1.233 | 0.581 | 1.240 | 0.583 | type5 | 256.0 | 94.7 | 0.386 |
| 2.72 | 3.36 | 1.371 | 0.690 | 1.240 | 0.707 | type3 | 284.8 | | 0.378 |
| 3.04 | 3.36 | 1.577 | 0.804 | 1.540 | 0.803 | type3 | 272.0 | | 0.433 |
| 3.36 | 3.36 | 1.707 | 0.885 | 1.751 | 0.869 | type3 | 262.4 | | 0.472 |
| 3.68 | 3.36 | 1.907 | 0.898 | 1.860 | 0.902 | type5 | 256.0 | 179.2 | 0.582 |
| 1.44 | 3.68 | 1.974 | 0.898 | 1.972 | 0.903 | type1 | 275.2 | | 0.581 |
| 1.76 | 3.68 | 1.930 | 0.032 | 1.860 | 0.080 | type3 | 243.2 | | 0.546 |
| 2.08 | 3.68 | 1.652 | 0.199 | 1.644 | 0.240 | type5 | 160.0 | 65.6 | 0.163 |
| 2.40 | 3.68 | 1.324 | 0.379 | 1.338 | 0.379 | type1' | 104.0 | | 0.332 |
| 2.72 | 3.68 | 1.326 | 0.488 | 1.338 | 0.494 | type5 | 224.0 | 100.8 | 0.342 |
| 3.04 | 3.68 | 1.656 | 0.572 | 1.644 | 0.583 | type5 | 224.0 | 125.4 | 0.395 |
| 3.36 | 3.68 | 1.855 | 0.637 | 1.860 | 0.645 | type1" | 86.4 | | 0.515 |
| 3.68 | 3.68 | 1.980 | 0.680 | 1.972 | 0.676 | type1" | 88.5 | | 0.541 |

### NUMERICAL EXAMPLE 3

| Cx | Cy | PM1 | PM2 | PD1 | PD2 | type | W | W' | FF |
|---|---|---|---|---|---|---|---|---|---|
| 2.40 | 2.40 | 1.994 | 0.718 | 0.000 | 0.728 | type1' | 121.6 | | 0.454 |
| 2.72 | 2.40 | 0.005 | 0.002 | 1.977 | 0.984 | type1 | 35.2 | | 0.010 |
| 3.04 | 2.40 | 1.905 | 0.229 | 1.909 | 0.230 | type5 | 256.0 | 174.1 | 0.574 |
| 3.36 | 2.40 | 1.930 | 0.374 | 1.797 | 0.465 | type3 | 243.2 | | 0.546 |
| 3.68 | 2.40 | 1.620 | 0.704 | 1.642 | 0.689 | type1" | 82.1 | | 0.466 |
| 4.00 | 2.40 | 1.471 | 0.893 | 1.445 | 0.898 | type5 | 256.0 | 107.5 | 0.425 |
| 4.32 | 2.40 | 1.206 | 0.197 | 1.209 | 0.094 | type1 | 131.2 | | 0.132 |
| 4.64 | 2.40 | 0.835 | 0.256 | 0.936 | 0.274 | type3 | 16.0 | | 0.998 |
| 4.96 | 2.40 | 0.953 | 0.427 | 0.936 | 0.437 | type1" | 67.2 | | 0.312 |
| 5.28 | 2.40 | 1.203 | 0.593 | 1.209 | 0.581 | type5 | 192.0 | 119.0 | 0.308 |
| 5.60 | 2.40 | 1.448 | 0.719 | 1.445 | 0.706 | type4 | 192.0 | | 0.360 |
| 5.92 | 2.40 | 1.656 | 0.810 | 1.642 | 0.810 | type5 | 224.0 | 125.4 | 0.395 |
| 6.24 | 2.40 | 1.774 | 0.915 | 1.797 | 0.893 | type1 | 240.0 | | 0.442 |
| 6.56 | 2.40 | 1.817 | 0.974 | 1.909 | 0.952 | type1 | 246.4 | | 0.466 |
| 6.88 | 2.40 | 0.005 | 0.002 | 1.977 | 0.988 | type1 | 35.2 | | 0.010 |
| 7.20 | 2.40 | 0.005 | 0.002 | 0.000 | 0.000 | type1 | 35.2 | | 0.010 |
| 2.72 | 2.72 | 0.005 | 0.002 | 1.955 | 0.975 | type1 | 35.2 | | 0.010 |
| 3.04 | 2.72 | 1.904 | 0.220 | 1.887 | 0.221 | type5 | 256.0 | 171.5 | 0.570 |
| 3.36 | 2.72 | 1.930 | 0.374 | 1.775 | 0.456 | type3 | 243.2 | | 0.546 |
| 3.68 | 2.72 | 1.620 | 0.704 | 1.620 | 0.679 | type1" | 82.1 | | 0.466 |
| 4.00 | 2.72 | 1.427 | 0.876 | 1.423 | 0.888 | type5 | 256.0 | 105.0 | 0.417 |
| 4.32 | 2.72 | 1.048 | 0.098 | 1.188 | 0.084 | type2 | 304.0 | 76.8 | 0.535 |
| 4.64 | 2.72 | 0.835 | 0.256 | 0.915 | 0.263 | type3 | 16.0 | | 0.998 |
| 4.96 | 2.72 | 0.914 | 0.411 | 0.915 | 0.426 | type1" | 66.1 | | 0.302 |
| 5.28 | 2.72 | 1.166 | 0.587 | 1.188 | 0.570 | type5 | 192.0 | 117.1 | 0.305 |
| 5.60 | 2.72 | 1.412 | 0.710 | 1.423 | 0.695 | type5 | 224.0 | 105.3 | 0.352 |
| 5.92 | 2.72 | 1.621 | 0.789 | 1.620 | 0.799 | type5 | 224.0 | 121.0 | 0.386 |
| 6.24 | 2.72 | 1.750 | 0.886 | 1.775 | 0.881 | type1 | 236.8 | | 0.430 |
| 6.56 | 2.72 | 1.817 | 0.974 | 1.887 | 0.940 | type1 | 246.4 | | 0.466 |
| 6.88 | 2.72 | 0.005 | 0.002 | 1.955 | 0.976 | type1 | 35.2 | | 0.010 |
| 7.20 | 2.72 | 0.005 | 0.002 | 1.977 | 0.988 | type1 | 35.2 | | 0.010 |
| 7.52 | 2.72 | 0.005 | 0.002 | 1.955 | 0.976 | type1 | 35.2 | | 0.010 |
| 3.04 | 3.04 | 1.866 | 0.161 | 1.819 | 0.193 | type4 | 236.8 | | 0.548 |
| 3.36 | 3.04 | 1.749 | 0.282 | 1.708 | 0.427 | type5 | 160.0 | 68.8 | 0.169 |
| 3.68 | 3.04 | 1.564 | 0.680 | 1.554 | 0.649 | type1" | 81.1 | | 0.454 |
| 4.00 | 3.04 | 1.382 | 0.858 | 1.359 | 0.858 | type5 | 256.0 | 102.4 | 0.410 |
| 4.32 | 3.04 | 1.048 | 0.098 | 1.124 | 0.052 | type2 | 304.0 | 76.8 | 0.535 |
| 4.64 | 3.04 | 0.831 | 0.253 | 0.853 | 0.231 | type3 | 19.2 | | 0.997 |
| 4.96 | 3.04 | 0.841 | 0.380 | 0.853 | 0.393 | type1" | 64.0 | | 0.283 |
| 5.28 | 3.04 | 1.153 | 0.544 | 1.124 | 0.536 | type1 | 195.2 | | 0.292 |
| 5.60 | 3.04 | 1.342 | 0.661 | 1.359 | 0.660 | type4 | 185.6 | | 0.336 |
| 5.92 | 3.04 | 1.549 | 0.757 | 1.554 | 0.764 | type5 | 224.0 | 114.2 | 0.372 |
| 6.24 | 3.04 | 1.699 | 0.848 | 1.708 | 0.845 | type5 | 224.0 | 134.4 | 0.412 |
| 6.56 | 3.04 | 1.774 | 0.915 | 1.819 | 0.904 | type1 | 240.0 | | 0.442 |
| 6.88 | 3.04 | 1.817 | 0.974 | 1.887 | 0.940 | type1 | 246.4 | | 0.466 |
| 7.20 | 3.04 | 1.817 | 0.974 | 1.909 | 0.952 | type1 | 246.4 | | 0.466 |
| 7.52 | 3.04 | 1.817 | 0.974 | 1.887 | 0.940 | type1 | 246.4 | | 0.466 |
| 7.84 | 3.04 | 1.774 | 0.915 | 1.819 | 0.904 | type1 | 240.0 | | 0.442 |
| 3.36 | 3.36 | 1.652 | 0.271 | 1.598 | 0.380 | type5 | 160.0 | 65.6 | 0.163 |
| 3.68 | 3.36 | 1.405 | 0.614 | 1.445 | 0.600 | type1" | 77.9 | | 0.419 |
| 4.00 | 3.36 | 1.233 | 0.804 | 1.252 | 0.808 | type5 | 256.0 | 94.7 | 0.386 |
| 4.32 | 3.36 | 0.971 | 0.009 | 1.019 | 0.001 | type2 | 291.2 | 76.8 | 0.505 |
| 4.64 | 3.36 | 0.757 | 0.177 | 0.750 | 0.178 | type3 | 64.0 | | 0.969 |
| 4.96 | 3.36 | 0.739 | 0.337 | 0.750 | 0.338 | type1" | 60.8 | | 0.255 |
| 5.28 | 3.36 | 1.003 | 0.499 | 1.019 | 0.481 | type1 | 188.8 | | 0.273 |
| 5.60 | 3.36 | 1.238 | 0.600 | 1.252 | 0.604 | type5 | 192.0 | 121.0 | 0.311 |
| 5.92 | 3.36 | 1.448 | 0.719 | 1.445 | 0.706 | type4 | 192.0 | | 0.360 |
| 6.24 | 3.36 | 1.599 | 0.778 | 1.598 | 0.787 | type5 | 224.0 | 118.7 | 0.382 |
| 6.56 | 3.36 | 1.699 | 0.848 | 1.708 | 0.845 | type5 | 224.0 | 134.4 | 0.412 |
| 6.88 | 3.36 | 1.750 | 0.886 | 1.775 | 0.881 | type1 | 236.8 | | 0.430 |
| 7.20 | 3.36 | 1.774 | 0.915 | 1.797 | 0.893 | type1 | 240.0 | | 0.442 |
| 7.52 | 3.36 | 1.750 | 0.886 | 1.775 | 0.881 | type1 | 236.8 | | 0.430 |
| 7.84 | 3.36 | 1.699 | 0.848 | 1.708 | 0.845 | type5 | 224.0 | 134.4 | 0.412 |
| 8.16 | 3.36 | 1.599 | 0.778 | 1.598 | 0.787 | type5 | 224.0 | 118.7 | 0.382 |

| Cx | Cy | PM1 | PM2 | PD1 | PD2 | type | W | W' | FF |
|---|---|---|---|---|---|---|---|---|---|
| 3.68 | 3.68 | 1.256 | 0.553 | 1.294 | 0.533 | type1" | 74.7 | | 0.385 |
| 4.00 | 3.68 | 1.067 | 0.747 | 1.103 | 0.738 | type5 | 256.0 | 87.0 | 0.361 |
| 4.32 | 3.68 | 0.889 | 0.919 | 0.874 | 0.929 | type2 | 275.2 | 76.8 | 0.467 |
| 4.64 | 3.68 | 0.589 | 0.123 | 0.608 | 0.104 | type1 | 108.8 | | 0.091 |
| 4.96 | 3.68 | 0.609 | 0.248 | 0.608 | 0.263 | type1' | 78.4 | | 0.189 |
| 5.28 | 3.68 | 0.877 | 0.395 | 0.874 | 0.404 | type1" | 65.1 | | 0.292 |
| 5.60 | 3.68 | 1.080 | 0.521 | 1.103 | 0.525 | type1 | 192.0 | | 0.283 |
| 5.92 | 3.68 | 1.281 | 0.633 | 1.294 | 0.626 | type4 | 182.4 | | 0.325 |
| 6.24 | 3.68 | 1.448 | 0.719 | 1.445 | 0.706 | type4 | 192.0 | | 0.360 |
| 6.56 | 3.68 | 1.549 | 0.757 | 1.554 | 0.764 | type5 | 224.0 | 114.2 | 0.372 |
| 6.88 | 3.68 | 1.621 | 0.789 | 1.620 | 0.799 | type5 | 224.0 | 121.0 | 0.386 |
| 7.20 | 3.68 | 1.656 | 0.810 | 1.642 | 0.810 | type5 | 224.0 | 125.4 | 0.395 |
| 7.52 | 3.68 | 1.621 | 0.789 | 1.620 | 0.799 | type5 | 224.0 | 121.0 | 0.386 |
| 7.84 | 3.68 | 1.549 | 0.757 | 1.554 | 0.764 | type5 | 224.0 | 114.2 | 0.372 |
| 8.16 | 3.68 | 1.448 | 0.719 | 1.445 | 0.706 | type4 | 192.0 | | 0.360 |
| 8.48 | 3.68 | 1.281 | 0.633 | 1.294 | 0.626 | type4 | 182.4 | | 0.325 |
| 4.00 | 4.00 | 0.881 | 0.689 | 0.915 | 0.649 | type5 | 256.0 | 79.4 | 0.335 |
| 4.32 | 4.00 | 0.679 | 0.849 | 0.689 | 0.838 | type2 | 272.0 | 70.4 | 0.435 |
| 4.64 | 4.00 | 0.451 | 0.926 | 0.427 | 0.011 | type4 | 304.0 | | 0.903 |
| 4.96 | 4.00 | 0.428 | 0.184 | 0.427 | 0.167 | type1' | 68.8 | | 0.145 |
| 5.28 | 4.00 | 0.676 | 0.310 | 0.689 | 0.306 | type1" | 58.7 | | 0.238 |
| 5.60 | 4.00 | 0.914 | 0.411 | 0.915 | 0.426 | type1" | 66.1 | | 0.302 |
| 5.92 | 4.00 | 1.080 | 0.521 | 1.103 | 0.525 | type1 | 192.0 | | 0.283 |
| 6.24 | 4.00 | 1.238 | 0.600 | 1.252 | 0.604 | type5 | 192.0 | 121.0 | 0.311 |
| 6.56 | 4.00 | 1.342 | 0.661 | 1.359 | 0.660 | type4 | 185.6 | | 0.336 |
| 6.88 | 4.00 | 1.412 | 0.710 | 1.423 | 0.695 | type5 | 224.0 | 105.3 | 0.352 |
| 7.20 | 4.00 | 1.448 | 0.719 | 1.445 | 0.706 | type4 | 192.0 | | 0.360 |
| 7.52 | 4.00 | 1.412 | 0.710 | 1.423 | 0.695 | type5 | 224.0 | 105.3 | 0.352 |
| 7.84 | 4.00 | 1.342 | 0.661 | 1.359 | 0.660 | type4 | 185.6 | | 0.336 |
| 8.16 | 4.00 | 1.238 | 0.600 | 1.252 | 0.604 | type5 | 192.0 | 121.0 | 0.311 |
| 8.48 | 4.00 | 1.080 | 0.521 | 1.103 | 0.525 | type1 | 192.0 | | 0.283 |
| 8.80 | 4.00 | 0.914 | 0.411 | 0.915 | 0.426 | type1" | 66.1 | | 0.302 |
| 4.32 | 4.32 | 0.425 | 0.750 | 0.467 | 0.728 | type2 | 262.4 | 64.0 | 0.390 |
| 4.64 | 4.32 | 0.254 | 0.820 | 0.210 | 0.898 | type1' | 128.0 | | 0.503 |
| 4.96 | 4.32 | 0.199 | 0.069 | 0.210 | 0.052 | type1 | 86.4 | | 0.057 |
| 5.28 | 4.32 | 0.455 | 0.194 | 0.467 | 0.189 | type1' | 70.4 | | 0.152 |
| 5.60 | 4.32 | 0.676 | 0.310 | 0.689 | 0.306 | type1" | 58.7 | | 0.238 |
| 5.92 | 4.32 | 0.877 | 0.395 | 0.874 | 0.404 | type1" | 65.1 | | 0.292 |
| 6.24 | 4.32 | 1.003 | 0.499 | 1.019 | 0.481 | type1 | 188.8 | | 0.273 |
| 6.56 | 4.32 | 1.153 | 0.544 | 1.124 | 0.536 | type1 | 195.2 | | 0.292 |
| 6.88 | 4.32 | 1.166 | 0.587 | 1.188 | 0.570 | type5 | 192.0 | 117.1 | 0.305 |
| 7.20 | 4.32 | 1.203 | 0.593 | 1.209 | 0.581 | type5 | 192.0 | 119.0 | 0.308 |
| 7.52 | 4.32 | 1.166 | 0.587 | 1.188 | 0.570 | type5 | 192.0 | 117.1 | 0.305 |
| 7.84 | 4.32 | 1.153 | 0.544 | 1.124 | 0.536 | type1 | 195.2 | | 0.292 |
| 8.16 | 4.32 | 1.003 | 0.499 | 1.019 | 0.481 | type1 | 188.8 | | 0.273 |
| 8.48 | 4.32 | 0.877 | 0.395 | 0.874 | 0.404 | type1" | 65.1 | | 0.292 |
| 8.80 | 4.32 | 0.676 | 0.310 | 0.689 | 0.306 | type1" | 58.7 | | 0.238 |
| 9.12 | 4.32 | 0.455 | 0.194 | 0.467 | 0.189 | type1' | 70.4 | | 0.152 |
| 4.64 | 4.64 | 1.994 | 0.718 | 1.958 | 0.768 | type1' | 121.6 | | 0.454 |
| 4.96 | 4.64 | 1.980 | 0.859 | 1.958 | 0.919 | type1" | 88.5 | | 0.541 |
| 5.28 | 4.64 | 0.199 | 0.069 | 0.210 | 0.052 | type1 | 86.4 | | 0.057 |
| 5.60 | 4.64 | 0.428 | 0.184 | 0.427 | 0.167 | type1' | 68.8 | | 0.145 |
| 5.92 | 4.64 | 0.609 | 0.248 | 0.608 | 0.263 | type1' | 78.4 | | 0.189 |
| 6.24 | 4.64 | 0.739 | 0.337 | 0.750 | 0.338 | type1" | 60.8 | | 0.255 |
| 6.56 | 4.64 | 0.841 | 0.380 | 0.853 | 0.393 | type1" | 64.0 | | 0.283 |
| 6.88 | 4.64 | 0.914 | 0.411 | 0.915 | 0.426 | type1" | 66.1 | | 0.302 |
| 7.20 | 4.64 | 0.953 | 0.427 | 0.936 | 0.437 | type1" | 67.2 | | 0.312 |
| 7.52 | 4.64 | 0.914 | 0.411 | 0.915 | 0.426 | type1" | 66.1 | | 0.302 |
| 7.84 | 4.64 | 0.841 | 0.380 | 0.853 | 0.393 | type1" | 64.0 | | 0.283 |
| 8.16 | 4.64 | 0.739 | 0.337 | 0.750 | 0.338 | type1" | 60.8 | | 0.255 |
| 8.48 | 4.64 | 0.609 | 0.248 | 0.608 | 0.263 | type1' | 78.4 | | 0.189 |
| 8.80 | 4.64 | 0.428 | 0.184 | 0.427 | 0.167 | type1' | 68.8 | | 0.145 |
| 9.12 | 4.64 | 0.199 | 0.069 | 0.210 | 0.052 | type1 | 86.4 | | 0.057 |
| 9.44 | 4.64 | 1.980 | 0.859 | 1.958 | 0.919 | type1" | 88.5 | | 0.541 |

| Cx | Cy | PM1 | PM2 | PD1 | PD2 | type | W | W' | FF |
|---|---|---|---|---|---|---|---|---|---|
| 4.96 | 4.96 | 1.994 | 0.718 | 1.958 | 0.768 | type1' | 121.6 | | 0.454 |
| 5.28 | 4.96 | 0.254 | 0.820 | 0.210 | 0.898 | type1' | 128.0 | | 0.503 |
| 5.60 | 4.96 | 0.451 | 0.926 | 0.427 | 0.011 | type4 | 304.0 | | 0.903 |
| 5.92 | 4.96 | 0.589 | 0.123 | 0.608 | 0.104 | type1 | 108.8 | | 0.091 |
| 6.24 | 4.96 | 0.757 | 0.177 | 0.750 | 0.178 | type3 | 64.0 | | 0.969 |
| 6.56 | 4.96 | 0.831 | 0.253 | 0.853 | 0.231 | type3 | 19.2 | | 0.997 |
| 6.88 | 4.96 | 0.835 | 0.256 | 0.915 | 0.263 | type3 | 16.0 | | 0.998 |
| 7.20 | 4.96 | 0.835 | 0.256 | 0.936 | 0.274 | type3 | 16.0 | | 0.998 |
| 7.52 | 4.96 | 0.835 | 0.256 | 0.915 | 0.263 | type3 | 16.0 | | 0.998 |
| 7.84 | 4.96 | 0.831 | 0.253 | 0.853 | 0.231 | type3 | 19.2 | | 0.997 |
| 8.16 | 4.96 | 0.757 | 0.177 | 0.750 | 0.178 | type3 | 64.0 | | 0.969 |
| 8.48 | 4.96 | 0.589 | 0.123 | 0.608 | 0.104 | type1 | 108.8 | | 0.091 |
| 8.80 | 4.96 | 0.451 | 0.926 | 0.427 | 0.011 | type4 | 304.0 | | 0.903 |
| 9.12 | 4.96 | 0.254 | 0.820 | 0.210 | 0.898 | type1' | 128.0 | | 0.503 |
| 9.44 | 4.96 | 1.994 | 0.718 | 1.958 | 0.768 | type1' | 121.6 | | 0.454 |
| 9.76 | 4.96 | 0.239 | 0.431 | 0.210 | 0.456 | type2 | 188.8 | 64.0 | 0.245 |
| 5.28 | 5.28 | 0.425 | 0.750 | 0.467 | 0.728 | type2 | 262.4 | 64.0 | 0.390 |
| 5.60 | 5.28 | 0.679 | 0.849 | 0.689 | 0.838 | type2 | 272.0 | 70.4 | 0.435 |
| 5.92 | 5.28 | 0.889 | 0.919 | 0.874 | 0.929 | type2 | 275.2 | 76.8 | 0.467 |
| 6.24 | 5.28 | 0.971 | 0.009 | 1.019 | 0.001 | type2 | 291.2 | 76.8 | 0.505 |
| 6.56 | 5.28 | 1.048 | 0.098 | 1.124 | 0.052 | type2 | 304.0 | 76.8 | 0.535 |
| 6.88 | 5.28 | 1.048 | 0.098 | 1.188 | 0.084 | type2 | 304.0 | 76.8 | 0.535 |
| 7.20 | 5.28 | 1.206 | 0.197 | 1.209 | 0.094 | type1 | 131.2 | | 0.132 |
| 7.52 | 5.28 | 1.048 | 0.098 | 1.188 | 0.084 | type2 | 304.0 | 76.8 | 0.535 |
| 7.84 | 5.28 | 1.048 | 0.098 | 1.124 | 0.052 | type2 | 304.0 | 76.8 | 0.535 |
| 8.16 | 5.28 | 0.971 | 0.009 | 1.019 | 0.001 | type2 | 291.2 | 76.8 | 0.505 |
| 8.48 | 5.28 | 0.889 | 0.919 | 0.874 | 0.929 | type2 | 275.2 | 76.8 | 0.467 |
| 8.80 | 5.28 | 0.679 | 0.849 | 0.689 | 0.838 | type2 | 272.0 | 70.4 | 0.435 |
| 9.12 | 5.28 | 0.425 | 0.750 | 0.467 | 0.728 | type2 | 262.4 | 64.0 | 0.390 |
| 9.44 | 5.28 | 0.188 | 0.597 | 0.210 | 0.600 | type3 | 214.4 | | 0.647 |
| 9.76 | 5.28 | 0.482 | 0.227 | 0.427 | 0.277 | type1" | 51.2 | | 0.181 |
| 10.08 | 5.28 | 0.702 | 0.116 | 0.689 | 0.120 | type3 | 89.6 | | 0.938 |
| 5.60 | 5.60 | 0.881 | 0.689 | 0.915 | 0.649 | type5 | 256.0 | 79.4 | 0.335 |
| 5.92 | 5.60 | 1.067 | 0.747 | 1.103 | 0.738 | type5 | 256.0 | 87.0 | 0.361 |
| 6.24 | 5.60 | 1.233 | 0.804 | 1.252 | 0.808 | type5 | 256.0 | 94.7 | 0.386 |
| 6.56 | 5.60 | 1.382 | 0.858 | 1.359 | 0.858 | type5 | 256.0 | 102.4 | 0.410 |
| 6.88 | 5.60 | 1.427 | 0.876 | 1.423 | 0.888 | type5 | 256.0 | 105.0 | 0.417 |
| 7.20 | 5.60 | 1.471 | 0.893 | 1.445 | 0.898 | type5 | 256.0 | 107.5 | 0.425 |
| 7.52 | 5.60 | 1.427 | 0.876 | 1.423 | 0.888 | type5 | 256.0 | 105.0 | 0.417 |
| 7.84 | 5.60 | 1.382 | 0.858 | 1.359 | 0.858 | type5 | 256.0 | 102.4 | 0.410 |
| 8.16 | 5.60 | 1.233 | 0.804 | 1.252 | 0.808 | type5 | 256.0 | 94.7 | 0.386 |
| 8.48 | 5.60 | 1.067 | 0.747 | 1.103 | 0.738 | type5 | 256.0 | 87.0 | 0.361 |
| 8.80 | 5.60 | 0.881 | 0.689 | 0.915 | 0.649 | type5 | 256.0 | 79.4 | 0.335 |
| 9.12 | 5.60 | 0.672 | 0.541 | 0.689 | 0.542 | type2 | 201.6 | 76.8 | 0.294 |
| 9.44 | 5.60 | 0.425 | 0.430 | 0.427 | 0.418 | type5 | 192.0 | 78.7 | 0.235 |
| 9.76 | 5.60 | 0.638 | 0.059 | 0.608 | 0.083 | type3 | 112.0 | | 0.904 |
| 10.08 | 5.60 | 0.889 | 0.919 | 0.874 | 0.931 | type2 | 275.2 | 76.8 | 0.467 |
| 10.40 | 5.60 | 1.124 | 0.766 | 1.103 | 0.763 | type5 | 256.0 | 89.6 | 0.370 |
| 5.92 | 5.92 | 1.256 | 0.553 | 1.294 | 0.533 | type1" | 74.7 | | 0.385 |
| 6.24 | 5.92 | 1.405 | 0.614 | 1.445 | 0.600 | type1" | 77.9 | | 0.419 |
| 6.56 | 5.92 | 1.564 | 0.680 | 1.554 | 0.649 | type1" | 81.1 | | 0.454 |
| 6.88 | 5.92 | 1.620 | 0.704 | 1.620 | 0.679 | type1" | 82.1 | | 0.466 |
| 7.20 | 5.92 | 1.620 | 0.704 | 1.642 | 0.689 | type1" | 82.1 | | 0.466 |
| 7.52 | 5.92 | 1.620 | 0.704 | 1.620 | 0.679 | type1" | 82.1 | | 0.466 |
| 7.84 | 5.92 | 1.564 | 0.680 | 1.554 | 0.649 | type1" | 81.1 | | 0.454 |
| 8.16 | 5.92 | 1.405 | 0.614 | 1.445 | 0.600 | type1" | 77.9 | | 0.419 |
| 8.48 | 5.92 | 1.256 | 0.553 | 1.294 | 0.533 | type1" | 74.7 | | 0.385 |
| 8.80 | 5.92 | 1.112 | 0.416 | 1.103 | 0.446 | type1' | 97.6 | | 0.292 |
| 9.12 | 5.92 | 0.878 | 0.339 | 0.874 | 0.342 | type1' | 89.6 | | 0.246 |
| 9.44 | 5.92 | 0.609 | 0.248 | 0.608 | 0.221 | type1' | 78.4 | | 0.189 |
| 9.76 | 5.92 | 0.723 | 0.881 | 0.750 | 0.877 | type2 | 278.4 | 70.4 | 0.449 |
| 10.08 | 5.92 | 1.007 | 0.728 | 1.019 | 0.728 | type5 | 256.0 | 84.5 | 0.353 |
| 10.40 | 5.92 | 1.256 | 0.553 | 1.252 | 0.565 | type1" | 74.7 | | 0.385 |
| 10.72 | 5.92 | 1.380 | 0.504 | 1.445 | 0.388 | type1' | 105.6 | | 0.342 |

| Cx | Cy | PM1 | PM2 | PD1 | PD2 | type | W | W' | FF |
|---|---|---|---|---|---|---|---|---|---|
| 6.24 | 6.24 | 1.652 | 0.271 | 1.598 | 0.380 | type5 | 160.0 | 65.6 | 0.163 |
| 6.56 | 6.24 | 1.749 | 0.282 | 1.708 | 0.427 | type5 | 160.0 | 68.8 | 0.169 |
| 6.88 | 6.24 | 1.930 | 0.374 | 1.775 | 0.456 | type3 | 243.2 | | 0.546 |
| 7.20 | 6.24 | 1.930 | 0.374 | 1.797 | 0.465 | type3 | 243.2 | | 0.546 |
| 7.52 | 6.24 | 1.930 | 0.374 | 1.775 | 0.456 | type3 | 243.2 | | 0.546 |
| 7.84 | 6.24 | 1.749 | 0.282 | 1.708 | 0.427 | type5 | 160.0 | 68.8 | 0.169 |
| 8.16 | 6.24 | 1.652 | 0.271 | 1.598 | 0.380 | type5 | 160.0 | 65.6 | 0.163 |
| 8.48 | 6.24 | 1.500 | 0.244 | 1.445 | 0.314 | type4 | 124.8 | | 0.152 |
| 8.80 | 6.24 | 1.272 | 0.213 | 1.252 | 0.230 | type4 | 118.4 | | 0.137 |
| 9.12 | 6.24 | 1.048 | 0.098 | 1.019 | 0.129 | type2 | 304.0 | 76.8 | 0.535 |
| 9.44 | 6.24 | 0.715 | 0.029 | 0.750 | 0.011 | type1' | 139.2 | | 0.594 |
| 9.76 | 6.24 | 0.815 | 0.669 | 0.853 | 0.659 | type5 | 256.0 | 76.8 | 0.326 |
| 10.08 | 6.24 | 1.119 | 0.496 | 1.124 | 0.514 | type1" | 71.5 | | 0.353 |
| 10.40 | 6.24 | 1.385 | 0.228 | 1.359 | 0.354 | type4 | 121.6 | | 0.144 |
| 10.72 | 6.24 | 1.516 | 0.236 | 1.554 | 0.182 | type1 | 140.8 | | 0.152 |
| 11.04 | 6.24 | 1.715 | 0.006 | 1.708 | 0.996 | type5 | 256.0 | 125.4 | 0.474 |
| 6.56 | 6.56 | 1.866 | 0.161 | 1.819 | 0.193 | type4 | 236.8 | | 0.548 |
| 6.88 | 6.56 | 1.904 | 0.220 | 1.887 | 0.221 | type5 | 256.0 | 171.5 | 0.570 |
| 7.20 | 6.56 | 1.905 | 0.229 | 1.909 | 0.230 | type5 | 256.0 | 174.1 | 0.574 |
| 7.52 | 6.56 | 1.904 | 0.220 | 1.887 | 0.221 | type5 | 256.0 | 171.5 | 0.570 |
| 7.84 | 6.56 | 1.866 | 0.161 | 1.819 | 0.193 | type4 | 236.8 | | 0.548 |
| 8.16 | 6.56 | 1.665 | 0.162 | 1.708 | 0.147 | type3 | 265.6 | | 0.459 |
| 8.48 | 6.56 | 1.577 | 0.093 | 1.554 | 0.083 | type3 | 272.0 | | 0.433 |
| 8.80 | 6.56 | 1.427 | 0.981 | 1.359 | 0.002 | type3 | 281.6 | | 0.392 |
| 9.12 | 6.56 | 1.180 | 0.785 | 1.124 | 0.904 | type5 | 256.0 | 92.2 | 0.378 |
| 9.44 | 6.56 | 0.787 | 0.823 | 0.853 | 0.789 | type2 | 256.0 | 76.8 | 0.422 |
| 9.76 | 6.56 | 0.914 | 0.411 | 0.915 | 0.429 | type1" | 66.1 | | 0.302 |
| 10.08 | 6.56 | 1.161 | 0.199 | 1.188 | 0.288 | type4 | 115.2 | | 0.130 |
| 10.40 | 6.56 | 1.410 | 0.223 | 1.423 | 0.133 | type1 | 137.6 | | 0.145 |
| 10.72 | 6.56 | 1.623 | 0.959 | 1.620 | 0.964 | type5 | 256.0 | 117.8 | 0.453 |
| 11.04 | 6.56 | 1.794 | 0.778 | 1.775 | 0.783 | type1" | 85.3 | | 0.503 |
| 11.36 | 6.56 | 1.865 | 0.671 | 1.887 | 0.591 | type1' | 118.4 | | 0.430 |
| 6.88 | 6.88 | 0.005 | 0.002 | 1.955 | 0.975 | type1 | 35.2 | | 0.010 |
| 7.20 | 6.88 | 0.005 | 0.002 | 1.977 | 0.984 | type1 | 35.2 | | 0.010 |
| 7.52 | 6.88 | 0.005 | 0.002 | 1.955 | 0.975 | type1 | 35.2 | | 0.010 |
| 7.84 | 6.88 | 1.817 | 0.974 | 1.887 | 0.948 | type1 | 246.4 | | 0.466 |
| 8.16 | 6.88 | 1.774 | 0.915 | 1.775 | 0.904 | type1 | 240.0 | | 0.442 |
| 8.48 | 6.88 | 1.614 | 0.839 | 1.620 | 0.842 | type4 | 204.8 | | 0.410 |
| 8.80 | 6.88 | 1.451 | 0.722 | 1.423 | 0.763 | type5 | 224.0 | 107.5 | 0.358 |
| 9.12 | 6.88 | 1.176 | 0.648 | 1.188 | 0.668 | type5 | 224.0 | 94.1 | 0.325 |
| 9.44 | 6.88 | 0.937 | 0.545 | 0.915 | 0.556 | type5 | 192.0 | 105.6 | 0.287 |
| 9.76 | 6.88 | 0.951 | 0.173 | 0.936 | 0.190 | type4 | 108.8 | | 0.116 |
| 10.08 | 6.88 | 1.048 | 0.098 | 1.209 | 0.052 | type2 | 304.0 | 76.8 | 0.535 |
| 10.40 | 6.88 | 1.471 | 0.893 | 1.445 | 0.901 | type5 | 256.0 | 107.5 | 0.425 |
| 10.72 | 6.88 | 1.677 | 0.728 | 1.642 | 0.737 | type1" | 83.2 | | 0.478 |
| 11.04 | 6.88 | 1.739 | 0.626 | 1.797 | 0.560 | type1' | 115.2 | | 0.407 |
| 11.36 | 6.88 | 1.930 | 0.374 | 1.909 | 0.372 | type3 | 243.2 | | 0.546 |
| 11.68 | 6.88 | 1.939 | 0.183 | 1.977 | 0.173 | type1 | 268.8 | | 0.554 |
| 7.20 | 7.20 | 1.994 | 0.718 | 0.000 | 0.728 | type1' | 121.6 | | 0.454 |
| 7.52 | 7.20 | 1.994 | 0.718 | 1.977 | 0.719 | type1' | 121.6 | | 0.454 |
| 7.84 | 7.20 | 1.929 | 0.694 | 1.909 | 0.693 | type1' | 120.0 | | 0.442 |
| 8.16 | 7.20 | 1.802 | 0.648 | 1.797 | 0.650 | type1' | 116.8 | | 0.419 |
| 8.48 | 7.20 | 1.616 | 0.583 | 1.642 | 0.590 | type1' | 112.0 | | 0.385 |
| 8.80 | 7.20 | 1.438 | 0.523 | 1.445 | 0.514 | type1' | 107.2 | | 0.353 |
| 9.12 | 7.20 | 1.216 | 0.450 | 1.209 | 0.421 | type1' | 100.8 | | 0.312 |
| 9.44 | 7.20 | 0.922 | 0.353 | 0.936 | 0.313 | type1' | 91.2 | | 0.255 |
| 9.76 | 7.20 | 0.914 | 0.411 | 0.915 | 0.429 | type1" | 66.1 | | 0.302 |
| 10.08 | 7.20 | 1.161 | 0.199 | 1.188 | 0.288 | type4 | 115.2 | | 0.130 |
| 10.40 | 7.20 | 1.410 | 0.223 | 1.423 | 0.133 | type1 | 137.6 | | 0.145 |
| 10.72 | 7.20 | 1.623 | 0.959 | 1.620 | 0.964 | type5 | 256.0 | 117.8 | 0.453 |
| 11.04 | 7.20 | 1.794 | 0.778 | 1.775 | 0.783 | type1" | 85.3 | | 0.503 |
| 11.36 | 7.20 | 1.865 | 0.671 | 1.887 | 0.591 | type1' | 118.4 | | 0.430 |
| 11.68 | 7.20 | 1.963 | 0.401 | 1.955 | 0.387 | type3 | 240.0 | | 0.558 |
| 12.00 | 7.20 | 1.939 | 0.183 | 1.977 | 0.173 | type 1 | 268.8 | | 0.554 |

### NUMERICAL EXAMPLE 4

| Cx | Cy | PM1 | PM2 | PD1 | PD2 | type | W | W' | FF |
|---|---|---|---|---|---|---|---|---|---|
| 3.00 | 3.00 | 0.029 | 0.857 | 0.000 | 0.895 | type1' | 162.0 | | 0.515 |
| 3.40 | 3.00 | 0.074 | 0.044 | 1.980 | 0.142 | type1' | 46.0 | | 0.042 |
| 3.80 | 3.00 | 1.905 | 0.398 | 1.920 | 0.377 | type5 | 200.0 | 134.0 | 0.223 |
| 4.20 | 3.00 | 1.814 | 0.597 | 1.821 | 0.601 | type2 | 288.0 | 80.0 | 0.327 |
| 4.60 | 3.00 | 1.684 | 0.795 | 1.683 | 0.810 | type1" | 106.7 | | 0.503 |
| 5.00 | 3.00 | 1.259 | 0.163 | 1.508 | 0.006 | type1 | 340.0 | | 0.567 |
| 5.40 | 3.00 | 1.290 | 0.191 | 1.296 | 0.187 | type1 | 344.0 | | 0.581 |
| 5.80 | 3.00 | 0.988 | 0.415 | 1.048 | 0.351 | type1' | 120.0 | | 0.283 |
| 6.20 | 3.00 | 1.046 | 0.495 | 1.048 | 0.499 | type1" | 88.0 | | 0.342 |
| 6.60 | 3.00 | 1.296 | 0.611 | 1.296 | 0.629 | type1" | 96.0 | | 0.407 |
| 7.00 | 3.00 | 1.531 | 0.721 | 1.508 | 0.741 | type1" | 102.7 | | 0.466 |
| 7.40 | 3.00 | 1.684 | 0.795 | 1.683 | 0.833 | type1" | 106.7 | | 0.503 |
| 7.80 | 3.00 | 1.846 | 0.873 | 1.821 | 0.906 | type1" | 110.7 | | 0.541 |
| 8.20 | 3.00 | 1.903 | 0.901 | 1.920 | 0.958 | type1" | 112.0 | | 0.554 |
| 8.60 | 3.00 | 0.000 | 0.000 | 1.980 | 0.989 | type1 | 40.0 | | 0.008 |
| 9.00 | 3.00 | 0.000 | 0.000 | 0.000 | 0.000 | type1 | 40.0 | | 0.008 |
| 3.40 | 3.40 | 0.055 | 0.035 | 1.960 | 0.133 | type1' | 42.0 | | 0.035 |
| 3.80 | 3.40 | 1.890 | 0.394 | 1.900 | 0.369 | type5 | 200.0 | 132.0 | 0.221 |
| 4.20 | 3.40 | 1.808 | 0.584 | 1.801 | 0.591 | type2 | 284.0 | 80.0 | 0.320 |
| 4.60 | 3.40 | 1.684 | 0.795 | 1.664 | 0.801 | type1" | 106.7 | | 0.503 |
| 5.00 | 3.40 | 1.228 | 0.134 | 1.488 | 0.997 | type1 | 336.0 | | 0.554 |
| 5.40 | 3.40 | 1.263 | 0.182 | 1.276 | 0.177 | type5 | 320.0 | 220.8 | 0.578 |
| 5.80 | 3.40 | 0.988 | 0.415 | 1.029 | 0.342 | type1' | 120.0 | | 0.283 |
| 6.20 | 3.40 | 1.046 | 0.495 | 1.029 | 0.489 | type1" | 88.0 | | 0.342 |
| 6.60 | 3.40 | 1.296 | 0.611 | 1.276 | 0.619 | type1" | 96.0 | | 0.407 |
| 7.00 | 3.40 | 1.531 | 0.721 | 1.488 | 0.731 | type1" | 102.7 | | 0.466 |
| 7.40 | 3.40 | 1.684 | 0.795 | 1.664 | 0.823 | type1" | 106.7 | | 0.503 |
| 7.80 | 3.40 | 1.846 | 0.873 | 1.801 | 0.895 | type1" | 110.7 | | 0.541 |
| 8.20 | 3.40 | 1.903 | 0.901 | 1.900 | 0.948 | type1" | 112.0 | | 0.554 |
| 8.60 | 3.40 | 0.000 | 0.000 | 1.960 | 0.979 | type1 | 40.0 | | 0.008 |
| 9.00 | 3.40 | 0.000 | 0.000 | 1.980 | 0.989 | type1 | 40.0 | | 0.008 |
| 9.40 | 3.40 | 0.000 | 0.000 | 1.960 | 0.979 | type1 | 40.0 | | 0.008 |
| 3.80 | 3.80 | 1.821 | 0.379 | 1.841 | 0.342 | type5 | 200.0 | 124.0 | 0.214 |
| 4.20 | 3.80 | 1.797 | 0.559 | 1.742 | 0.564 | type2 | 276.0 | 80.0 | 0.308 |
| 4.60 | 3.80 | 1.632 | 0.770 | 1.605 | 0.774 | type1" | 105.3 | | 0.490 |
| 5.00 | 3.80 | 1.168 | 0.063 | 1.430 | 0.968 | type5 | 300.0 | 219.0 | 0.521 |
| 5.40 | 3.80 | 1.205 | 0.143 | 1.219 | 0.148 | type4 | 300.0 | | 0.563 |
| 5.80 | 3.80 | 0.908 | 0.384 | 0.973 | 0.312 | type1' | 116.0 | | 0.264 |
| 6.20 | 3.80 | 0.970 | 0.461 | 0.973 | 0.459 | type1" | 85.3 | | 0.322 |
| 6.60 | 3.80 | 1.209 | 0.570 | 1.219 | 0.589 | type1" | 93.3 | | 0.385 |
| 7.00 | 3.80 | 1.434 | 0.675 | 1.430 | 0.700 | type1" | 100.0 | | 0.442 |
| 7.40 | 3.80 | 1.632 | 0.770 | 1.605 | 0.792 | type1" | 105.3 | | 0.490 |
| 7.80 | 3.80 | 1.791 | 0.846 | 1.742 | 0.864 | type1" | 109.3 | | 0.528 |
| 8.20 | 3.80 | 1.846 | 0.873 | 1.841 | 0.916 | type1" | 110.7 | | 0.541 |
| 8.60 | 3.80 | 1.903 | 0.901 | 1.900 | 0.948 | type1" | 112.0 | | 0.554 |
| 9.00 | 3.80 | 1.903 | 0.901 | 1.920 | 0.958 | type1" | 112.0 | | 0.554 |
| 9.40 | 3.80 | 1.903 | 0.901 | 1.900 | 0.948 | type1" | 112.0 | | 0.554 |
| 9.80 | 3.80 | 1.846 | 0.873 | 1.841 | 0.916 | type1" | 110.7 | | 0.541 |
| 4.20 | 4.20 | 1.595 | 0.520 | 1.644 | 0.520 | type4 | 348.0 | | 0.757 |
| 4.60 | 4.20 | 1.531 | 0.721 | 1.508 | 0.728 | type1" | 102.7 | | 0.466 |
| 5.00 | 4.20 | 1.149 | 0.045 | 1.334 | 0.922 | type5 | 300.0 | 210.0 | 0.512 |
| 5.40 | 4.20 | 1.134 | 0.082 | 1.124 | 0.101 | type4 | 292.0 | | 0.533 |
| 5.80 | 4.20 | 0.911 | 0.207 | 0.879 | 0.264 | type4 | 144.0 | | 0.130 |
| 6.20 | 4.20 | 0.862 | 0.412 | 0.879 | 0.410 | type1" | 81.3 | | 0.292 |
| 6.60 | 4.20 | 1.125 | 0.532 | 1.124 | 0.539 | type1" | 90.7 | | 0.363 |
| 7.00 | 4.20 | 1.341 | 0.632 | 1.334 | 0.649 | type1" | 97.3 | | 0.419 |
| 7.40 | 4.20 | 1.531 | 0.721 | 1.508 | 0.741 | type1" | 102.7 | | 0.466 |
| 7.80 | 4.20 | 1.684 | 0.795 | 1.644 | 0.813 | type1" | 106.7 | | 0.503 |
| 8.20 | 4.20 | 1.791 | 0.846 | 1.742 | 0.864 | type1" | 109.3 | | 0.528 |
| 8.60 | 4.20 | 1.846 | 0.873 | 1.801 | 0.895 | type1" | 110.7 | | 0.541 |
| 9.00 | 4.20 | 1.846 | 0.873 | 1.821 | 0.906 | type1" | 110.7 | | 0.541 |
| 9.40 | 4.20 | 1.846 | 0.873 | 1.801 | 0.895 | type1" | 110.7 | | 0.541 |
| 9.80 | 4.20 | 1.791 | 0.846 | 1.742 | 0.864 | type1" | 109.3 | | 0.528 |
| 10.20 | 4.20 | 1.684 | 0.795 | 1.644 | 0.813 | type1" | 106.7 | | 0.503 |

| Cx | Cy | PM1 | PM2 | PD1 | PD2 | type | W | W' | FF |
|---|---|---|---|---|---|---|---|---|---|
| 4.60 | 4.60 | 1.387 | 0.653 | 1.372 | 0.664 | type1" | 98.7 | | 0.430 |
| 5.00 | 4.60 | 1.038 | 0.968 | 1.200 | 0.857 | type1 | 312.0 | | 0.478 |
| 5.40 | 4.60 | 1.030 | 0.992 | 0.992 | 0.034 | type4 | 280.0 | | 0.490 |
| 5.80 | 4.60 | 0.752 | 0.180 | 0.749 | 0.196 | type4 | 136.0 | | 0.116 |
| 6.20 | 4.60 | 0.758 | 0.326 | 0.749 | 0.342 | type1' | 108.0 | | 0.229 |
| 6.60 | 4.60 | 1.007 | 0.478 | 0.992 | 0.469 | type1" | 86.7 | | 0.332 |
| 7.00 | 4.60 | 1.209 | 0.570 | 1.200 | 0.579 | type1" | 93.3 | | 0.385 |
| 7.40 | 4.60 | 1.387 | 0.653 | 1.372 | 0.670 | type1" | 98.7 | | 0.430 |
| 7.80 | 4.60 | 1.531 | 0.721 | 1.508 | 0.741 | type1" | 102.7 | | 0.466 |
| 8.20 | 4.60 | 1.632 | 0.770 | 1.605 | 0.792 | type1" | 105.3 | | 0.490 |
| 8.60 | 4.60 | 1.684 | 0.795 | 1.664 | 0.823 | type1" | 106.7 | | 0.503 |
| 9.00 | 4.60 | 1.684 | 0.795 | 1.683 | 0.833 | type1" | 106.7 | | 0.503 |
| 9.40 | 4.60 | 1.684 | 0.795 | 1.664 | 0.823 | type1" | 106.7 | | 0.503 |
| 9.80 | 4.60 | 1.632 | 0.770 | 1.605 | 0.792 | type1" | 105.3 | | 0.490 |
| 10.20 | 4.60 | 1.531 | 0.721 | 1.508 | 0.741 | type1" | 102.7 | | 0.466 |
| 10.60 | 4.60 | 1.387 | 0.653 | 1.372 | 0.670 | type1" | 98.7 | | 0.430 |
| 5.00 | 5.00 | 0.907 | 0.862 | 1.029 | 0.774 | type1 | 296.0 | | 0.430 |
| 5.40 | 5.00 | 0.879 | 0.898 | 0.823 | 0.950 | type5 | 320.0 | 140.8 | 0.439 |
| 5.80 | 5.00 | 0.596 | 0.150 | 0.583 | 0.110 | type 1 | 144.0 | | 0.102 |
| 6.20 | 5.00 | 0.592 | 0.262 | 0.583 | 0.254 | type1' | 98.0 | | 0.189 |
| 6.60 | 5.00 | 0.828 | 0.397 | 0.823 | 0.381 | type1" | 80.0 | | 0.283 |
| 7.00 | 5.00 | 1.046 | 0.495 | 1.029 | 0.489 | type1" | 88.0 | | 0.342 |
| 7.40 | 5.00 | 1.209 | 0.570 | 1.200 | 0.579 | type1" | 93.3 | | 0.385 |
| 7.80 | 5.00 | 1.341 | 0.632 | 1.334 | 0.649 | type1" | 97.3 | | 0.419 |
| 8.20 | 5.00 | 1.434 | 0.675 | 1.430 | 0.700 | type1" | 100.0 | | 0.442 |
| 8.60 | 5.00 | 1.531 | 0.721 | 1.488 | 0.731 | type1" | 102.7 | | 0.466 |
| 9.00 | 5.00 | 1.531 | 0.721 | 1.508 | 0.741 | type1" | 102.7 | | 0.466 |
| 9.40 | 5.00 | 1.531 | 0.721 | 1.488 | 0.731 | type1" | 102.7 | | 0.466 |
| 9.80 | 5.00 | 1.434 | 0.675 | 1.430 | 0.700 | type1" | 100.0 | | 0.442 |
| 10.20 | 5.00 | 1.341 | 0.632 | 1.334 | 0.649 | type1" | 97.3 | | 0.419 |
| 10.60 | 5.00 | 1.209 | 0.570 | 1.200 | 0.579 | type1" | 93.3 | | 0.385 |
| 11.00 | 5.00 | 1.046 | 0.495 | 1.029 | 0.489 | type1" | 88.0 | | 0.342 |
| 5.40 | 5.40 | 0.664 | 0.798 | 0.620 | 0.847 | type5 | 320.0 | 121.6 | 0.394 |
| 5.80 | 5.40 | 0.369 | 0.029 | 0.382 | 0.006 | type1' | 174.0 | | 0.594 |
| 6.20 | 5.40 | 0.375 | 0.175 | 0.382 | 0.148 | type1' | 82.0 | | 0.132 |
| 6.60 | 5.40 | 0.623 | 0.274 | 0.620 | 0.273 | type1' | 100.0 | | 0.196 |
| 7.00 | 5.40 | 0.828 | 0.397 | 0.823 | 0.381 | type1" | 80.0 | | 0.283 |
| 7.40 | 5.40 | 1.007 | 0.478 | 0.992 | 0.469 | type1" | 86.7 | | 0.332 |
| 7.80 | 5.40 | 1.125 | 0.532 | 1.124 | 0.539 | type1" | 90.7 | | 0.363 |
| 8.20 | 5.40 | 1.209 | 0.570 | 1.219 | 0.589 | type1" | 93.3 | | 0.385 |
| 8.60 | 5.40 | 1.296 | 0.611 | 1.276 | 0.619 | type1" | 96.0 | | 0.407 |
| 9.00 | 5.40 | 1.296 | 0.611 | 1.296 | 0.629 | type1" | 96.0 | | 0.407 |
| 9.40 | 5.40 | 1.296 | 0.611 | 1.276 | 0.619 | type1" | 96.0 | | 0.407 |
| 9.80 | 5.40 | 1.209 | 0.570 | 1.219 | 0.589 | type1" | 93.3 | | 0.385 |
| 10.20 | 5.40 | 1.125 | 0.532 | 1.124 | 0.539 | type1" | 90.7 | | 0.363 |
| 10.60 | 5.40 | 1.007 | 0.478 | 0.992 | 0.469 | type1" | 86.7 | | 0.332 |
| 11.00 | 5.40 | 0.828 | 0.397 | 0.823 | 0.381 | type1" | 80.0 | | 0.283 |
| 11.40 | 5.40 | 0.623 | 0.274 | 0.620 | 0.273 | type1' | 100.0 | | 0.196 |
| 5.80 | 5.80 | 0.172 | 0.869 | 0.147 | 0.884 | type2 | 368.0 | 80.0 | 0.452 |
| 6.20 | 5.80 | 0.137 | 0.062 | 0.147 | 0.025 | type4 | 88.0 | | 0.048 |
| 6.60 | 5.80 | 0.375 | 0.175 | 0.382 | 0.148 | type1' | 82.0 | | 0.132 |
| 7.00 | 5.80 | 0.592 | 0.262 | 0.583 | 0.254 | type1' | 98.0 | | 0.189 |
| 7.40 | 5.80 | 0.758 | 0.326 | 0.749 | 0.342 | type1' | 108.0 | | 0.229 |
| 7.80 | 5.80 | 0.862 | 0.412 | 0.879 | 0.410 | type1" | 81.3 | | 0.292 |
| 8.20 | 5.80 | 0.970 | 0.461 | 0.973 | 0.459 | type1" | 85.3 | | 0.322 |
| 8.60 | 5.80 | 1.046 | 0.495 | 1.029 | 0.489 | type1" | 88.0 | | 0.342 |
| 9.00 | 5.80 | 1.046 | 0.495 | 1.048 | 0.499 | type1" | 88.0 | | 0.342 |
| 9.40 | 5.80 | 1.046 | 0.495 | 1.029 | 0.489 | type1" | 88.0 | | 0.342 |
| 9.80 | 5.80 | 0.970 | 0.461 | 0.973 | 0.459 | type1" | 85.3 | | 0.322 |
| 10.20 | 5.80 | 0.862 | 0.412 | 0.879 | 0.410 | type1" | 81.3 | | 0.292 |
| 10.60 | 5.80 | 0.758 | 0.326 | 0.749 | 0.342 | type1' | 108.0 | | 0.229 |
| 11.00 | 5.80 | 0.592 | 0.262 | 0.583 | 0.254 | type1' | 98.0 | | 0.189 |
| 11.40 | 5.80 | 0.375 | 0.175 | 0.382 | 0.148 | type1' | 82.0 | | 0.132 |
| 11.80 | 5.80 | 0.137 | 0.062 | 0.147 | 0.025 | type4 | 88.0 | | 0.048 |

| Cx | Cy | PM1 | PM2 | PD1 | PD2 | type | W | W' | FF |
|---|---|---|---|---|---|---|---|---|---|
| 6.20 | 6.20 | 0.172 | 0.869 | 0.147 | 0.884 | type2 | 368.0 | 80.0 | 0.452 |
| 6.60 | 6.20 | 0.369 | 0.029 | 0.382 | 0.006 | type1' | 174.0 | | 0.594 |
| 7.00 | 6.20 | 0.596 | 0.150 | 0.583 | 0.110 | type1 | 144.0 | | 0.102 |
| 7.40 | 6.20 | 0.752 | 0.180 | 0.749 | 0.196 | type4 | 136.0 | | 0.116 |
| 7.80 | 6.20 | 0.911 | 0.207 | 0.879 | 0.264 | type4 | 144.0 | | 0.130 |
| 8.20 | 6.20 | 0.908 | 0.384 | 0.973 | 0.312 | type1' | 116.0 | | 0.264 |
| 8.60 | 6.20 | 0.988 | 0.415 | 1.029 | 0.342 | type1' | 120.0 | | 0.283 |
| 9.00 | 6.20 | 0.988 | 0.415 | 1.048 | 0.351 | type1' | 120.0 | | 0.283 |
| 9.40 | 6.20 | 0.988 | 0.415 | 1.029 | 0.342 | type1' | 120.0 | | 0.283 |
| 9.80 | 6.20 | 0.908 | 0.384 | 0.973 | 0.312 | type1' | 116.0 | | 0.264 |
| 10.20 | 6.20 | 0.911 | 0.207 | 0.879 | 0.264 | type4 | 144.0 | | 0.130 |
| 10.60 | 6.20 | 0.752 | 0.180 | 0.749 | 0.196 | type4 | 136.0 | | 0.116 |
| 11.00 | 6.20 | 0.596 | 0.150 | 0.583 | 0.110 | type1 | 144.0 | | 0.102 |
| 11.40 | 6.20 | 0.369 | 0.029 | 0.382 | 0.006 | type1' | 174.0 | | 0.594 |
| 11.80 | 6.20 | 0.172 | 0.869 | 0.147 | 0.884 | type2 | 368.0 | 80.0 | 0.452 |
| 12.20 | 6.20 | 0.397 | 0.577 | 0.382 | 0.591 | type5 | 240.0 | 144.0 | 0.302 |
| 6.60 | 6.60 | 0.664 | 0.798 | 0.620 | 0.847 | type5 | 320.0 | 121.6 | 0.394 |
| 7.00 | 6.60 | 0.879 | 0.898 | 0.823 | 0.950 | type5 | 320.0 | 140.8 | 0.439 |
| 7.40 | 6.60 | 1.030 | 0.992 | 0.992 | 0.034 | type4 | 280.0 | | 0.490 |
| 7.80 | 6.60 | 1.134 | 0.082 | 1.124 | 0.101 | type4 | 292.0 | | 0.533 |
| 8.20 | 6.60 | 1.205 | 0.143 | 1.219 | 0.148 | type4 | 300.0 | | 0.563 |
| 8.60 | 6.60 | 1.263 | 0.182 | 1.276 | 0.177 | type5 | 320.0 | 220.8 | 0.578 |
| 9.00 | 6.60 | 1.290 | 0.191 | 1.296 | 0.187 | type1 | 344.0 | | 0.581 |
| 9.40 | 6.60 | 1.263 | 0.182 | 1.276 | 0.177 | type5 | 320.0 | 220.8 | 0.578 |
| 9.80 | 6.60 | 1.205 | 0.143 | 1.219 | 0.148 | type4 | 300.0 | | 0.563 |
| 10.20 | 6.60 | 1.134 | 0.082 | 1.124 | 0.101 | type4 | 292.0 | | 0.533 |
| 10.60 | 6.60 | 1.030 | 0.992 | 0.992 | 0.034 | type4 | 280.0 | | 0.490 |
| 11.00 | 6.60 | 0.879 | 0.898 | 0.823 | 0.950 | type5 | 320.0 | 140.8 | 0.439 |
| 11.40 | 6.60 | 0.664 | 0.798 | 0.620 | 0.847 | type5 | 320.0 | 121.6 | 0.394 |
| 11.80 | 6.60 | 0.374 | 0.730 | 0.382 | 0.728 | type2 | 292.0 | 104.0 | 0.384 |
| 12.20 | 6.60 | 0.671 | 0.326 | 0.583 | 0.422 | type1" | 73.3 | | 0.238 |
| 12.60 | 6.60 | 0.794 | 0.340 | 0.823 | 0.272 | type1' | 110.0 | | 0.238 |
| 7.00 | 7.00 | 0.907 | 0.862 | 1.029 | 0.774 | type1 | 296.0 | | 0.430 |
| 7.40 | 7.00 | 1.038 | 0.968 | 1.200 | 0.857 | type1 | 312.0 | | 0.478 |
| 7.80 | 7.00 | 1.149 | 0.045 | 1.334 | 0.922 | type5 | 300.0 | 210.0 | 0.512 |
| 8.20 | 7.00 | 1.168 | 0.063 | 1.430 | 0.968 | type5 | 300.0 | 219.0 | 0.521 |
| 8.60 | 7.00 | 1.228 | 0.134 | 1.488 | 0.997 | type1 | 336.0 | | 0.554 |
| 9.00 | 7.00 | 1.259 | 0.163 | 1.508 | 0.006 | type1 | 340.0 | | 0.567 |
| 9.40 | 7.00 | 1.228 | 0.134 | 1.488 | 0.997 | type1 | 336.0 | | 0.554 |
| 9.80 | 7.00 | 1.168 | 0.063 | 1.430 | 0.968 | type5 | 300.0 | 219.0 | 0.521 |
| 10.20 | 7.00 | 1.149 | 0.045 | 1.334 | 0.922 | type5 | 300.0 | 210.0 | 0.512 |
| 10.60 | 7.00 | 1.038 | 0.968 | 1.200 | 0.857 | type1 | 312.0 | | 0.478 |
| 11.00 | 7.00 | 0.907 | 0.862 | 1.029 | 0.774 | type1 | 296.0 | | 0.430 |
| 11.40 | 7.00 | 0.728 | 0.734 | 0.823 | 0.673 | type1 | 276.0 | | 0.374 |
| 11.80 | 7.00 | 0.516 | 0.614 | 0.583 | 0.555 | type1 | 256.0 | | 0.322 |
| 12.20 | 7.00 | 0.752 | 0.180 | 0.749 | 0.237 | type4 | 136.0 | | 0.116 |
| 12.60 | 7.00 | 1.099 | 0.052 | 0.992 | 0.090 | type4 | 288.0 | | 0.518 |
| 13.00 | 7.00 | 1.105 | 0.016 | 1.200 | 0.928 | type5 | 300.0 | 198.0 | 0.497 |
| 7.40 | 7.40 | 1.387 | 0.653 | 1.372 | 0.664 | type1" | 98.7 | | 0.430 |
| 7.80 | 7.40 | 1.531 | 0.721 | 1.508 | 0.728 | type1" | 102.7 | | 0.466 |
| 8.20 | 7.40 | 1.632 | 0.770 | 1.605 | 0.774 | type1" | 105.3 | | 0.490 |
| 8.60 | 7.40 | 1.684 | 0.795 | 1.664 | 0.801 | type1" | 106.7 | | 0.503 |
| 9.00 | 7.40 | 1.684 | 0.795 | 1.683 | 0.810 | type1" | 106.7 | | 0.503 |
| 9.40 | 7.40 | 1.684 | 0.795 | 1.664 | 0.801 | type1" | 106.7 | | 0.503 |
| 9.80 | 7.40 | 1.632 | 0.770 | 1.605 | 0.774 | type1" | 105.3 | | 0.490 |
| 10.20 | 7.40 | 1.531 | 0.721 | 1.508 | 0.728 | type1" | 102.7 | | 0.466 |
| 10.60 | 7.40 | 1.387 | 0.653 | 1.372 | 0.664 | type1" | 98.7 | | 0.430 |
| 11.00 | 7.40 | 1.209 | 0.570 | 1.200 | 0.582 | type1" | 93.3 | | 0.385 |
| 11.40 | 7.40 | 1.007 | 0.478 | 0.992 | 0.484 | type1" | 86.7 | | 0.332 |
| 11.80 | 7.40 | 0.763 | 0.367 | 0.749 | 0.369 | type1" | 77.3 | | 0.264 |
| 12.20 | 7.40 | 0.996 | 0.962 | 0.879 | 0.039 | type4 | 276.0 | | 0.476 |
| 12.60 | 7.40 | 1.038 | 0.968 | 1.124 | 0.895 | type1 | 312.0 | | 0.478 |
| 13.00 | 7.40 | 1.387 | 0.653 | 1.334 | 0.736 | type1" | 98.7 | | 0.430 |
| 13.40 | 7.40 | 1.447 | 0.598 | 1.508 | 0.563 | type1' | 140.0 | | 0.385 |
| 7.80 | 7.80 | 1.595 | 0.520 | 1.644 | 0.520 | type4 | 348.0 | | 0.757 |
| 8.20 | 7.80 | 1.797 | 0.559 | 1.742 | 0.564 | type2 | 276.0 | 80.0 | 0.308 |
| 8.60 | 7.80 | 1.808 | 0.584 | 1.801 | 0.591 | type2 | 284.0 | 80.0 | 0.320 |
| 9.00 | 7.80 | 1.814 | 0.597 | 1.821 | 0.601 | type2 | 288.0 | 80.0 | 0.327 |
| 9.40 | 7.80 | 1.808 | 0.584 | 1.801 | 0.591 | type2 | 284.0 | 80.0 | 0.320 |
| 9.80 | 7.80 | 1.797 | 0.559 | 1.742 | 0.564 | type2 | 276.0 | 80.0 | 0.308 |
| 10.20 | 7.80 | 1.595 | 0.520 | 1.644 | 0.520 | type4 | 348.0 | | 0.757 |
| 10.60 | 7.80 | 1.541 | 0.454 | 1.508 | 0.457 | type4 | 340.0 | | 0.723 |
| 11.00 | 7.80 | 1.416 | 0.328 | 1.334 | 0.377 | type4 | 324.0 | | 0.656 |
| 11.40 | 7.80 | 1.166 | 0.252 | 1.124 | 0.281 | type4 | 156.0 | | 0.152 |
| 11.80 | 7.80 | 0.868 | 0.194 | 0.879 | 0.168 | type1 | 160.0 | | 0.126 |
| 12.20 | 7.80 | 0.907 | 0.862 | 0.973 | 0.828 | type1 | 296.0 | | 0.430 |
| 12.60 | 7.80 | 1.296 | 0.611 | 1.219 | 0.686 | type1" | 96.0 | | ).407 |
| 13.00 | 7.80 | 1.397 | 0.577 | 1.430 | 0.531 | type1' | 138.0 | | ).374 |
| 13.40 | 7.80 | 1.618 | 0.377 | 1.605 | 0.361 | type5 | 240.0 | 84.0 | 0.208 |
| 13.80 | 7.80 | 1.640 | 0.335 | 1.742 | 0.178 | type1 | 200.0 | | 0.196 |
| 8.20 | 8.20 | 1.821 | 0.379 | 1.841 | 0.342 | type5 | 200.0 | 124.0 | 0.214 |
| 8.60 | 8.20 | 1.890 | 0.394 | 1.900 | 0.369 | type5 | 200.0 | 132.0 | 0.221 |
| 9.00 | 8.20 | 1.905 | 0.398 | 1.920 | 0.377 | type5 | 200.0 | 134.0 | 0.223 |
| 9.40 | 8.20 | 1.890 | 0.394 | 1.900 | 0.369 | type5 | 200.0 | 132.0 | 0.221 |
| 9.80 | 8.20 | 1.821 | 0.379 | 1.841 | 0.342 | type5 | 200.0 | 124.0 | 0.214 |
| 10.20 | 8.20 | 1.715 | 0.352 | 1.742 | 0.298 | type1 | 204.0 | | 0.204 |
| 10.60 | 8.20 | 1.563 | 0.319 | 1.605 | 0.237 | type1 | 196.0 | | 0.189 |
| 11.00 | 8.20 | 1.321 | 0.220 | 1.430 | 0.159 | type1 | 348.0 | | 0.594 |
| 11.40 | 8.20 | 1.174 | 0.075 | 1.219 | 0.065 | type5 | 300.0 | 225.0 | 0.527 |
| 11.80 | 8.20 | 0.974 | 0.946 | 0.973 | 0.954 | type5 | 300.0 | 174.0 | 0.463 |
| 12.20 | 8.20 | 1.085 | 0.513 | 1.029 | 0.604 | type1" | 89.3 | | 0.353 |
| 12.60 | 8.20 | 1.253 | 0.519 | 1.276 | 0.466 | type1' | 132.0 | | 0.342 |
| 13.00 | 8.20 | 1.486 | 0.303 | 1.488 | 0.313 | type1 | 192.0 | | 0.181 |
| 13.40 | 8.20 | 1.563 | 0.319 | 1.664 | 0.147 | type1 | 196.0 | | 0.189 |
| 13.80 | 8.20 | 1.903 | 0.901 | 1.801 | 0.967 | type1" | 112.0 | | 0.554 |
| 14.20 | 8.20 | 1.865 | 0.779 | 1.900 | 0.775 | type1' | 156.0 | | 0.478 |
| 8.60 | 8.60 | 0.055 | 0.035 | 1.960 | 0.133 | type1' | 42.0 | | 0.035 |
| 9.00 | 8.60 | 0.074 | 0.044 | 1.980 | 0.142 | type1' | 46.0 | | 0.042 |
| 9.40 | 8.60 | 0.055 | 0.035 | 1.960 | 0.133 | type1' | 42.0 | | 0.035 |
| 9.80 | 8.60 | 0.045 | 0.030 | 1.900 | 0.107 | type1' | 40.0 | | 0.031 |
| 10.20 | 8.60 | 0.000 | 0.000 | 1.801 | 0.065 | type1 | 40.0 | | 0.008 |
| 10.60 | 8.60 | 1.791 | 0.846 | 1.664 | 0.005 | type1" | 109.3 | | 0.528 |
| 11.00 | 8.60 | 1.632 | 0.770 | 1.488 | 0.928 | type1" | 105.3 | | 0.490 |
| 11.40 | 8.60 | 1.434 | 0.675 | 1.276 | 0.836 | type1" | 100.0 | | 0.442 |
| 11.80 | 8.60 | 0.873 | 0.835 | 1.029 | 0.728 | type1 | 292.0 | | 0.419 |
| 12.20 | 8.60 | 0.988 | 0.415 | 1.048 | 0.369 | type1' | 120.0 | | 0.283 |
| 12.60 | 8.60 | 1.294 | 0.233 | 1.296 | 0.233 | type5 | 320.0 | 246.4 | 0.606 |
| 13.00 | 8.60 | 1.290 | 0.191 | 1.508 | 0.084 | type1 | 344.0 | | 0.581 |
| 13.40 | 8.60 | 1.791 | 0.846 | 1.683 | 0.921 | type1" | 109.3 | | 0.528 |
| 13.80 | 8.60 | 1.811 | 0.755 | 1.821 | 0.745 | type1' | 154.0 | | 0.466 |
| 14.20 | 8.60 | 1.928 | 0.549 | 1.920 | 0.557 | type5 | 320.0 | 80.0 | 0.280 |
| 14.60 | 8.60 | 1.958 | 0.411 | 1.980 | 0.357 | type5 | 200.0 | 142.0 | 0.229 |
| 9.00 | 9.00 | 0.029 | 0.857 | 0.000 | 0.895 | type1' | 162.0 | | 0.515 |
| 9.40 | 9.00 | 0.029 | 0.857 | 1.980 | 0.886 | type1' | 162.0 | | 0.515 |
| 9.80 | 9.00 | 1.903 | 0.901 | 1.920 | 0.861 | type1" | 112.0 | | 0.554 |
| 10.20 | 9.00 | 1.791 | 0.846 | 1.821 | 0.819 | type1" | 109.3 | | 0.528 |
| 10.60 | 9.00 | 1.684 | 0.795 | 1.683 | 0.761 | type1" | 106.7 | | 0.503 |
| 11.00 | 9.00 | 1.482 | 0.698 | 1.508 | 0.686 | type1" | 101.3 | | 0.454 |
| 11.40 | 9.00 | 1.296 | 0.611 | 1.296 | 0.596 | type1" | 96.0 | | 0.407 |
| 11.80 | 9.00 | 1.046 | 0.495 | 1.048 | 0.490 | type1" | 88.0 | | 0.342 |
| 12.20 | 9.00 | 1.085 | 0.513 | 1.029 | 0.604 | type1" | 89.3 | | 0.353 |
| 12.60 | 9.00 | 1.253 | 0.519 | 1.276 | 0.466 | type1' | 132.0 | | 0.342 |
| 13.00 | 9.00 | 1.486 | 0.303 | 1.488 | 0.313 | type1 | 192.0 | | 0.181 |
| 13.40 | 9.00 | 1.563 | 0.319 | 1.664 | 0.147 | type1 | 196.0 | | 0.189 |
| 13.80 | 9.00 | 1.903 | 0.901 | 1.801 | 0.967 | type1" | 112.0 | | 0.554 |
| 14.20 | 9.00 | 1.865 | 0.779 | 1.900 | 0.775 | type1' | 156.0 | | 0.478 |
| 14.60 | 9.00 | 1.995 | 0.570 | 1.960 | 0.572 | type2 | 268.0 | 88.0 | 0.311 |
| 15.00 | 9.00 | 1.958 | 0.411 | 1.980 | 0.357 | type5 | 200.0 | 142.0 | 0.229 |

### NUMERICAL EXAMPLE 5

| Cx | Cy | PM1 | PM2 | PD1 | PD2 | type | W | W' | FF |
|---|---|---|---|---|---|---|---|---|---|
| 3.00 | 3.00 | 2.962 | 0.791 | 0.000 | 0.766 | type2 | 336.0 | 104.0 | 0.474 |
| 3.40 | 3.00 | 0.000 | 0.007 | 2.973 | 0.019 | type1 | 52.0 | | 0.013 |
| 3.80 | 3.00 | 2.876 | 0.395 | 2.891 | 0.263 | type1 | 228.0 | | 0.255 |
| 4.20 | 3.00 | 2.767 | 0.527 | 2.756 | 0.495 | type5 | 300.0 | 99.0 | 0.310 |
| 4.60 | 3.00 | 2.556 | 0.713 | 2.569 | 0.715 | type2 | 352.0 | 80.0 | 0.427 |
| 5.00 | 3.00 | 2.219 | 0.807 | 2.332 | 0.922 | type1" | 112.0 | | 0.554 |
| 5.40 | 3.00 | 1.980 | 0.247 | 2.047 | 0.114 | type1 | 188.0 | | 0.173 |
| 5.80 | 3.00 | 1.690 | 0.217 | 1.717 | 0.290 | type4 | 156.0 | | 0.152 |
| 6.20 | 3.00 | 1.666 | 0.497 | 1.717 | 0.450 | type1' | 136.0 | | 0.363 |
| 6.60 | 3.00 | 2.025 | 0.609 | 2.047 | 0.592 | type1' | 148.0 | | 0.430 |
| 7.00 | 3.00 | 2.332 | 0.715 | 2.332 | 0.714 | type1' | 158.0 | | 0.490 |
| 7.40 | 3.00 | 2.578 | 0.810 | 2.569 | 0.815 | type1' | 166.0 | | 0.541 |
| 7.80 | 3.00 | 2.763 | 0.889 | 2.756 | 0.895 | type1' | 172.0 | | 0.581 |
| 8.20 | 3.00 | 2.887 | 0.945 | 2.891 | 0.953 | type1' | 176.0 | | 0.608 |
| 8.60 | 3.00 | 2.950 | 0.975 | 2.973 | 0.988 | type1' | 178.0 | | 0.622 |
| 9.00 | 3.00 | 0.000 | 0.000 | 0.000 | 0.000 | type1 | 40.0 | | 0.008 |
| 3.40 | 3.40 | 2.950 | 0.975 | 2.945 | 0.011 | type1' | 178.0 | | 0.622 |
| 3.80 | 3.40 | 2.797 | 0.378 | 2.864 | 0.254 | type1 | 224.0 | | 0.246 |
| 4.20 | 3.40 | 2.710 | 0.513 | 2.729 | 0.486 | type5 | 300.0 | 96.0 | 0.302 |
| 4.60 | 3.40 | 2.532 | 0.699 | 2.542 | 0.705 | type2 | 348.0 | 80.0 | 0.421 |
| 5.00 | 3.40 | 2.219 | 0.807 | 2.306 | 0.912 | type1" | 112.0 | | 0.554 |
| 5.40 | 3.40 | 1.980 | 0.247 | 2.021 | 0.104 | type1 | 188.0 | | 0.173 |
| 5.80 | 3.40 | 1.690 | 0.217 | 1.692 | 0.280 | type4 | 156.0 | | 0.152 |
| 6.20 | 3.40 | 1.666 | 0.497 | 1.692 | 0.439 | type1' | 136.0 | | 0.363 |
| 6.60 | 3.40 | 2.025 | 0.609 | 2.021 | 0.581 | type1' | 148.0 | | 0.430 |
| 7.00 | 3.40 | 2.332 | 0.715 | 2.306 | 0.702 | type1' | 158.0 | | 0.490 |
| 7.40 | 3.40 | 2.517 | 0.785 | 2.542 | 0.804 | type1' | 164.0 | | 0.528 |
| 7.80 | 3.40 | 2.763 | 0.889 | 2.729 | 0.884 | type1' | 172.0 | | 0.581 |
| 8.20 | 3.40 | 2.887 | 0.945 | 2.864 | 0.942 | type1' | 176.0 | | 0.608 |
| 8.60 | 3.40 | 2.950 | 0.975 | 2.945 | 0.977 | type1' | 178.0 | | 0.622 |
| 9.00 | 3.40 | 2.950 | 0.975 | 2.973 | 0.988 | type1' | 178.0 | | 0.622 |
| 9.40 | 3.40 | 2.950 | 0.975 | 2.945 | 0.977 | type1' | 178.0 | | 0.622 |
| 3.80 | 3.80 | 2.716 | 0.362 | 2.783 | 0.226 | type1 | 220.0 | | 0.238 |
| 4.20 | 3.80 | 2.668 | 0.450 | 2.649 | 0.457 | type2 | 248.0 | 96.0 | 0.287 |
| 4.60 | 3.80 | 2.482 | 0.674 | 2.463 | 0.676 | type2 | 340.0 | 80.0 | 0.408 |
| 5.00 | 3.80 | 2.219 | 0.807 | 2.228 | 0.882 | type1" | 112.0 | | 0.554 |
| 5.40 | 3.80 | 1.882 | 0.235 | 1.945 | 0.073 | type1 | 184.0 | | 0.166 |
| 5.80 | 3.80 | 1.582 | 0.204 | 1.617 | 0.249 | type4 | 152.0 | | 0.144 |
| 6.20 | 3.80 | 1.550 | 0.464 | 1.617 | 0.407 | type1' | 132.0 | | 0.342 |
| 6.60 | 3.80 | 1.904 | 0.570 | 1.945 | 0.548 | type1' | 144.0 | | 0.407 |
| 7.00 | 3.80 | 2.209 | 0.671 | 2.228 | 0.669 | type1' | 154.0 | | 0.466 |
| 7.40 | 3.80 | 2.455 | 0.761 | 2.463 | 0.770 | type1' | 162.0 | | 0.515 |
| 7.80 | 3.80 | 2.640 | 0.835 | 2.649 | 0.849 | type1' | 168.0 | | 0.554 |
| 8.20 | 3.80 | 2.763 | 0.889 | 2.783 | 0.907 | type1' | 172.0 | | 0.581 |
| 8.60 | 3.80 | 2.887 | 0.945 | 2.864 | 0.942 | type1' | 176.0 | | 0.608 |
| 9.00 | 3.80 | 2.887 | 0.945 | 2.891 | 0.953 | type1' | 176.0 | | 0.608 |
| 9.40 | 3.80 | 2.887 | 0.945 | 2.864 | 0.942 | type1' | 176.0 | | 0.608 |
| 9.80 | 3.80 | 2.763 | 0.889 | 2.783 | 0.907 | type1' | 172.0 | | 0.581 |
| 4.20 | 4.20 | 2.487 | 0.419 | 2.516 | 0.411 | type2 | 244.0 | 88.0 | 0.270 |
| 4.60 | 4.20 | 2.361 | 0.614 | 2.332 | 0.628 | type2 | 320.0 | 80.0 | 0.377 |
| 5.00 | 4.20 | 2.155 | 0.782 | 2.098 | 0.832 | type1" | 110.7 | | 0.541 |
| 5.40 | 4.20 | 1.784 | 0.222 | 1.818 | 0.022 | type1 | 180.0 | | 0.159 |
| 5.80 | 4.20 | 1.492 | 0.188 | 1.492 | 0.196 | type1 | 168.0 | | 0.139 |
| 6.20 | 4.20 | 1.438 | 0.431 | 1.492 | 0.354 | type1' | 128.0 | | 0.322 |
| 6.60 | 4.20 | 1.784 | 0.533 | 1.818 | 0.493 | type1' | 140.0 | | 0.385 |
| 7.00 | 4.20 | 2.086 | 0.629 | 2.098 | 0.614 | type1' | 150.0 | | 0.442 |
| 7.40 | 4.20 | 2.332 | 0.715 | 2.332 | 0.714 | type1' | 158.0 | | 0.490 |
| 7.80 | 4.20 | 2.517 | 0.785 | 2.516 | 0.792 | type1' | 164.0 | | 0.528 |
| 8.20 | 4.20 | 2.640 | 0.835 | 2.649 | 0.849 | type1' | 168.0 | | 0.554 |
| 8.60 | 4.20 | 2.763 | 0.889 | 2.729 | 0.884 | type1' | 172.0 | | 0.581 |
| 9.00 | 4.20 | 2.763 | 0.889 | 2.756 | 0.895 | type1' | 172.0 | | 0.581 |
| 9.40 | 4.20 | 2.763 | 0.889 | 2.729 | 0.884 | type1' | 172.0 | | 0.581 |
| 9.80 | 4.20 | 2.640 | 0.835 | 2.649 | 0.849 | type1' | 168.0 | | 0.554 |
| 10.20 | 4.20 | 2.517 | 0.785 | 2.516 | 0.792 | type1' | 164.0 | | 0.528 |

| Cx | Cy | PM1 | PM2 | PD1 | PD2 | type | W | W' | FF |
|---|---|---|---|---|---|---|---|---|---|
| 4.60 | 4.60 | 2.086 | 0.629 | 2.150 | 0.561 | type1' | 150.0 | | 0.442 |
| 5.00 | 4.60 | 1.970 | 0.711 | 1.919 | 0.764 | type1" | 106.7 | | 0.503 |
| 5.40 | 4.60 | 1.589 | 0.199 | 1.642 | 0.952 | type1 | 172.0 | | 0.145 |
| 5.80 | 4.60 | 1.303 | 0.167 | 1.320 | 0.124 | type1 | 160.0 | | 0.126 |
| 6.20 | 4.60 | 1.370 | 0.179 | 1.320 | 0.280 | type4 | 144.0 | | 0.130 |
| 6.60 | 4.60 | 1.608 | 0.480 | 1.642 | 0.418 | type1' | 134.0 | | 0.353 |
| 7.00 | 4.60 | 1.904 | 0.570 | 1.919 | 0.537 | type1' | 144.0 | | 0.407 |
| 7.40 | 4.60 | 2.148 | 0.650 | 2.150 | 0.636 | type1' | 152.0 | | 0.454 |
| 7.80 | 4.60 | 2.332 | 0.715 | 2.332 | 0.714 | type1' | 158.0 | | 0.490 |
| 8.20 | 4.60 | 2.455 | 0.761 | 2.463 | 0.770 | type1' | 162.0 | | 0.515 |
| 8.60 | 4.60 | 2.517 | 0.785 | 2.542 | 0.804 | type1' | 164.0 | | 0.528 |
| 9.00 | 4.60 | 2.578 | 0.810 | 2.569 | 0.815 | type1' | 166.0 | | 0.541 |
| 9.40 | 4.60 | 2.517 | 0.785 | 2.542 | 0.804 | type1' | 164.0 | | 0.528 |
| 9.80 | 4.60 | 2.455 | 0.761 | 2.463 | 0.770 | type1' | 162.0 | | 0.515 |
| 10.20 | 4.60 | 2.332 | 0.715 | 2.332 | 0.714 | type1' | 158.0 | | 0.490 |
| 10.60 | 4.60 | 2.148 | 0.650 | 2.150 | 0.636 | type1' | 152.0 | | 0.454 |
| 5.00 | 5.00 | 1.738 | 0.626 | 1.692 | 0.676 | type1" | 101.3 | | 0.454 |
| 5.40 | 5.00 | 1.348 | 0.600 | 1.418 | 0.862 | type4 | 376.0 | | 0.884 |
| 5.80 | 5.00 | 1.064 | 0.145 | 1.101 | 0.032 | type4 | 132.0 | | 0.109 |
| 6.20 | 5.00 | 1.066 | 0.202 | 1.101 | 0.186 | type1 | 368.0 | | 0.665 |
| 6.60 | 5.00 | 1.383 | 0.415 | 1.418 | 0.322 | type1' | 126.0 | | 0.312 |
| 7.00 | 5.00 | 1.666 | 0.497 | 1.692 | 0.439 | type1' | 136.0 | | 0.363 |
| 7.40 | 5.00 | 1.904 | 0.570 | 1.919 | 0.537 | type1' | 144.0 | | 0.407 |
| 7.80 | 5.00 | 2.086 | 0.629 | 2.098 | 0.614 | type1' | 150.0 | | 0.442 |
| 8.20 | 5.00 | 2.209 | 0.671 | 2.228 | 0.669 | type1' | 154.0 | | 0.466 |
| 8.60 | 5.00 | 2.332 | 0.715 | 2.306 | 0.702 | type1' | 158.0 | | 0.490 |
| 9.00 | 5.00 | 2.332 | 0.715 | 2.332 | 0.714 | type1' | 158.0 | | 0.490 |
| 9.40 | 5.00 | 2.332 | 0.715 | 2.306 | 0.702 | type1' | 158.0 | | 0.490 |
| 9.80 | 5.00 | 2.209 | 0.671 | 2.228 | 0.669 | type1' | 154.0 | | 0.466 |
| 10.20 | 5.00 | 2.086 | 0.629 | 2.098 | 0.614 | type1' | 150.0 | | 0.442 |
| 10.60 | 5.00 | 1.904 | 0.570 | 1.919 | 0.537 | type1' | 144.0 | | 0.407 |
| 11.00 | 5.00 | 1.666 | 0.497 | 1.692 | 0.439 | type1' | 136.0 | | 0.363 |
| 5.40 | 5.40 | 1.348 | 0.600 | 1.149 | 0.754 | type4 | 376.0 | | 0.884 |
| 5.80 | 5.40 | 0.850 | 0.932 | 0.837 | 0.922 | type4 | 292.0 | | 0.533 |
| 6.20 | 5.40 | 0.868 | 0.057 | 0.837 | 0.073 | type5 | 320.0 | 236.8 | 0.597 |
| 6.60 | 5.40 | 1.101 | 0.232 | 1.149 | 0.207 | type1 | 372.0 | | 0.679 |
| 7.00 | 5.40 | 1.383 | 0.415 | 1.418 | 0.322 | type1' | 126.0 | | 0.312 |
| 7.40 | 5.40 | 1.608 | 0.480 | 1.642 | 0.418 | type1' | 134.0 | | 0.353 |
| 7.80 | 5.40 | 1.784 | 0.533 | 1.818 | 0.493 | type1' | 140.0 | | 0.385 |
| 8.20 | 5.40 | 1.904 | 0.570 | 1.945 | 0.548 | type1' | 144.0 | | 0.407 |
| 8.60 | 5.40 | 2.025 | 0.609 | 2.021 | 0.581 | type1' | 148.0 | | 0.430 |
| 9.00 | 5.40 | 2.025 | 0.609 | 2.047 | 0.592 | type1' | 148.0 | | 0.430 |
| 9.40 | 5.40 | 2.025 | 0.609 | 2.021 | 0.581 | type1' | 148.0 | | 0.430 |
| 9.80 | 5.40 | 1.904 | 0.570 | 1.945 | 0.548 | type1' | 144.0 | | 0.407 |
| 10.20 | 5.40 | 1.784 | 0.533 | 1.818 | 0.493 | type1' | 140.0 | | 0.385 |
| 10.60 | 5.40 | 1.608 | 0.480 | 1.642 | 0.418 | type1' | 134.0 | | 0.353 |
| 11.00 | 5.40 | 1.383 | 0.415 | 1.418 | 0.322 | type1' | 126.0 | | 0.312 |
| 11.40 | 5.40 | 1.101 | 0.232 | 1.149 | 0.207 | type1 | 372.0 | | 0.679 |
| 5.80 | 5.80 | 0.547 | 0.771 | 0.531 | 0.793 | type5 | 320.0 | 140.8 | 0.439 |
| 6.20 | 5.80 | 0.713 | 0.957 | 0.531 | 0.942 | type5 | 300.0 | 249.0 | 0.546 |
| 6.60 | 5.80 | 0.868 | 0.057 | 0.837 | 0.073 | type5 | 320.0 | 236.8 | 0.597 |
| 7.00 | 5.80 | 1.066 | 0.202 | 1.101 | 0.186 | type1 | 368.0 | | 0.665 |
| 7.40 | 5.80 | 1.370 | 0.179 | 1.320 | 0.280 | type4 | 144.0 | | 0.130 |
| 7.80 | 5.80 | 1.438 | 0.431 | 1.492 | 0.354 | type1' | 128.0 | | 0.322 |
| 8.20 | 5.80 | 1.550 | 0.464 | 1.617 | 0.407 | type1' | 132.0 | | 0.342 |
| 8.60 | 5.80 | 1.666 | 0.497 | 1.692 | 0.439 | type1' | 136.0 | | 0.363 |
| 9.00 | 5.80 | 1.666 | 0.497 | 1.717 | 0.450 | type1' | 136.0 | | 0.363 |
| 9.40 | 5.80 | 1.666 | 0.497 | 1.692 | 0.439 | type1' | 136.0 | | 0.363 |
| 9.80 | 5.80 | 1.550 | 0.464 | 1.617 | 0.407 | type1' | 132.0 | | 0.342 |
| 10.20 | 5.80 | 1.438 | 0.431 | 1.492 | 0.354 | type1' | 128.0 | | 0.322 |
| 10.60 | 5.80 | 1.370 | 0.179 | 1.320 | 0.280 | type4 | 144.0 | | 0.130 |
| 11.00 | 5.80 | 1.066 | 0.202 | 1.101 | 0.186 | type1 | 368.0 | | 0.665 |
| 11.40 | 5.80 | 0.868 | 0.057 | 0.837 | 0.073 | type5 | 320.0 | 236.8 | 0.597 |
| 11.80 | 5.80 | 0.713 | 0.957 | 0.531 | 0.942 | type5 | 300.0 | 249.0 | 0.546 |

| Cx | Cy | PM1 | PM2 | PD1 | PD2 | type | W | W' | FF |
|---|---|---|---|---|---|---|---|---|---|
| 6.20 | 6.20 | 0.547 | 0.771 | 0.531 | 0.793 | type5 | 320.0 | 140.8 | 0.439 |
| 6.60 | 6.20 | 0.850 | 0.932 | 0.837 | 0.922 | type4 | 292.0 | | 0.533 |
| 7.00 | 6.20 | 1.064 | 0.145 | 1.101 | 0.032 | type4 | 132.0 | | 0.109 |
| 7.40 | 6.20 | 1.303 | 0.167 | 1.320 | 0.124 | type1 | 160.0 | | 0.126 |
| 7.80 | 6.20 | 1.492 | 0.188 | 1.492 | 0.196 | type1 | 168.0 | | 0.139 |
| 8.20 | 6.20 | 1.582 | 0.204 | 1.617 | 0.249 | typed | 152.0 | | 0.144 |
| 8.60 | 6.20 | 1.690 | 0.217 | 1.692 | 0.280 | type4 | 156.0 | | 0.152 |
| 9.00 | 6.20 | 1.690 | 0.217 | 1.717 | 0.290 | type4 | 156.0 | | 0.152 |
| 9.40 | 6.20 | 1.690 | 0.217 | 1.692 | 0.280 | type4 | 156.0 | | 0.152 |
| 9.80 | 6.20 | 1.582 | 0.204 | 1.617 | 0.249 | type4 | 152.0 | | 0.144 |
| 10.20 | 6.20 | 1.492 | 0.188 | 1.492 | 0.196 | type1 | 168.0 | | 0.139 |
| 10.60 | 6.20 | 1.303 | 0.167 | 1.320 | 0.124 | type1 | 160.0 | | 0.126 |
| 11.00 | 6.20 | 1.064 | 0.145 | 1.101 | 0.032 | type4 | 132.0 | | 0.109 |
| 11.40 | 6.20 | 0.850 | 0.932 | 0.837 | 0.922 | type4 | 292.0 | | 0.533 |
| 11.80 | 6.20 | 0.547 | 0.771 | 0.531 | 0.793 | type5 | 320.0 | 140.8 | 0.439 |
| 12.20 | 6.20 | 0.938 | 0.343 | 0.837 | 0.486 | type 1 " | 78.7 | | 0.273 |
| 6.60 | 6.60 | 1.348 | 0.600 | 1.149 | 0.754 | type4 | 376.0 | | 0.884 |
| 7.00 | 6.60 | 1.348 | 0.600 | 1.418 | 0.862 | type4 | 376.0 | | 0.884 |
| 7.40 | 6.60 | 1.589 | 0.199 | 1.642 | 0.952 | type1 | 172.0 | | 0.145 |
| 7.80 | 6.60 | 1.784 | 0.222 | 1.818 | 0.022 | type1 | 180.0 | | 0.159 |
| 8.20 | 6.60 | 1.882 | 0.235 | 1.945 | 0.073 | type1 | 184.0 | | 0.166 |
| 8.60 | 6.60 | 1.980 | 0.247 | 2.021 | 0.104 | type1 | 188.0 | | 0.173 |
| 9.00 | 6.60 | 1.980 | 0.247 | 2.047 | 0.114 | type 1 | 188.0 | | 0.173 |
| 9.40 | 6.60 | 1.980 | 0.247 | 2.021 | 0.104 | type1 | 188.0 | | 0.173 |
| 9.80 | 6.60 | 1.882 | 0.235 | 1.945 | 0.073 | type1 | 184.0 | | 0.166 |
| 10.20 | 6.60 | 1.784 | 0.222 | 1.818 | 0.022 | type1 | 180.0 | | 0.159 |
| 10.60 | 6.60 | 1.589 | 0.199 | 1.642 | 0.952 | type1 | 172.0 | | 0.145 |
| 11.00 | 6.60 | 1.348 | 0.600 | 1.418 | 0.862 | type4 | 376.0 | | 0.884 |
| 11.40 | 6.60 | 1.348 | 0.600 | 1.149 | 0.754 | type4 | 376.0 | | 0.884 |
| 11.80 | 6.60 | 0.652 | 0.711 | 0.837 | 0.628 | type1 | 292.0 | | 0.419 |
| 12.20 | 6.60 | 1.099 | 0.311 | 1.101 | 0.309 | type4 | 344.0 | | 0.740 |
| 12.60 | 6.60 | 1.397 | 0.177 | 1.418 | 0.154 | type1 | 164.0 | | 0.132 |
| 7.00 | 7.00 | 1.738 | 0.626 | 1.692 | 0.676 | type1" | 101.3 | | 0.454 |
| 7.40 | 7.00 | 1.970 | 0.711 | 1.919 | 0.764 | type1" | 106.7 | | 0.503 |
| 7.80 | 7.00 | 2.155 | 0.782 | 2.098 | 0.832 | type1" | 110.7 | | 0.541 |
| 8.20 | 7.00 | 2.219 | 0.807 | 2.228 | 0.882 | type1" | 112.0 | | 0.554 |
| 8.60 | 7.00 | 2.219 | 0.807 | 2.306 | 0.912 | type1" | 112.0 | | 0.554 |
| 9.00 | 7.00 | 2.219 | 0.807 | 2.332 | 0.922 | type1" | 112.0 | | 0.554 |
| 9.40 | 7.00 | 2.219 | 0.807 | 2.306 | 0.912 | type1" | 112.0 | | 0.554 |
| 9.80 | 7.00 | 2.219 | 0.807 | 2.228 | 0.882 | type1" | 112.0 | | 0.554 |
| 10.20 | 7.00 | 2.155 | 0.782 | 2.098 | 0.832 | type1" | 110.7 | | 0.541 |
| 10.60 | 7.00 | 1.970 | 0.711 | 1.919 | 0.764 | type1" | 106.7 | | 0.503 |
| 11.00 | 7.00 | 1.738 | 0.626 | 1.692 | 0.676 | type1" | 101.3 | | 0.454 |
| 11.40 | 7.00 | 1.471 | 0.530 | 1.418 | 0.571 | type1" | 94.7 | | 0.396 |
| 11.80 | 7.00 | 1.142 | 0.415 | 1.101 | 0.448 | type1" | 85.3 | | 0.322 |
| 12.20 | 7.00 | 1.303 | 0.167 | 1.320 | 0.118 | type1 | 160.0 | | 0.126 |
| 12.60 | 7.00 | 1.589 | 0.199 | 1.642 | 0.966 | type1 | 172.0 | | 0.145 |
| 13.00 | 7.00 | 1.970 | 0.711 | 1.919 | 0.800 | type1" | 106.7 | | 0.503 |
| 7.40 | 7.40 | 2.086 | 0.629 | 2.150 | 0.561 | type1' | 150.0 | | 0.442 |
| 7.80 | 7.40 | 2.361 | 0.614 | 2.332 | 0.628 | type2 | 320.0 | 80.0 | 0.377 |
| 8.20 | 7.40 | 2.482 | 0.674 | 2.463 | 0.676 | type2 | 340.0 | 80.0 | 0.408 |
| 8.60 | 7.40 | 2.532 | 0.699 | 2.542 | 0.705 | type2 | 348.0 | 80.0 | 0.421 |
| 9.00 | 7.40 | 2.556 | 0.713 | 2.569 | 0.715 | type2 | 352.0 | 80.0 | 0.427 |
| 9.40 | 7.40 | 2.532 | 0.699 | 2.542 | 0.705 | type2 | 348.0 | 80.0 | 0.421 |
| 9.80 | 7.40 | 2.482 | 0.674 | 2.463 | 0.676 | type2 | 340.0 | 80.0 | 0.408 |
| 10.20 | 7.40 | 2.361 | 0.614 | 2.332 | 0.628 | type2 | 320.0 | 80.0 | 0.377 |
| 10.60 | 7.40 | 2.086 | 0.629 | 2.150 | 0.561 | type1' | 150.0 | | 0.442 |
| 11.00 | 7.40 | 1.843 | 0.551 | 1.919 | 0.476 | type1' | 142.0 | | 0.396 |
| 11.40 | 7.40 | 1.608 | 0.480 | 1.642 | 0.373 | type1' | 134.0 | | 0.353 |
| 11.80 | 7.40 | 1.370 | 0.179 | 1.320 | 0.254 | type4 | 144.0 | | 0.130 |
| 12.20 | 7.40 | 1.397 | 0.177 | 1.492 | 0.914 | type1 | 164.0 | | 0.132 |
| 12.60 | 7.40 | 1.910 | 0.689 | 1.818 | 0.766 | type1" | 105.3 | | 0.490 |
| 13.00 | 7.40 | 2.086 | 0.629 | 2.098 | 0.604 | type1' | 150.0 | | 0.442 |
| 13.40 | 7.40 | 2.281 | 0.420 | 2.332 | 0.428 | type2 | 252.0 | 80.0 | 0.270 |

| Cx | Cy | PM1 | PM2 | PD1 | PD2 | type | W | W' | FF |
|---|---|---|---|---|---|---|---|---|---|
| 7.80 | 7.80 | 2.487 | 0.419 | 2.516 | 0.411 | type2 | 244.0 | 88.0 | 0.270 |
| 8.20 | 7.80 | 2.668 | 0.450 | 2.649 | 0.457 | type2 | 248.0 | 96.0 | 0.287 |
| 8.60 | 7.80 | 2.710 | 0.513 | 2.729 | 0.486 | type5 | 300.0 | 96.0 | 0.302 |
| 9.00 | 7.80 | 2.767 | 0.527 | 2.756 | 0.495 | type5 | 300.0 | 99.0 | 0.310 |
| 9.40 | 7.80 | 2.710 | 0.513 | 2.729 | 0.486 | type5 | 300.0 | 96.0 | 0.302 |
| 9.80 | 7.80 | 2.668 | 0.450 | 2.649 | 0.457 | type2 | 248.0 | 96.0 | 0.287 |
| 10.20 | 7.80 | 2.487 | 0.419 | 2.516 | 0.411 | type2 | 244.0 | 88.0 | 0.270 |
| 10.60 | 7.80 | 2.323 | 0.341 | 2.332 | 0.346 | type5 | 240.0 | 88.8 | 0.217 |
| 11.00 | 7.80 | 2.112 | 0.271 | 2.098 | 0.263 | type5 | 200.0 | 96.0 | 0.182 |
| 11.40 | 7.80 | 1.784 | 0.222 | 1.818 | 0.163 | type1 | 180.0 | | 0.159 |
| 11.80 | 7.80 | 1.492 | 0.188 | 1.492 | 0.046 | type1 | 168.0 | | 0.139 |
| 12.20 | 7.80 | 1.682 | 0.606 | 1.617 | 0.697 | type 1 | 100.0 | | 0.442 |
| 12.60 | 7.80 | 1.904 | 0.570 | 1.945 | 0.553 | type1' | 144.0 | | 0.407 |
| 13.00 | 7.80 | 2.279 | 0.386 | 2.228 | 0.395 | type2 | 240.0 | 80.0 | 0.251 |
| 13.40 | 7.80 | 2.454 | 0.316 | 2.463 | 0.223 | type 1 | 208.0 | | 0.212 |
| 13.80 | 7.80 | 2.763 | 0.889 | 2.649 | 0.039 | type1' | 172.0 | | 0.581 |
| 8.20 | 8.20 | 2.716 | 0.362 | 2.783 | 0.226 | type1 | 220.0 | | 0.238 |
| 8.60 | 8.20 | 2.797 | 0.378 | 2.864 | 0.254 | type1 | 224.0 | | 0.246 |
| 9.00 | 8.20 | 2.876 | 0.395 | 2.891 | 0.263 | type1 | 228.0 | | 0.255 |
| 9.40 | 8.20 | 2.797 | 0.378 | 2.864 | 0.254 | type1 | 224.0 | | 0.246 |
| 9.80 | 8.20 | 2.716 | 0.362 | 2.783 | 0.226 | type1 | 220.0 | | 0.238 |
| 10.20 | 8.20 | 2.631 | 0.346 | 2.649 | 0.181 | type 1 | 216.0 | | 0.229 |
| 10.60 | 8.20 | 2.362 | 0.301 | 2.463 | 0.118 | type1 | 204.0 | | 0.204 |
| 11.00 | 8.20 | 2.219 | 0.807 | 2.228 | 0.037 | type1" | 112.0 | | 0.554 |
| 11.40 | 8.20 | 2.092 | 0.758 | 1.945 | 0.940 | type1" | 109.3 | | 0.528 |
| 11.80 | 8.20 | 1.738 | 0.626 | 1.617 | 0.826 | type1" | 101.3 | | 0.454 |
| 12.20 | 8.20 | 1.666 | 0.497 | 1.692 | 0.470 | type1' | 136.0 | | 0.363 |
| 12.60 | 8.20 | 2.029 | 0.272 | 2.021 | 0.329 | type2 | 200.0 | 80.0 | 0.188 |
| 13.00 | 8.20 | 2.268 | 0.287 | 2.306 | 0.175 | type1 | 200.0 | | 0.196 |
| 13.40 | 8.20 | 2.701 | 0.862 | 2.542 | 0.008 | type1' | 170.0 | | 0.567 |
| 13.80 | 8.20 | 2.693 | 0.800 | 2.729 | 0.828 | type2 | 376.0 | 80.0 | 0.465 |
| 14.20 | 8.20 | 2.857 | 0.631 | 2.864 | 0.636 | type2 | 292.0 | 104.0 | 0.384 |
| 8.60 | 8.60 | 2.950 | 0.975 | 2.945 | 0.011 | type1' | 178.0 | | 0.622 |
| 9.00 | 8.60 | 0.000 | 0.007 | 2.973 | 0.019 | type1 | 52.0 | | 0.013 |
| 9.40 | 8.60 | 2.950 | 0.975 | 2.945 | 0.011 | type1' | 178.0 | | 0.622 |
| 9.80 | 8.60 | 2.887 | 0.945 | 2.864 | 0.984 | type1' | 176.0 | | 0.608 |
| 10.20 | 8.60 | 2.763 | 0.889 | 2.729 | 0.940 | type1' | 172.0 | | 0.581 |
| 10.60 | 8.60 | 2.578 | 0.810 | 2.542 | 0.879 | type1' | 166.0 | | 0.541 |
| 11.00 | 8.60 | 2.219 | 0.807 | 2.306 | 0.800 | type1" | 112.0 | | 0.554 |
| 11.40 | 8.60 | 2.030 | 0.734 | 2.021 | 0.706 | type1" | 108.0 | | 0.515 |
| 11.80 | 8.60 | 1.682 | 0.606 | 1.692 | 0.595 | type1" | 100.0 | | 0.442 |
| 12.20 | 8.60 | 1.690 | 0.217 | 1.717 | 0.232 | type4 | 156.0 | | 0.152 |
| 12.60 | 8.60 | 1.980 | 0.247 | 2.047 | 0.095 | type1 | 188.0 | | 0.173 |
| 13.00 | 8.60 | 2.219 | 0.807 | 2.332 | 0.945 | type1" | 112.0 | | 0.554 |
| 13.40 | 8.60 | 2.578 | 0.810 | 2.569 | 0.781 | type1' | 166.0 | | 0.541 |
| 13.80 | 8.60 | 2.693 | 0.615 | 2.756 | 0.605 | type2 | 296.0 | 96.0 | 0.377 |
| 14.20 | 8.60 | 2.876 | 0.412 | 2.891 | 0.418 | type4 | 204.0 | | 0.260 |
| 14.60 | 8.60 | 2.876 | 0.395 | 2.973 | 0.220 | type1 | 228.0 | | 0.255 |
| 9.00 | 9.00 | 2.962 | 0.791 | 0.000 | 0.766 | type2 | 336.0 | 104.0 | 0.474 |
| 9.40 | 9.00 | 2.946 | 0.776 | 2.973 | 0.757 | type2 | 332.0 | 104.0 | 0.466 |
| 9.80 | 9.00 | 2.906 | 0.732 | 2.891 | 0.731 | type2 | 320.0 | 104.0 | 0.441 |
| 10.20 | 9.00 | 2.747 | 0.695 | 2.756 | 0.689 | type2 | 320.0 | 96.0 | 0.422 |
| 10.60 | 9.00 | 2.552 | 0.643 | 2.569 | 0.629 | type2 | 316.0 | 88.0 | 0.394 |
| 11.00 | 9.00 | 2.305 | 0.579 | 2.332 | 0.553 | type2 | 308.0 | 80.0 | 0.358 |
| 11.40 | 9.00 | 1.964 | 0.589 | 2.047 | 0.461 | type1' | 146.0 | | 0.419 |
| 11.80 | 9.00 | 1.794 | 0.234 | 1.717 | 0.354 | type5 | 200.0 | 80.0 | 0.160 |
| 12.20 | 9.00 | 1.666 | 0.497 | 1.692 | 0.470 | type1' | 136.0 | | 0.363 |
| 12.60 | 9.00 | 2.029 | 0.272 | 2.021 | 0.329 | type2 | 200.0 | 80.0 | 0.188 |
| 13.00 | 9.00 | 2.268 | 0.287 | 2.306 | 0.175 | type1 | 200.0 | | 0.196 |
| 13.40 | 9.00 | 2.701 | 0.862 | 2.542 | 0.008 | type1' | 170.0 | | 0.567 |
| 13.80 | 9.00 | 2.693 | 0.800 | 2.729 | 0.828 | type2 | 376.0 | 80.0 | 0.465 |
| 14.20 | 9.00 | 2.857 | 0.631 | 2.864 | 0.636 | type2 | 292.0 | 104.0 | 0.384 |
| 14.60 | 9.00 | 2.957 | 0.431 | 2.945 | 0.433 | type4 | 208.0 | | 0.270 |
| 15.00 | 9.00 | 2.876 | 0.395 | 2.973 | 0.220 | type1 | 228.0 | | 0.255 |

### NUMERICAL EXAMPLE 6

| Cx | Cy | PM1 | PM2 | PD1 | PD2 | type | W | W' | FF |
|---|---|---|---|---|---|---|---|---|---|
| 1.44 | 1.44 | 0.045 | 0.222 | 1.972 | 0.264 | type1" | 89.6 | | 0.554 |
| 1.76 | 1.44 | 1.796 | 0.657 | 1.860 | 0.631 | type1 | 243.2 | | 0.454 |
| 2.08 | 1.44 | 1.620 | 0.969 | 1.644 | 0.971 | type1" | 82.1 | | 0.466 |
| 2.40 | 1.44 | 1.371 | 0.241 | 1.338 | 0.277 | type5 | 224.0 | 103.0 | 0.347 |
| 2.72 | 1.44 | 1.371 | 0.503 | 1.338 | 0.542 | type3 | 284.8 | | 0.378 |
| 3.04 | 1.44 | 1.622 | 0.765 | 1.644 | 0.754 | type3 | 268.8 | | 0.446 |
| 3.36 | 1.44 | 1.879 | 0.901 | 1.860 | 0.903 | type5 | 256.0 | 151.0 | 0.532 |
| 3.68 | 1.44 | 1.956 | 0.978 | 1.972 | 0.980 | type1 | 272.0 | | 0.567 |
| 1.44 | 1.76 | 1.917 | 0.145 | 1.860 | 0.214 | type1" | 87.5 | | 0.528 |
| 1.76 | 1.76 | 1.750 | 0.578 | 1.751 | 0.577 | type1 | 236.8 | | 0.430 |
| 2.08 | 1.76 | 1.510 | 0.906 | 1.540 | 0.912 | type1" | 80.0 | | 0.442 |
| 2.40 | 1.76 | 1.279 | 0.194 | 1.240 | 0.214 | type5 | 224.0 | 98.6 | 0.336 |
| 2.72 | 1.76 | 1.334 | 0.423 | 1.240 | 0.474 | type5 | 256.0 | 99.8 | 0.402 |
| 3.04 | 1.76 | 1.529 | 0.667 | 1.540 | 0.682 | type3 | 275.2 | | 0.419 |
| 3.36 | 1.76 | 1.707 | 0.856 | 1.751 | 0.828 | type3 | 262.4 | | 0.472 |
| 3.68 | 1.76 | 1.879 | 0.901 | 1.860 | 0.903 | type5 | 256.0 | 151.0 | 0.532 |
| 1.44 | 2.08 | 1.735 | 0.036 | 1.644 | 0.116 | type1" | 84.3 | | 0.490 |
| 1.76 | 2.08 | 1.578 | 0.437 | 1.540 | 0.470 | type4 | 201.6 | | 0.397 |
| 2.08 | 2.08 | 1.354 | 0.816 | 1.338 | 0.797 | type1" | 76.8 | | 0.407 |
| 2.40 | 2.08 | 1.062 | 0.094 | 1.049 | 0.091 | type5 | 224.0 | 89.6 | 0.314 |
| 2.72 | 2.08 | 1.054 | 0.297 | 1.049 | 0.342 | type4 | 112.0 | | 0.123 |
| 3.04 | 2.08 | 1.371 | 0.503 | 1.338 | 0.542 | type3 | 284.8 | | 0.378 |
| 3.36 | 2.08 | 1.529 | 0.667 | 1.540 | 0.682 | type3 | 275.2 | | 0.419 |
| 3.68 | 2.08 | 1.622 | 0.765 | 1.644 | 0.754 | type3 | 268.8 | | 0.446 |
| 1.44 | 2.40 | 1.222 | 0.056 | 1.338 | 0.971 | type1 | 198.4 | | 0.302 |
| 1.76 | 2.40 | 1.206 | 0.320 | 1.240 | 0.315 | type1 | 131.2 | | 0.132 |
| 2.08 | 2.40 | 1.033 | 0.633 | 1.049 | 0.631 | type1" | 69.3 | | 0.332 |
| 2.40 | 2.40 | 0.753 | 0.912 | 0.775 | 0.912 | type5 | 192.0 | 96.0 | 0.270 |
| 2.72 | 2.40 | 0.717 | 0.157 | 0.775 | 0.152 | type2 | 230.4 | 76.8 | 0.362 |
| 3.04 | 2.40 | 1.054 | 0.297 | 1.049 | 0.342 | type4 | 112.0 | | 0.123 |
| 3.36 | 2.40 | 1.334 | 0.423 | 1.240 | 0.474 | type5 | 256.0 | 99.8 | 0.402 |
| 3.68 | 2.40 | 1.371 | 0.503 | 1.338 | 0.542 | type3 | 284.8 | | 0.378 |
| 1.44 | 2.72 | 1.304 | 0.788 | 1.338 | 0.785 | type1" | 75.7 | | 0.396 |
| 1.76 | 2.72 | 1.238 | 0.102 | 1.240 | 0.116 | type5 | 192.0 | 121.0 | 0.311 |
| 2.08 | 2.72 | 0.940 | 0.457 | 1.049 | 0.418 | type2 | 284.8 | 76.8 | 0.490 |
| 2.40 | 2.72 | 0.656 | 0.758 | 0.775 | 0.686 | type1 | 176.0 | | 0.238 |
| 2.72 | 2.72 | 0.753 | 0.912 | 0.775 | 0.912 | type5 | 192.0 | 96.0 | 0.270 |
| 3.04 | 2.72 | 1.062 | 0.094 | 1.049 | 0.091 | type5 | 224.0 | 89.6 | 0.314 |
| 3.36 | 2.72 | 1.279 | 0.194 | 1.240 | 0.214 | type5 | 224.0 | 98.6 | 0.336 |
| 3.68 | 2.72 | 1.371 | 0.241 | 1.338 | 0.277 | type5 | 224.0 | 103.0 | 0.347 |
| 1.44 | 3.04 | 1.677 | 0.578 | 1.644 | 0.560 | type4 | 211.2 | | 0.436 |
| 1.76 | 3.04 | 1.510 | 0.906 | 1.540 | 0.877 | type1" | 80.0 | | 0.442 |
| 2.08 | 3.04 | 1.348 | 0.145 | 1.338 | 0.165 | type1 | 204.8 | | 0.322 |
| 2.40 | 3.04 | 0.940 | 0.457 | 1.049 | 0.418 | type2 | 284.8 | 76.8 | 0.490 |
| 2.72 | 3.04 | 1.033 | 0.633 | 1.049 | 0.631 | type1" | 69.3 | | 0.332 |
| 3.04 | 3.04 | 1.354 | 0.816 | 1.338 | 0.797 | type1" | 76.8 | | 0.407 |
| 3.36 | 3.04 | 1.510 | 0.906 | 1.540 | 0.912 | type1" | 80.0 | | 0.442 |
| 3.68 | 3.04 | 1.620 | 0.969 | 1.644 | 0.971 | type1" | 82.1 | | 0.466 |
| 1.44 | 3.36 | 1.980 | 0.183 | 1.860 | 0.303 | type1" | 88.5 | | 0.541 |
| 1.76 | 3.36 | 1.721 | 0.607 | 1.751 | 0.605 | type5 | 224.0 | 152.3 | 0.440 |
| 2.08 | 3.36 | 1.510 | 0.906 | 1.540 | 0.877 | type1" | 80.0 | | 0.442 |
| 2.40 | 3.36 | 1.238 | 0.102 | 1.240 | 0.116 | type5 | 192.0 | 121.0 | 0.311 |
| 2.72 | 3.36 | 1.206 | 0.320 | 1.240 | 0.315 | type1 | 131.2 | | 0.132 |
| 3.04 | 3.36 | 1.578 | 0.437 | 1.540 | 0.470 | type4 | 201.6 | | 0.397 |
| 3.36 | 3.36 | 1.750 | 0.578 | 1.751 | 0.577 | type1 | 236.8 | | 0.430 |
| 3.68 | 3.36 | 1.796 | 0.657 | 1.860 | 0.631 | type1 | 243.2 | | 0.454 |
| 1.44 | 3.68 | 1.974 | 0.011 | 1.972 | 0.016 | type1 | 275.2 | | 0.581 |
| 1.76 | 3.68 | 1.980 | 0.183 | 1.860 | 0.303 | type1" | 88.5 | | 0.541 |
| 2.08 | 3.68 | 1.677 | 0.578 | 1.644 | 0.560 | type4 | 211.2 | | 0.436 |
| 2.40 | 3.68 | 1.304 | 0.788 | 1.338 | 0.785 | type1" | 75.7 | | 0.396 |
| 2.72 | 3.68 | 1.222 | 0.056 | 1.338 | 0.971 | type1 | 198.4 | | 0.302 |
| 3.04 | 3.68 | 1.735 | 0.036 | 1.644 | 0.116 | type1" | 84.3 | | 0.490 |
| 3.36 | 3.68 | 1.917 | 0.145 | 1.860 | 0.214 | type1" | 87.5 | | 0.528 |
| 3.68 | 3.68 | 0.045 | 0.222 | 1.972 | 0.264 | type1" | 89.6 | | 0.554 |

### NUMERICAL EXAMPLE 7

| Cx | Cy | PM1 | PM2 | PD1 | PD2 | type | W | W' | FF |
|---|---|---|---|---|---|---|---|---|---|
| 2.72 | 0.16 | 0.412 | 0.267 | 0.429 | 0.225 | type5 | 160.0 | 99.2 | 0.214 |
| 3.04 | 0.16 | 0.089 | 0.267 | 0.022 | 0.343 | type5 | 192.0 | 65.3 | 0.203 |
| 3.36 | 0.16 | 1.739 | 0.488 | 1.748 | 0.424 | type1' | 115.2 | | 0.407 |
| 3.68 | 0.16 | 0.300 | 0.464 | 0.288 | 0.466 | type2 | 233.6 | 64.0 | 0.333 |
| 4.00 | 0.16 | 0.815 | 0.487 | 0.800 | 0.466 | type5 | 256.0 | 76.8 | 0.326 |
| 4.32 | 0.16 | 1.272 | 0.428 | 1.278 | 0.424 | type5 | 192.0 | 122.9 | 0.313 |
| 4.64 | 0.16 | 1.677 | 0.471 | 1.715 | 0.343 | type1' | 113.6 | | 0.396 |
| 4.96 | 0.16 | 0.087 | 0.234 | 0.101 | 0.225 | type5 | 160.0 | 81.6 | 0.190 |
| 2.72 | 0.48 | 0.682 | 0.351 | 0.687 | 0.343 | type5 | 192.0 | 92.2 | 0.263 |
| 3.04 | 0.48 | 0.300 | 0.464 | 0.263 | 0.466 | type2 | 233.6 | 64.0 | 0.333 |
| 3.36 | 0.48 | 1.802 | 0.505 | 1.790 | 0.553 | type1' | 116.8 | | 0.419 |
| 3.68 | 0.48 | 1.994 | 0.559 | 1.984 | 0.598 | type1' | 121.6 | | 0.454 |
| 4.00 | 0.48 | 0.470 | 0.589 | 0.476 | 0.598 | type2 | 268.8 | 64.0 | 0.402 |
| 4.32 | 0.48 | 0.945 | 0.515 | 0.933 | 0.553 | type5 | 256.0 | 81.9 | 0.344 |
| 4.64 | 0.48 | 1.342 | 0.466 | 1.349 | 0.466 | type4 | 185.6 | | 0.336 |
| 4.96 | 0.48 | 1.677 | 0.471 | 1.715 | 0.343 | type1' | 113.6 | | 0.396 |
| 2.72 | 0.80 | 0.873 | 0.419 | 0.865 | 0.424 | type5 | 224.0 | 82.9 | 0.296 |
| 3.04 | 0.80 | 0.425 | 0.566 | 0.429 | 0.553 | type2 | 262.4 | 64.0 | 0.390 |
| 3.36 | 0.80 | 1.917 | 0.658 | 1.944 | 0.643 | type1" | 87.5 | | 0.528 |
| 3.68 | 0.80 | 1.427 | 0.719 | 1.421 | 0.690 | type3 | 281.6 | | 0.392 |
| 4.00 | 0.80 | 0.045 | 0.703 | 0.104 | 0.690 | type1" | 89.6 | | 0.554 |
| 4.32 | 0.80 | 0.562 | 0.640 | 0.540 | 0.643 | type2 | 281.6 | 64.0 | 0.427 |
| 4.64 | 0.80 | 0.945 | 0.515 | 0.933 | 0.553 | type5 | 256.0 | 81.9 | 0.344 |
| 4.96 | 0.80 | 1.272 | 0.428 | 1.278 | 0.424 | type5 | 192.0 | 122.9 | 0.313 |
| 2.72 | 1.12 | 0.938 | 0.428 | 0.956 | 0.466 | type5 | 224.0 | 85.1 | 0.302 |
| 3.04 | 1.12 | 0.493 | 0.602 | 0.513 | 0.598 | type2 | 272.0 | 64.0 | 0.408 |
| 3.36 | 1.12 | 0.045 | 0.703 | 0.022 | 0.690 | type1" | 89.6 | | 0.554 |
| 3.68 | 1.12 | 1.479 | 0.748 | 1.493 | 0.738 | type3 | 278.4 | | 0.406 |
| 4.00 | 1.12 | 1.715 | 0.722 | 1.690 | 0.738 | type5 | 256.0 | 125.4 | 0.474 |
| 4.32 | 1.12 | 0.045 | 0.703 | 0.104 | 0.690 | type1" | 89.6 | | 0.554 |
| 4.64 | 1.12 | 0.470 | 0.589 | 0.476 | 0.598 | type2 | 268.8 | 64.0 | 0.402 |
| 4.96 | 1.12 | 0.815 | 0.487 | 0.800 | 0.466 | type5 | 256.0 | 76.8 | 0.326 |
| 1.44 | 1.44 | 1.980 | 0.680 | 1.972 | 0.676 | type1" | 88.5 | | 0.541 |
| 1.76 | 1.44 | 1.907 | 0.898 | 1.860 | 0.902 | type5 | 256.0 | 179.2 | 0.582 |
| 2.08 | 1.44 | 1.622 | 0.182 | 1.644 | 0.113 | type1 | 144.0 | | 0.159 |
| 2.40 | 1.44 | 1.324 | 0.379 | 1.338 | 0.303 | type1' | 104.0 | | 0.332 |
| 2.72 | 1.44 | 0.938 | 0.428 | 0.956 | 0.466 | type5 | 224.0 | 85.1 | 0.302 |
| 3.04 | 1.44 | 0.493 | 0.602 | 0.513 | 0.598 | type2 | 272.0 | 64.0 | 0.408 |
| 3.36 | 1.44 | 0.045 | 0.703 | 0.022 | 0.690 | type1" | 89.6 | | 0.554 |
| 3.68 | 1.44 | 1.479 | 0.748 | 1.493 | 0.738 | type3 | 278.4 | | 0.406 |
| 4.00 | 1.44 | 1.479 | 0.748 | 1.493 | 0.738 | type3 | 278.4 | | 0.406 |
| 4.32 | 1.44 | 1.427 | 0.719 | 1.421 | 0.690 | type3 | 281.6 | | 0.392 |
| 4.64 | 1.44 | 1.994 | 0.559 | 1.984 | 0.598 | type1' | 121.6 | | 0.454 |
| 4.96 | 1.44 | 0.300 | 0.464 | 0.288 | 0.466 | type2 | 233.6 | 64.0 | 0.333 |
| 1.44 | 1.76 | 1.855 | 0.637 | 1.860 | 0.645 | type1" | 86.4 | | 0.515 |
| 1.76 | 1.76 | 1.707 | 0.885 | 1.751 | 0.869 | type3 | 262.4 | | 0.472 |
| 2.08 | 1.76 | 1.516 | 0.172 | 1.540 | 0.077 | type1 | 140.8 | | 0.152 |
| 2.40 | 1.76 | 1.216 | 0.351 | 1.240 | 0.264 | type1' | 100.8 | | 0.312 |
| 2.72 | 1.76 | 0.873 | 0.419 | 0.865 | 0.424 | type5 | 224.0 | 82.9 | 0.296 |
| 3.04 | 1.76 | 0.425 | 0.566 | 0.429 | 0.553 | type2 | 262.4 | 64.0 | 0.390 |
| 3.36 | 1.76 | 1.917 | 0.658 | 1.944 | 0.643 | type1" | 87.5 | | 0.528 |
| 3.68 | 1.76 | 0.045 | 0.703 | 0.022 | 0.690 | type1" | 89.6 | | 0.554 |
| 4.00 | 1.76 | 0.045 | 0.703 | 0.022 | 0.690 | type1" | 89.6 | | 0.554 |
| 4.32 | 1.76 | 1.917 | 0.658 | 1.944 | 0.643 | type1" | 87.5 | | 0.528 |
| 4.64 | 1.76 | 1.802 | 0.505 | 1.790 | 0.553 | type1' | 116.8 | | 0.419 |
| 4.96 | 1.76 | 1.739 | 0.488 | 1.748 | 0.424 | type1' | 115.2 | | 0.407 |

| Cx | Cy | PM1 | PM2 | PD1 | PD2 | type | W | W' | FF |
|---|---|---|---|---|---|---|---|---|---|
| 1.44 | 2.08 | 1.656 | 0.572 | 1.644 | 0.583 | type5 | 224.0 | 125.4 | 0.395 |
| 1.76 | 2.08 | 1.577 | 0.804 | 1.540 | 0.803 | type3 | 272.0 | | 0.433 |
| 2.08 | 2.08 | 1.307 | 0.154 | 1.338 | 0.006 | type1 | 134.4 | | 0.139 |
| 2.40 | 2.08 | 1.054 | 0.138 | 1.049 | 0.187 | type4 | 112.0 | | 0.123 |
| 2.72 | 2.08 | 0.682 | 0.351 | 0.687 | 0.343 | type5 | 192.0 | 92.2 | 0.263 |
| 3.04 | 2.08 | 0.300 | 0.464 | 0.263 | 0.466 | type2 | 233.6 | 64.0 | 0.333 |
| 3.36 | 2.08 | 0.425 | 0.566 | 0.429 | 0.553 | type2 | 262.4 | 64.0 | 0.390 |
| 3.68 | 2.08 | 0.493 | 0.602 | 0.513 | 0.598 | type2 | 272.0 | 64.0 | 0.408 |
| 4.00 | 2.08 | 0.493 | 0.602 | 0.513 | 0.598 | type2 | 272.0 | 64.0 | 0.408 |
| 4.32 | 2.08 | 0.425 | 0.566 | 0.429 | 0.553 | type2 | 262.4 | 64.0 | 0.390 |
| 4.64 | 2.08 | 0.300 | 0.464 | 0.263 | 0.466 | type2 | 233.6 | 64.0 | 0.333 |
| 4.96 | 2.08 | 0.089 | 0.267 | 0.022 | 0.343 | type5 | 192.0 | 65.3 | 0.203 |
| 1.44 | 2.40 | 1.326 | 0.488 | 1.338 | 0.494 | type5 | 224.0 | 100.8 | 0.342 |
| 1.76 | 2.40 | 1.371 | 0.690 | 1.240 | 0.707 | type3 | 284.8 | | 0.378 |
| 2.08 | 2.40 | 1.048 | 0.844 | 1.049 | 0.902 | type2 | 304.0 | 76.8 | 0.535 |
| 2.40 | 2.40 | 0.757 | 0.110 | 0.775 | 0.077 | type4 | 102.4 | | 0.102 |
| 2.72 | 2.40 | 0.412 | 0.267 | 0.429 | 0.225 | type5 | 160.0 | 99.2 | 0.214 |
| 3.04 | 2.40 | 0.682 | 0.351 | 0.687 | 0.343 | type5 | 192.0 | 92.2 | 0.263 |
| 3.36 | 2.40 | 0.873 | 0.419 | 0.865 | 0.424 | type5 | 224.0 | 82.9 | 0.296 |
| 3.68 | 2.40 | 0.938 | 0.428 | 0.956 | 0.466 | type5 | 224.0 | 85.1 | 0.302 |
| 4.00 | 2.40 | 0.938 | 0.428 | 0.956 | 0.466 | type5 | 224.0 | 85.1 | 0.302 |
| 4.32 | 2.40 | 0.873 | 0.419 | 0.865 | 0.424 | type5 | 224.0 | 82.9 | 0.296 |
| 4.64 | 2.40 | 0.682 | 0.351 | 0.687 | 0.343 | type5 | 192.0 | 92.2 | 0.263 |
| 4.96 | 2.40 | 0.412 | 0.267 | 0.429 | 0.225 | type5 | 160.0 | 99.2 | 0.214 |
| 1.44 | 2.72 | 1.324 | 0.379 | 1.338 | 0.379 | type1' | 104.0 | | 0.332 |
| 1.76 | 2.72 | 1.233 | 0.581 | 1.240 | 0.583 | type5 | 256.0 | 94.7 | 0.386 |
| 2.08 | 2.72 | 0.987 | 0.788 | 1.049 | 0.771 | type2 | 294.4 | 76.8 | 0.513 |
| 2.40 | 2.72 | 0.849 | 0.856 | 0.775 | 0.936 | type1' | 142.4 | | 0.622 |
| 2.72 | 2.72 | 0.757 | 0.110 | 0.775 | 0.077 | type4 | 102.4 | | 0.102 |
| 3.04 | 2.72 | 1.054 | 0.138 | 1.049 | 0.187 | type4 | 112.0 | | 0.123 |
| 3.36 | 2.72 | 1.216 | 0.351 | 1.240 | 0.264 | type1' | 100.8 | | 0.312 |
| 3.68 | 2.72 | 1.324 | 0.379 | 1.338 | 0.303 | type1' | 104.0 | | 0.332 |
| 1.44 | 3.04 | 1.652 | 0.199 | 1.644 | 0.240 | type5 | 160.0 | 65.6 | 0.163 |
| 1.76 | 3.04 | 1.555 | 0.439 | 1.540 | 0.436 | type1' | 110.4 | | 0.374 |
| 2.08 | 3.04 | 1.334 | 0.606 | 1.338 | 0.614 | type5 | 256.0 | 99.8 | 0.402 |
| 2.40 | 3.04 | 0.987 | 0.788 | 1.049 | 0.771 | type2 | 294.4 | 76.8 | 0.513 |
| 2.72 | 3.04 | 1.048 | 0.844 | 1.049 | 0.902 | type2 | 304.0 | 76.8 | 0.535 |
| 3.04 | 3.04 | 1.307 | 0.154 | 1.338 | 0.006 | type1 | 134.4 | | 0.139 |
| 3.36 | 3.04 | 1.516 | 0.172 | 1.540 | 0.077 | type1 | 140.8 | | 0.152 |
| 3.68 | 3.04 | 1.622 | 0.182 | 1.644 | 0.113 | type1 | 144.0 | | 0.159 |
| 1.44 | 3.36 | 1.930 | 0.032 | 1.860 | 0.080 | type3 | 243.2 | | 0.546 |
| 1.76 | 3.36 | 1.749 | 0.207 | 1.751 | 0.267 | type5 | 160.0 | 68.8 | 0.169 |
| 2.08 | 3.36 | 1.555 | 0.439 | 1.540 | 0.436 | type1' | 110.4 | | 0.374 |
| 2.40 | 3.36 | 1.233 | 0.581 | 1.240 | 0.583 | type5 | 256.0 | 94.7 | 0.386 |
| 2.72 | 3.36 | 1.371 | 0.690 | 1.240 | 0.707 | type3 | 284.8 | | 0.378 |
| 3.04 | 3.36 | 1.577 | 0.804 | 1.540 | 0.803 | type3 | 272.0 | | 0.433 |
| 3.36 | 3.36 | 1.707 | 0.885 | 1.751 | 0.869 | type3 | 262.4 | | 0.472 |
| 3.68 | 3.36 | 1.907 | 0.898 | 1.860 | 0.902 | type5 | 256.0 | 179.2 | 0.582 |
| 1.44 | 3.68 | 1.974 | 0.898 | 1.972 | 0.903 | type1 | 275.2 | | 0.581 |
| 1.76 | 3.68 | 1.930 | 0.032 | 1.860 | 0.080 | type3 | 243.2 | | 0.546 |
| 2.08 | 3.68 | 1.652 | 0.199 | 1.644 | 0.240 | type5 | 160.0 | 65.6 | 0.163 |
| 2.40 | 3.68 | 1.324 | 0.379 | 1.338 | 0.379 | type1' | 104.0 | | 0.332 |
| 2.72 | 3.68 | 1.326 | 0.488 | 1.338 | 0.494 | type5 | 224.0 | 100.8 | 0.342 |
| 3.04 | 3.68 | 1.656 | 0.572 | 1.644 | 0.583 | type5 | 224.0 | 125.4 | 0.395 |
| 3.36 | 3.68 | 1.855 | 0.637 | 1.860 | 0.645 | type1" | 86.4 | | 0.515 |
| 3.68 | 3.68 | 1.980 | 0.680 | 1.972 | 0.676 | type1" | 88.5 | | 0.541 |

### [Comparative example 1]

| Cx | Cy | PM1 | PM2 | PD1 | PD2 | type | W | W' | FF |
|---|---|---|---|---|---|---|---|---|---|
| 1.80 | 1.80 | 0.956 | 0.875 | 0.972 | 0.866 | type2 | 368.0 | 96.0 | 0.513 |
| 2.20 | 1.80 | 0.864 | 0.121 | 0.862 | 0.116 | type1 | 140.0 | | 0.096 |
| 2.60 | 1.80 | 0.631 | 0.346 | 0.648 | 0.344 | type1 | 216.0 | | 0.229 |
| 3.00 | 1.80 | 0.357 | 0.557 | 0.337 | 0.546 | type4 | 232.0 | | 0.336 |
| 3.40 | 1.80 | 0.332 | 0.715 | 0.337 | 0.716 | type1' | 158.0 | | 0.490 |
| 3.80 | 1.80 | 0.640 | 0.835 | 0.648 | 0.849 | type1' | 168.0 | | 0.554 |
| 4.20 | 1.80 | 0.850 | 0.932 | 0.862 | 0.941 | type4 | 292.0 | | 0.533 |
| 4.60 | 1.80 | 0.950 | 0.975 | 0.972 | 0.988 | type1' | 178.0 | | 0.622 |
| 1.80 | 2.20 | 0.883 | 0.810 | 0.862 | 0.831 | type2 | 352.0 | 96.0 | 0.483 |
| 2.20 | 2.20 | 0.785 | 0.113 | 0.754 | 0.079 | type1 | 136.0 | | 0.091 |
| 2.60 | 2.20 | 0.543 | 0.331 | 0.542 | 0.305 | type1 | 212.0 | | 0.221 |
| 3.00 | 2.20 | 0.230 | 0.498 | 0.236 | 0.505 | type5 | 240.0 | 146.4 | 0.305 |
| 3.40 | 2.20 | 0.209 | 0.671 | 0.236 | 0.672 | type1' | 154.0 | | 0.466 |
| 3.80 | 2.20 | 0.517 | 0.785 | 0.542 | 0.804 | type1' | 164.0 | | 0.528 |
| 4.20 | 2.20 | 0.755 | 0.892 | 0.754 | 0.895 | type5 | 320.0 | 172.8 | 0.505 |
| 4.60 | 2.20 | 0.850 | 0.932 | 0.862 | 0.941 | type4 | 292.0 | | 0.533 |
| 1.80 | 2.60 | 0.652 | 0.763 | 0.648 | 0.763 | type5 | 300.0 | 159.0 | 0.438 |
| 2.20 | 2.60 | 0.542 | 0.089 | 0.542 | 0.007 | type4 | 108.0 | | 0.073 |
| 2.60 | 2.60 | 0.370 | 0.179 | 0.337 | 0.229 | type4 | 144.0 | | 0.130 |
| 3.00 | 2.60 | 0.024 | 0.429 | 0.037 | 0.424 | type1 | 236.0 | | 0.273 |
| 3.40 | 2.60 | 0.032 | 0.594 | 0.037 | 0.587 | type5 | 300.0 | 114.0 | 0.346 |
| 3.80 | 2.60 | 0.332 | 0.715 | 0.337 | 0.716 | type1' | 158.0 | | 0.490 |
| 4.20 | 2.60 | 0.517 | 0.785 | 0.542 | 0.804 | type1' | 164.0 | | 0.528 |
| 4.60 | 2.60 | 0.640 | 0.835 | 0.648 | 0.849 | type1' | 168.0 | | 0.554 |
| 1.80 | 3.00 | 0.314 | 0.667 | 0.337 | 0.663 | type5 | 300.0 | 132.0 | 0.386 |
| 2.20 | 3.00 | 0.219 | 0.807 | 0.236 | 0.901 | type1" | 112.0 | | 0.554 |
| 2.60 | 3.00 | 0.032 | 0.138 | 0.037 | 0.116 | type1 | 148.0 | | 0.108 |
| 3.00 | 3.00 | 0.759 | 0.280 | 0.749 | 0.305 | type1" | 72.0 | | 0.229 |
| 3.40 | 3.00 | 0.756 | 0.421 | 0.749 | 0.464 | type5 | 240.0 | 115.2 | 0.263 |
| 3.80 | 3.00 | 0.032 | 0.594 | 0.037 | 0.587 | type5 | 300.0 | 114.0 | 0.346 |
| 4.20 | 3.00 | 0.209 | 0.671 | 0.236 | 0.672 | type1' | 154.0 | | 0.466 |
| 4.60 | 3.00 | 0.332 | 0.715 | 0.337 | 0.716 | type1' | 158.0 | | 0.490 |
| 1.80 | 3.40 | 0.329 | 0.521 | 0.337 | 0.532 | type1 | 256.0 | | 0.322 |
| 2.20 | 3.40 | 0.219 | 0.807 | 0.236 | 0.763 | type1" | 112.0 | | 0.554 |
| 2.60 | 3.40 | 0.004 | 0.003 | 0.037 | 0.971 | type4 | 40.0 | | 0.010 |
| 3.00 | 3.40 | 0.785 | 0.115 | 0.749 | 0.153 | type4 | 120.0 | | 0.090 |
| 3.40 | 3.40 | 0.759 | 0.280 | 0.749 | 0.305 | type1" | 72.0 | | 0.229 |
| 3.80 | 3.40 | 0.024 | 0.429 | 0.037 | 0.424 | type1 | 236.0 | | 0.273 |
| 4.20 | 3.40 | 0.230 | 0.498 | 0.236 | 0.505 | type5 | 240.0 | 146.4 | 0.305 |
| 4.60 | 3.40 | 0.357 | 0.557 | 0.337 | 0.546 | type4 | 232.0 | | 0.336 |
| 1.80 | 3.80 | 0.647 | 0.400 | 0.648 | 0.374 | type5 | 240.0 | 108.0 | 0.251 |
| 2.20 | 3.80 | 0.552 | 0.580 | 0.542 | 0.597 | type5 | 240.0 | 199.2 | 0.350 |
| 2.60 | 3.80 | 0.332 | 0.715 | 0.337 | 0.797 | type1' | 158.0 | | 0.490 |
| 3.00 | 3.80 | 0.004 | 0.003 | 0.037 | 0.971 | type4 | 40.0 | | 0.010 |
| 3.40 | 3.80 | 0.032 | 0.138 | 0.037 | 0.116 | type1 | 148.0 | | 0.108 |
| 3.80 | 3.80 | 0.370 | 0.179 | 0.337 | 0.229 | type4 | 144.0 | | 0.130 |
| 4.20 | 3.80 | 0.543 | 0.331 | 0.542 | 0.305 | type1 | 212.0 | | 0.221 |
| 4.60 | 3.80 | 0.631 | 0.346 | 0.648 | 0.344 | type1 | 216.0 | | 0.229 |
| 1.80 | 4.20 | 0.882 | 0.235 | 0.862 | 0.191 | type1 | 184.0 | | 0.166 |
| 2.20 | 4.20 | 0.756 | 0.421 | 0.754 | 0.405 | type5 | 240.0 | 115.2 | 0.263 |
| 2.60 | 4.20 | 0.552 | 0.580 | 0.542 | 0.597 | type5 | 240.0 | 199.2 | 0.350 |
| 3.00 | 4.20 | 0.219 | 0.807 | 0.236 | 0.763 | type1" | 112.0 | | 0.554 |
| 3.40 | 4.20 | 0.219 | 0.807 | 0.236 | 0.901 | type1" | 112.0 | | 0.554 |
| 3.80 | 4.20 | 0.542 | 0.089 | 0.542 | 0.007 | type4 | 108.0 | | 0.073 |
| 4.20 | 4.20 | 0.785 | 0.113 | 0.754 | 0.079 | type1 | 136.0 | | 0.091 |
| 4.60 | 4.20 | 0.864 | 0.121 | 0.862 | 0.116 | type1 | 140.0 | | 0.096 |
| 1.80 | 4.60 | 0.950 | 0.975 | 0.972 | 0.987 | type1' | 178.0 | | 0.622 |
| 2.20 | 4.60 | 0.882 | 0.235 | 0.862 | 0.191 | type1 | 184.0 | | 0.166 |
| 2.60 | 4.60 | 0.647 | 0.400 | 0.648 | 0.374 | type5 | 240.0 | 108.0 | 0.251 |
| 3.00 | 4.60 | 0.329 | 0.521 | 0.337 | 0.532 | type1 | 256.0 | | 0.322 |
| 3.40 | 4.60 | 0.314 | 0.667 | 0.337 | 0.663 | type5 | 300.0 | 132.0 | 0.386 |
| 3.80 | 4.60 | 0.652 | 0.763 | 0.648 | 0.763 | type5 | 300.0 | 159.0 | 0.438 |
| 4.20 | 4.60 | 0.883 | 0.810 | 0.862 | 0.831 | type2 | 352.0 | 96.0 | 0.483 |
| 4.60 | 4.60 | 0.956 | 0.875 | 0.972 | 0.866 | type2 | 368.0 | 96.0 | 0.513 |

**TABLE 1**

| | Si₃N₄ | SiO₂ | TiO₂ |
|---|---|---|---|
| n450 | 2.07856 | 1.46128 | 2.46125 |
| n500 | 2.06337 | 1.45790 | 2.40780 |
| n650 | 2.03738 | 1.45106 | 2.32848 |
| n850 | 2.02105 | 1.44587 | 2.28487 |
| n950 | 2.01591 | 1.44413 | 2.27247 |
| n1050 | 2.01174 | 1.44273 | 2.26318 |

**TABLE 2**

| | Numerical Example | | | |
|---|---|---|---|---|
| | 1 | 2 | 3 | 4 |
| Material | Si₃N₄ | TiO₂ | TiO₂ | Si₃N₄ |
| f | 3200 | 2000 | 5000 | 8000 |
| G | 3200 | 2560 | 4800 | 6000 |
| P | 400 | 320 | 320 | 400 |
| H | 2000 | 1250 | 1250 | 2000 |
| λ1 | 450 | 450 | 450 | 500 |
| λ2 | 1050 | 1050 | 850 | 950 |
| m1 | 1.223 | 1.197 | 1.977 | 1.980 |
| m2 | 0.963 | 0.931 | 0.996 | 0.997 |
| W1max | 4525.5 | 3620.4 | 6788.2 | 8485.3 |
| Δrmin1 | 1534.2 | 1240.7 | 1155.8 | 1512.9 |
| FFmax | 0.594 | 0.622 | 0.998 | 0.757 |
| FFmin | 0.073 | 0.102 | 0.010 | 0.008 |
| n2 | 2.01174 | 2.26318 | 2.28487 | 2.01591 |
| m1/m2 | 1.271 | 1.286 | 1.985 | 1.987 |
| m1-m2 | 0.261 | 0.266 | 0.981 | 0.983 |
| λ1m1/(λ2m2) | 0.545 | 0.551 | 1.051 | 1.046 |
| Hmin/Hmax | 1.000 | 1.000 | 1.000 | 1.000 |
| Hmax(n2-1)/(m2λ2) | 2.002 | 1.616 | 1.897 | 2.146 |
| P/λ1 | 0.889 | 0.711 | 0.711 | 0.800 |
| f1/W1max | 0.707 | 0.552 | 0.737 | 0.943 |
| Δrmin1/P | 3.835 | 3.877 | 3.612 | 3.782 |
| FFmax-FFmin | 0.522 | 0.520 | 0.989 | 0.749 |

| | Numerical Example | | | Compar. Ex. |
|---|---|---|---|---|
| | 5 | 6 | 7 | 1 |
| Material | Si₃N₄ | TiO₂ | TiO₂ | Si₃N₄ |
| f | 6500 | 2000 | 2000 | 3200 |
| G | 6000 | 2560 | 2560 | 3200 |
| P | 400 | 320 | 320 | 400 |
| H | 2000 | 1250 | 1250 | 2000 |
| λ1 | 450 | 450 | 450 | 450 |
| λ2 | 1050 | 650 | 1050 | 1050 |
| m1 | 2.973 | 1.197 | 1.961 | 0.935 |
| m2 | 0.988 | 0.964 | 0.931 | 0.981 |
| W1max | 8485.3 | 3620.4 | 7210.2 | 4525.5 |
| Δrmin1 | 2143.3 | 1240.7 | 622.9 | 803.2 |
| FFmax | 0.884 | 0.581 | 0.622 | 0.622 |
| FFmin | 0.008 | 0.123 | 0.102 | 0.010 |
| n2 | 2.01174 | 2.32848 | 2.26318 | 2.01174 |
| m1/m2 | 3.008 | 1.241 | 2.107 | 0.953 |
| m1-m2 | 1.984 | 0.232 | 1.031 | -0.046 |
| λ1m1/(λ2m2) | 1.289 | 0.859 | 0.903 | 0.408 |
| Hmin/Hmax | 1.000 | 1.000 | 1.000 | 1.000 |
| Hmax(n2-1)/(m2λ2) | 1.950 | 2.649 | 1.616 | 1.964 |
| P/λ1 | 0.889 | 0.711 | 0.711 | 0.889 |
| f1/W1max | 0.766 | 0.552 | 0.277 | 0.707 |
| Δrmin1/P | 5.358 | 3.877 | 1.947 | 2.008 |
| FFmax-FFmin | 0.876 | 0.458 | 0.520 | 0.612 |

### IMAGE PICKUP APPARATUS

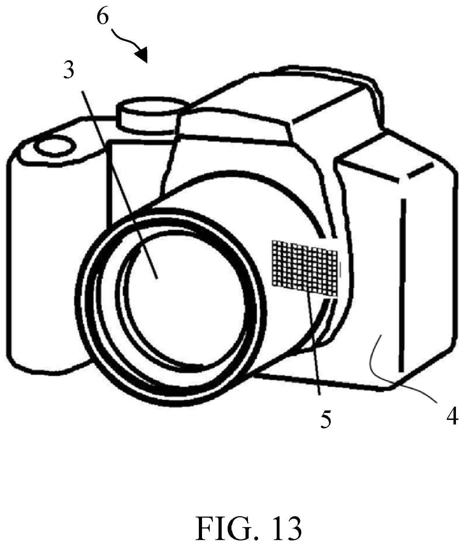

Fig. 13 illustrates a digital still camera (image pickup apparatus) 6 using an image sensor including the optical element according to any one of Examples 1 to 7. Reference numeral 4 denotes a camera body, and reference numeral 3 denotes an optical system. Reference numeral 5 denotes an image sensor (photoelectric conversion element), such as a CCD sensor or a CMOS sensor, which is built into the camera body 4 and performs photoelectric conversion (image capture) of an optical image formed by the optical system 3. The image sensor 5 includes the optical element according to any one of Examples 1 to 7.

The camera body 4 may be a single-lens reflex camera having a quick-return mirror, or may be a mirrorless camera not having a quick-return mirror.

Applying the image sensor including the optical element according to any one of the above examples to an image pickup apparatus such as a digital still camera can provide satisfactory imaging.

While the present disclosure has been described with reference to embodiments, it is to be understood that the present disclosure is not limited to the disclosed embodiments. The scope of the following claims is to be accorded the broadest interpretation so as to encompass all such modifications and equivalent structures and functions.

Each example can provide an optical element that efficiently condenses or diverges light of a plurality of wavelengths.

## Claims

1. An optical element (100) comprising:
a plurality of structures each including at least one of a concave element or a convex element (121),
**characterized in that** the following inequality is satisfied: $1 < m 1 / m 2 \leq 20$
where m1 is a value obtained by normalizing, by 2π, a maximum phase change amount provided by the plurality of structures to light of a first wavelength, and m2 is a value obtained by normalizing, by 2π, a maximum phase change amount provided by the plurality of structures to light of a second wavelength different from the first wavelength.

2. The optical element according to claim 1, **characterized in that** the following inequality is satisfied: $0.1 \leq m 1 - m 2 \leq 10.0 .$

3. The optical element according to claim 1 or 2, **characterized in that** at least one of the first wavelength or the second wavelength is a wavelength in a visible light region, and the following inequality is satisfied: $λ 1 < λ 2$ where A1 is the first wavelength and λ2 is the second wavelength.

4. The optical element according to any one of claims 1 to 3, **characterized in that** the following inequality is satisfied: $0.2 \leq \left(λ1\times m1\right) / \left(λ2\times m2\right) \leq 10.0$ where A1 is the first wavelength and λ2 is the second wavelength.

5. The optical element according to any one of claims 1 to 4, **characterized in that** the following inequality is satisfied: $0.8 \leq Hmin / Hmax \leq 1.0$ where Hmax is a maximum height of the plurality of structures, and Hmin is a minimum height of the plurality of structures.

6. The optical element according to any one of claims 1 to 5, **characterized in that** the following inequality is satisfied: $0.90 \leq Hmax \left(n2-1\right) / \left(m2\times λ2\right) \leq 5.00$ where λ2 is the second wavelength, Hmax is a maximum height of the plurality of structures, and n2 is a refractive index of the plurality of structures at the second wavelength.

7. The optical element according to any one of claims 1 to 6, **characterized in that** the following inequality is satisfied: $0.1 \leq P / λ 1 \leq 1.5$ where λ1 is the first wavelength, and P is a repetition period of the structures.

8. The optical element according to any one of claims 1 to 7, **characterized in that** the following inequality is satisfied: $0.1 \leq f 1 / W 1 max \leq 4.0$ where in the plurality of structures, W1max is a maximum width of a first condensing region having a condensing function and f1 is a focal length of the first condensing region at the first wavelength.

9. The optical element according to any one of claims 1 to 8, **characterized in that** the plurality of structures include a plurality of annuli,
wherein the following inequality is satisfied: $1.2 \leq Δrmin 1 / P \leq 20.0$ where P is a repetition period of the structures, and Δrmin1 is a minimum inter-annulus distance at the first wavelength among the plurality of annuli.

10. The optical element according to any one of claims 1 to 9, **characterized in that** the plurality of structures include a plurality of types of structures having configurations that are different from each other.

11. The optical element according to any one of claims 1 to 10, **characterized in that** the optical element includes a substrate,
wherein the plurality of structures are arranged on the substrate.

12. An image sensor (5) comprising:
the optical element according to any one of claims 1 to 11; and
a photoelectric conversion element.

13. An image pickup apparatus (6) comprising:
an optical system (3); and
the image sensor (5) according to claim 12 configured to receive an image formed by the optical system.
